# EUROPEAN PATENT APPLICATION

(11) **EP 2 360 162 A1**
(43) Date of publication of application: **24.08.2011**
(21) Application number: 09830367.0
(22) Date of filing: 30.11.2009
(51) Int. Cl.: C07F 9/50, C07F 9/53, C08K 5/10, C08L 101/00, C09K 11/06, H01L 51/50

(54) **LUMINESCENT SILVER COMPLEXES**

(30) Priority: 01.12.2008 JP 2008306720
(71) Applicant: Sumitomo Chemical Company, Limited, Tokyo 104-8260 (JP)
(72) Inventor: KOBAYASHI, Norifumi, Tsukuba-shi Ibaraki 305-0003 (JP); HIGASHIMURA, Hideyuki, Tsukuba-shi Ibaraki 305-0045 (JP); SUENOBU, Katsuhiro, Tsukuba-shi Ibaraki 305-0045 (JP)
(74) Representative: Duckworth, Timothy John
(86) International application number: PCT/JP2009/070103
(87) International publication number: WO 2010/064601

(57) **Abstract**

An luminescent device material which is inexpensive and exhibits excellent durability in the presence of oxygen can be provided using a luminescent silver complex which has an organic multidentate ligand, particularly, a luminescent silver complex wherein the organic multidentate ligand is coordinated to a phosphorus atom, a nitrogen atom, an oxygen atom, a sulfur atom, an arsenic atom, an oxygen anion, a nitrogen anion, or a sulfur anion, or a polymer of the luminescent silver complex.

## Description

### Technical Field

The present invention relates to a luminescent silver complex.

### Background Art

A phosphorescent complex with a platinum group metal represented by an iridium complex has been promising as a luminescent material used for an organic EL device or the like. However, iridium has been a rare metal among platinum group metals and very expensive. Accordingly, various studies have been made on a complex with an inexpensive metal advantageous for cost (Non Patent Literature 1). A known inexpensive metal complex, however, has not exhibited sufficient durability in the presence of oxygen as a luminescent material.

### Prior Art Literature(s)

### Non Patent Literature

Non Patent Literature 1: Coord. Chem. Rev. 250, 2093-2126 (2006)

### Summary of the Invention

The present invention provides a silver complex which is less expensive than the complex with a platinum group metal and has excellent durability in the presence of oxygen as a luminescent material.

### Effects of The Invention

According to the present invention, a luminescent silver complex having two or more kinds of organic ligands including organic bidentate ligands may be a material for a luminescent device with excellent luminescence property.
Also, the luminescent silver complex of the present invention is suitable for a material for a luminescent device since the luminescent silver complex has excellent luminous efficiency even as the luminescent device which is made by mixing the luminescent silver complex with a medium such as a high-molecular material to form an illuminant and then sandwiching the illuminant with a pair of electrodes.
In addition, the luminescent silver complex of the present invention has high durability in the presence of oxygen as a luminescent material. That is, the luminescent silver complex may exhibit long-lasting luminescence property.

### Embodiments For Carring Out The Invention

The luminescent silver complex of the present invention is represented by formula (1):

(Ag⁺) (L¹)ₐ (L²)_{b} (X¹)ₖ (1)

wherein, L¹ is a molecule having two atoms capable of coordinating to Ag⁺ which are selected from among a phosphorus atom, a nitrogen atom, an oxygen atom, a sulfur atom, and an arsenic atom. L² is a molecule having one or two of an atom and/or ion selected from among a phosphorus atom, a nitrogen atom, an oxygen atom, a sulfur atom, an arsenic atom, an oxygen anion, and a sulfur anion, as an atom and/or ion capable of coordinating to Ag⁺. Either one of L¹ and L² has at least one phosphorus atom capable of coordinating to Ag⁺, and L¹ and L² are different from each other. X¹ is an anion, and X¹ is a halide ion when L² is a molecule having only one atom capable of coordinating to Ag⁺. a and b are independently a positive number that is smaller than 2.0. k is a number of from 0 to 1.5.

In the silver complex represented by formula (1), L¹ is preferably coordinated with Ag⁺ and it may be coordinated with Ag⁺ either as a monodentate ligand or as a bidentate ligand, and is more preferably coordinated with Ag⁺ as a bidentate ligand. The number of carbon in L¹ is generally from 2 to 300, preferably from 3 to 200, more preferably from 4 to 150, still more preferably from 6 to 100, and particularly preferably from 10 to 80.

L¹ is preferably a molecule having two of phosphorus atoms, and/or oxygen atoms of phosphine oxide as atoms capable of coordinating to Ag⁺, including the following examples.

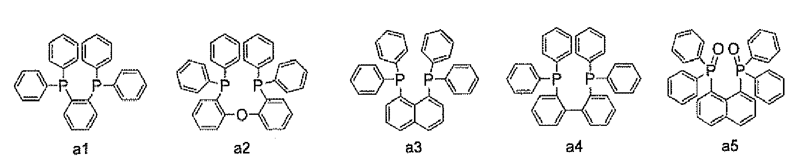

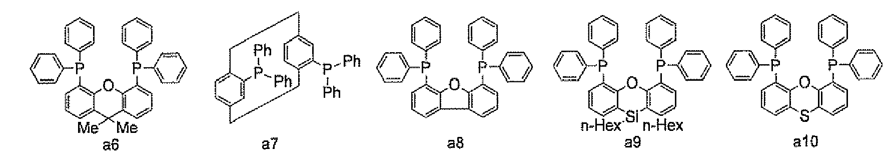

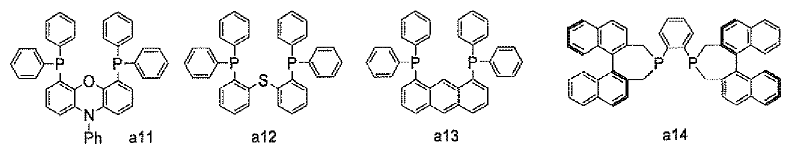

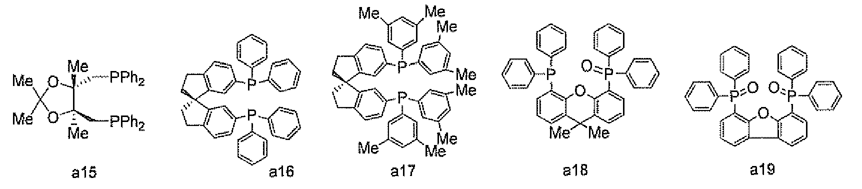

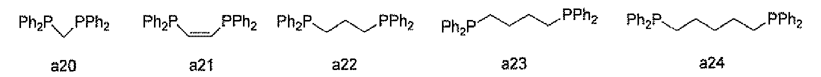

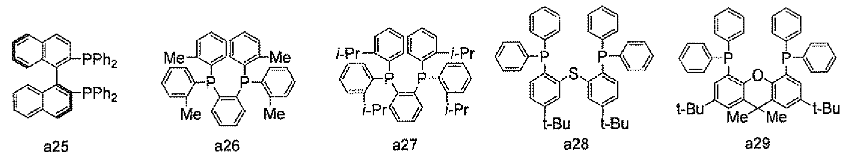

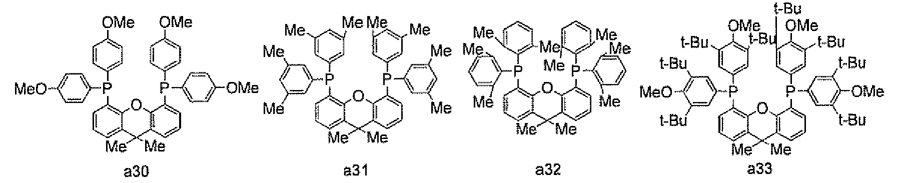

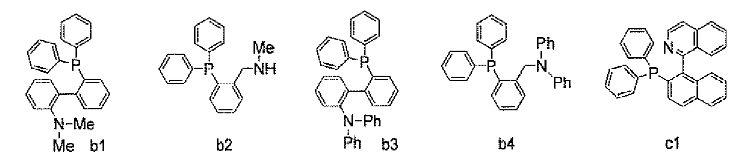

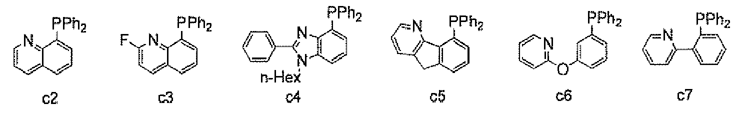

L¹ is more preferably a molecule having two phosphorus atoms capable of coordinating to Ag⁺. Preferable examples of L¹ include molecules represented by formula (A).

Q¹-R¹-Q¹ (A)

Q¹ is -P(R¹¹)₂, R¹¹ is an optionally substituted hydrocarbyl group, four R¹¹s may be the same as or different from each other, and any two of the four R¹¹s may be bonded to each other to form a ring. R¹ is a divalent group.

Examples of hydrocarbon groups for R¹¹ include an alkyl group having 1 to 50 carbon atoms such as a methyl group, an ethyl group, a propyl group, an isopropyl group, a butyl group, an isobutyl group, a t-butyl group, a pentyl group, a hexyl group, an octyl group, a nonyl group, a dodecyl group, a pentadecyl group, an octadecyl group, and a docosyl group; a cyclic saturated hydrocarbon groups having 3 to 50 carbon atoms such as a cyclopropyl group, a cyclobutyl group, a cyclopentyl group, a cyclohexyl group, a cyclononyl group, a cyclododecyl group, a norbornyl group, and an adamantyl group; an alkenyl groups having 2 to 50 carbon atoms such as an ethenyl group, a propenyl group, a 3-butenyl group, a 2-butenyl group, a 2-pentenyl group, a 2-hexenyl group, a 2-nonenyl group, and a 2-dodecenyl group; aryl groups having 6 to 50 carbon atoms such as a phenyl group, a 1-naphthyl group, a 2-naphthyl group, a 2-methylphenyl group, a 3-methylphenyl group, a 4-methylphenyl group, a 4-ethylphenyl group, a 4-propylphenyl group, a 4-isopropylphenyl group, a 4-butylphenyl group, a 4-t-butylphenyl group, a 4-hexylphenyl group, a 4-cyclohexylphenyl group, a 4-adamantylphenyl group, a 4-phenylphenyl group, and a 9-fluorenyl group; and an aralkyl groups having 7 to 50 carbon atoms such as a phenylmethyl group, a 1-phenylethyl group, a 2-phenylethyl group, a 1-phenyl-1-propyl group, a 1-phenyl-2-propyl group, a 2-phenyl-2-propyl group, a 3-phenyl-1-propyl group, a 4-phenyl-1-butyl group, a 5-phenyl-1-pentyl group, and a 6-phenyl-1-hexyl group.

Examples of the substituent in the hydrocarbon group include a halogen atom, a hydrocarbyloxy group, a dihydrocarbylamino group, a hydrocarbylmercapto group, a hydrocarbylcarbonyl group, a hydrocarbyloxycarbonyl group, and a (dihydrocarbyl)aminocarbonyl group. The hydrocarbyloxy group is represented by RO- (R represents a hydrocarbyl group), the hydrocarbylmercapto group is represented by RS-, the hydrocarbylcarbonyl group is represented by RC(=O)-, the hydrocarbyloxycarbonyl group is represented by ROC(=O)-, the dihydrocarbylamino group is represented by R₂N-, and the (dihydrocarbyl)aminocarbonyl group is represented by R₂N-C(=O)-. When two Rs are present, they may be the same as or different from each other. R is a hydrocarbon group, and specific examples of the hydrocarbon group are the same as those described above.

Hereinafter, examples of the substituent when described as "optionally substituted" in the present invention are, unless otherwise specified, a halogen atom, a hydrocarbon group, a hydrocarbyloxy group, a dihydrocarbylamino group, a hydrocarbylmercapto group, a hydrocarbylcarbonyl group, a hydrocarbyloxycarbonyl group, and a (dihydrocarbyl)aminocarbonyl group. Among them, a halogen atom, a hydrocarbon group having 1 to 30 carbon atoms, a hydrocarbyloxy group having 1 to 30 carbon atoms, a hydrocarbylmercapto group having 1 to 30 carbon atoms, and a hydrocarbylcarbonyl group having 1 to 30 carbon atoms are preferable. A halogen atom, a hydrocarbon group having 1 to 18 carbon atoms, a hydrocarbyloxy group having 1 to 18 carbon atoms, and a hydrocarbylmercapto group having 1 to 18 carbon atoms are more preferable. A halogen atom, a hydrocarbon group having 1 to 12 carbon atoms, and a hydrocarbyloxy group having 1 to 12 carbon atoms are still more preferable. As the substituent for the hydrocarbon group, a halogen atom, a hydrocarbyloxy group having 1 to 12 carbon atoms, and a hydrocarbylmercapto group having 1 to 12 carbon atoms are preferable.

R¹¹ is preferably an optionally substituted aryl group, more preferably an optionally substituted phenyl group, and still more preferably a phenyl group substituted at position 2, position 4 and/or position 6, and particularly preferably a phenyl group substituted at position 4. The substituent is preferably a halogen atom, a hydrocarbon group having 1 to 50 carbon atoms, a hydrocarbyloxy group having 1 to 24 carbon atoms, a dihydrocarbylamino group having 1 to 24 carbon atoms, and a hydrocarbylmercapto group having 1 to 12 carbon atoms; more preferably a fluorine atom, a chlorine atom, a bromine atom, an iodine atom, a trifluoromethyl group, a methyl group, an ethyl group, a propyl group, an isopropyl group, a butyl group, an isobutyl group, a t-butyl group, a pentyl group, a hexyl group, a heptyl group, an octyl group, a nonyl group, a decyl group, a dodecyl group, an octadecyl group, a docosyl group, a cyclopentyl group, a cyclohexyl group, a cyclononyl group, a cyclododecyl group, a norbornyl group, an adamantyl group, an ethenyl group, a propenyl group, a 3-butenyl group, a 2-butenyl group, a 2-pentenyl group, a phenyl group, a 1-naphthyl group, a 2-naphthyl group, a 2-methylphenyl group, a 3-methylphenyl group, a 4-methylphenyl group, a 2-methoxyphenyl group, a 3-methoxyphenyl group, a 4-methoxyphenyl group, a 4-ethylphenyl group, a 4-propylphenyl group, a 4-t-butylphenyl group, a 4-hexylphenyl group, a 4-cyclohexylphenyl group, a 4-adamantylphenyl group, a 2-phenylphenyl group, a 9-fluorenyl group, a phenylmethyl group, a 1-phenylethyl group, a 2-phenylethyl group, a methoxy group, an ethoxy group, a propoxy group, a phenoxy group, a butoxy group, a hexyloxy group, a methylthio group, an ethylthio group, a propylthio group, a butylthio group, a phenylthio group, a diphenylamino group, a dimethylamino group, a dihexylamino group, and a methylphenylamino group; further preferably a fluorine atom, a methyl group, an ethyl group, a propyl group, a butyl group, a t-butyl group, a hexyl group, an octyl group, a dodecyl group, an octadecyl group, a cyclohexyl group, an ethenyl group, a propenyl group, a phenyl group, a 2-naphthyl group, a 2-methylphenyl group, a 3-methylphenyl group, a 4-methylphenyl group, a 2-methoxyphenyl group, a 3-methoxyphenyl group, a 4-methoxyphenyl group, a 4-t-butylphenyl group, a 4-hexylphenyl group, a 2-phenylphenyl group, a 9-fluorenyl group, a methoxy group, an ethoxy group, a phenoxy group, a methylthio group, a phenylthio group, and a diphenylamino group; still more preferably a fluorine atom, a methyl group, a t-butyl group, an ethenyl group, a phenyl group, a 2-methylphenyl group, a 4-methylphenyl group, a 4-methoxyphenyl group, a 4-t-butylphenyl group, a methoxy group, and a phenoxy group; and particularly preferably a methyl group, a t-butyl group, and a methoxy group.

Examples of R¹ include an alkanediyl group having 1 to 30 carbon atoms which is optionally substituted; an alkenediyl group having 2 to 30 carbon atoms; an alkynediyl group having 2 to 30 main-chain carbon atoms which is optionally substituted; a cycloalkanediyl group having 4 to 30 carbon atoms which is optionally substituted; a divalent hydrocarbon group of an arenediyl group having 6 to 30 carbon atoms which is optionally substituted; a divalent group formed by combining an optionally substituted divalent hydrocarbon group with -O- and/or -S-; and optionally substituted r1 to r12.

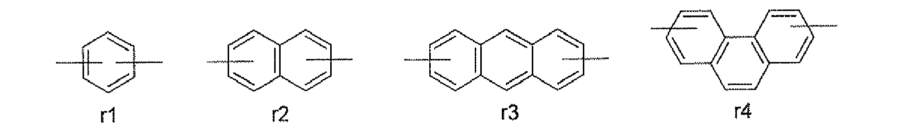

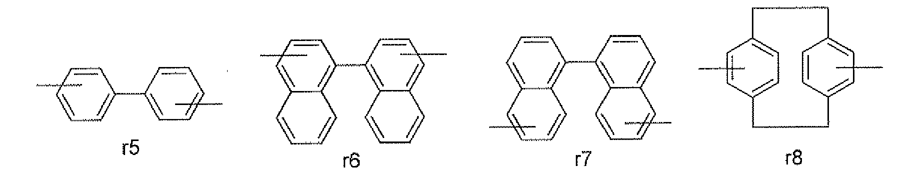

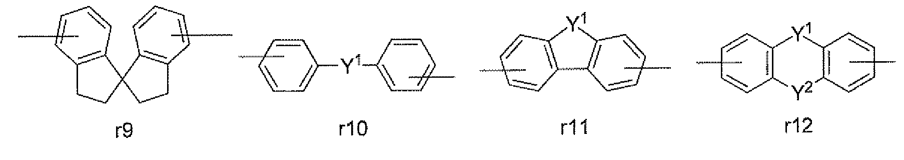

Each of Y¹ and Y² are a divalent group represented by -(CH₂)n-, -O-, -S-, -N(R^{x})-, -Si(R^{x})₂-, - O(CH₂)n-, or -O(CH₂)nO-, and Y¹ and Y² may be the same as or different from each other. n is an integer of from 1 to 3. R^{x} is a hydrocarbon group.

R¹ is preferably optionally substituted r1 to r12, more preferably optionally substituted r1, r2, r5, r6, r8, r9 and r10 wherein Y¹ is -O- or -S-, r11 wherein Y¹ is -Oor -S-, and r12 wherein Y¹ is -O-, Y² is -CH₂-, and n is 1, and still more preferably optionally substituted r1', r5', r6', r10' and r12'.

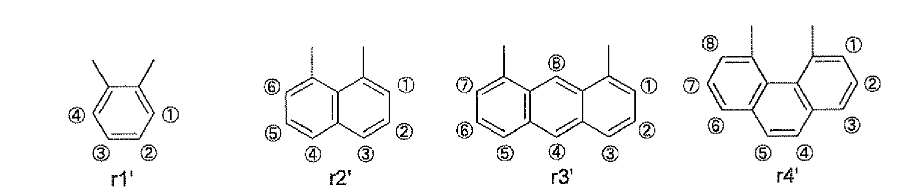

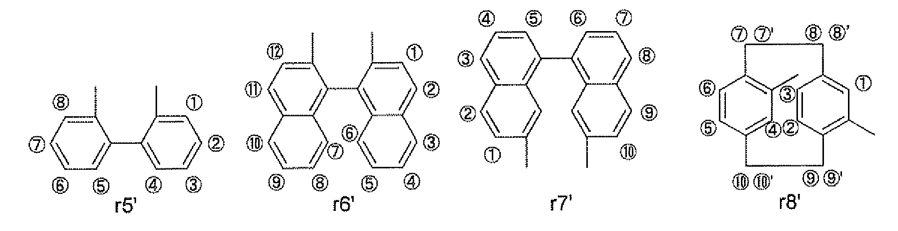

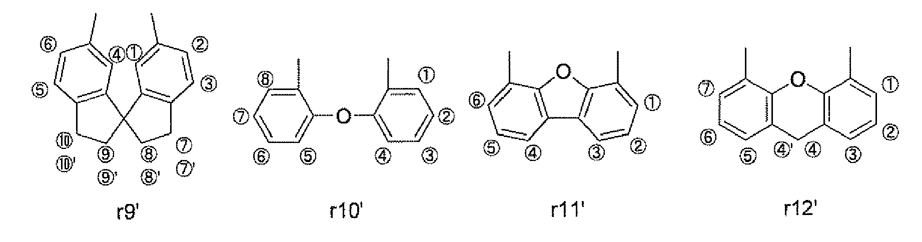

Specific examples of the substituent include preferably a fluorine atom, a chlorine atom, a bromine atom, a trifluoromethyl group, a methyl group, an ethyl group, a propyl group, a butyl group, an isobutyl group, a t-butyl group, a pentyl group, a hexyl group, a heptyl group, an octyl group, a nonyl group, a dodecyl group, an octadecyl group, a cyclohexyl group, an ethenyl group, a propenyl group, a 3-butenyl group, a phenyl group, a 1-naphthyl group, a 2-naphthyl group, a 2-methylphenyl group, a 3-methylphenyl group, a 4-methylphenyl group, a 2-methoxyphenyl group, a 3-methoxyphenyl group, a 4-methoxyphenyl group, a 4-t-butylphenyl group, a 4-hexylphenyl group, a 4-cyclohexylphenyl group, a 2-phenylphenyl group, a 2-phenylethyl group, a methoxy group, a butoxy group, a phenoxy group, a phenylthio group, and a diphenylamino group; more preferably, a fluorine atom, a chlorine atom, a trifluoromethyl group, a methyl group, an ethyl group, a propyl group, a butyl group, a t-butyl group, a hexyl group, an octyl group, a cyclohexyl group, a phenyl group, a 2-methylphenyl group, a 4-methylphenyl group, a 2-methoxyphenyl group, a 4-methoxyphenyl group, a 4-t-butylphenyl group, a 4-hexylphenyl group, a methoxy group, a butoxy group, a phenoxy group, and a diphenylamino group; still more preferably, a fluorine atom, a trifluoromethyl group, a methyl group, a butyl group, a t-butyl group, a phenyl group, a 4-methylphenyl group, a 4-methoxyphenyl group, a 4-t-butylphenyl group, and a methoxy group; and particularly preferably, a methyl group, a t-butyl group, and a methoxy group.

The number of the substituent is preferably from 0 to 4, more preferably from 0 to 3, and still more preferably from 0 to 2. The binding positions of the substituent are preferably <2> and/or <3> in r1' (The numbers in <> correspond to the circled numbers in r1' to r12'. The same applies hereinafter in this paragraph). In r2', <2>, <3>, <4> and/or <5> are preferable, and <2> and <5>, and <3> and <4> are more preferable. In r3', <2>, <3>, <4>, <5>, <6> and/or <8> are preferable, and <4>, <2> and <6>, <2>, <4> and <6>, <3> and <5>, and <2>, <3> and <5> are more preferable. In r4', <2>, <3>, <4>, <5>, <6> and/or <7> are preferable, and <2> and <7>, <3> and <6>, and <4> and <5> are more preferable. In r5', <2>, <3>, <4>, <5>, <6> and/or <7> are preferable, and <2> and <7>, and <3> and <6> are more preferable. In r6', <2>, <3>, <4>, <5>, <8>, <9>, <10> and/or <11> are preferable, and <2> and <11>, <3> and <10>, <4> and <9>, and <5> and <8> are more preferable. In r7', <2>, <3>, <4>, <5>, <6>, <7>, <8> and/or <9> are preferable, and <2> and <9>, <3> and <8>, <4> and <7>, and <5> and <6> are more preferable. In r8', <2>, <3>, <5> and/or <6> are preferable, and <2> and <6>, and <3> and <5> are more preferable. In r9', <3> and/or <5> are preferable. In r10', <2>, <3>, <4>, <5>, <6> and/or <7> are preferable, and <2> and <7>, and <3> and <6> are more preferable. In r11', <2>, <3>, <4> and/or <5> are preferable, and <2> and <5> are more preferable. In r12', <2>, <3>, <4>, <4>', <5> and/or <6> are preferable, and <4> and <4>', <2> and <6>, and <3> and <5> are more preferable.

Specific examples of L¹ include preferably the above a1 to a4, a6 to a13, a16, a17, and a25 to a33, more preferably a1, a2, a4, a6, a7, a9, a17, a26, and a33, and still more preferably a1, a2, a4, a6, and a33.

The luminescent silver complex of the present invention is preferably represented by any one of the following compositional formula (3) to (6).

(Ag⁺) (L³)_{d'1} (L⁴)_{e'1} (X²)_{f'1} (3)

L³ is defined as the same as L¹ described above. L⁴ is a molecule having only one of a phosphorus atom, a nitrogen atom, an oxygen atom, a sulfur atom, or an arsenic atom, which are capable of coordinating to Ag⁺. X² is a halide ion. d'1 and e'1 are independently a positive number that is smaller than 2.0, and f'1 is a positive number of 1.5 or smaller.

(Ag⁺) (L⁵)_{d'2} (L⁶)_{e'2} (X³)_{f'2} (4)

L⁵ is defined as the same as L¹ described above. L⁶ is a molecule having a phosphorus atom, a nitrogen atom, an oxygen atom, a sulfur atom, or an arsenic atom as one atom capable of coordinating to Ag⁺, and having a phosphorus atom, an oxygen atom, a sulfur atom, or an arsenic atom as another atom capable of coordinating to Ag⁺. L⁶ is different from L⁵. X³ is an anion. d'2 and e'2 are independently a positive number that is smaller than 2.0, and f'2 is a number of from 0 to 1.5.

(Ag⁺) (L⁷)_{d'3} (L⁸)_{e'3} (X⁴)_{f'3} (5)

L⁷ is defined as the same as L¹ described above. L⁸ is a molecule having two nitrogen atoms capable of coordinating to Ag⁺. X⁴ is an anion. d'3 and e'3 are independently a positive number that is smaller than 2.0, and f'3 is a number of from 0 to 1.5.

(Ag⁺) (L⁹)_{d'4} (L¹⁰)_{e'4} (6)

L⁹ is defined as the same as L¹ described above. L¹⁰ is a molecule having a phosphorus atom, a nitrogen atom, an oxygen atom, a sulfur atom, or an arsenic atom as one atom capable of coordinating to Ag⁺ atom, and having an oxygen anion or a sulfur anion as another ion capable of coordinating to Ag⁺. d'4 and e'4 are independently a positive number that is smaller than 2.0.

In the above composition formula (3), L³ is defined as the same as L¹ described above, and specific examples and preferred examples thereof are also the same as L¹ described above. L³ is particularly preferably a1.

In the above composition formula (3), L⁴ is a molecule having only one of a phosphorus atom, a nitrogen atom, an oxygen atom, a sulfur atom, or an arsenic atom as an atom capable of coordinating to Ag⁺.

Specific examples of L⁴ include a molecule represented by P(R²¹⁰)₃, N(R²²⁰)₃, an optionally substituted nitrogen-containing heterocyclic compound molecule, O(R²³⁰)₂, S(R²⁴⁰)₂, R²⁵⁰-CO₂H, R²⁶⁰-OH, R²⁷⁰-CN, R²⁸⁰-SH, or R²⁹⁰-SO₃H, wherein: R²¹⁰, R²²⁰, R²³⁰, R²⁴⁰, R²⁵⁰, R²⁶⁰, R²⁷⁰, R²⁸⁰, and R²⁹⁰ are independently a hydrogen atom or an optionally substituted hydrocarbon group; Each of three R²¹⁰s, three R²²⁰s, two R²³⁰s, and two R²⁴⁰s may be the same as or different from each other; two of three R²¹⁰s may be bonded to each other to form a ring; two of three R²²⁰s may be bonded to each other to form a ring; two R²³⁰s may be bonded to each other to form a ring; and two R²⁴⁰s may be bonded to each other to form a ring.

Specific examples and preferred examples of the optionally substituted hydrocarbon groups in R²¹⁰, R²²⁰, R²³⁰, R²⁴⁰, R²⁵⁰, R²⁶⁰, R²⁷⁰, R²⁸⁰, and R²⁹⁰ are the same as those of R¹¹ described above.

Examples of nitrogen-containing heterocyclic compound molecules in L⁴ include pyridine, pyridazine, pyrimidine, pyrazine, triazine, quinoline, isoquinoline, imidazole, pyrazole, oxazole, thiazole, oxadiazole, thiadiazole, azadiazole, and acridine. Pyridine, imidazole, quinoline, and isoquinoline are preferable, pyridine, imidazole, and quinoline are more preferable, and pyridine is still more preferable. The substituent of the nitrogen-containing heterocyclic compound molecule is defined as the same as that of the hydrocarbon in R¹¹ described above. Specific examples and preferred examples thereof are the same as those of the substituent of the hydrocarbon in R¹¹ described above. The number of the substituent is preferably from 0 to 4, more preferably from 0 to 3, still more preferably from 0 to 2, and particularly preferably from 1 to 2.

L⁴ is preferably P(R²¹⁰) ₃, N(²²⁰)₃, and an optionally substituted nitrogen-containing heterocyclic compound molecule, more preferably P(R²¹⁰)₃ wherein R²¹⁰ is an optionally substituted aryl group, and an optionally substituted nitrogen-containing heterocyclic compound molecule, and still more preferably P(R²¹⁰)₃ wherein R²¹⁰ is an optionally substituted phenyl group.

Specific examples of L⁴ include the followings.

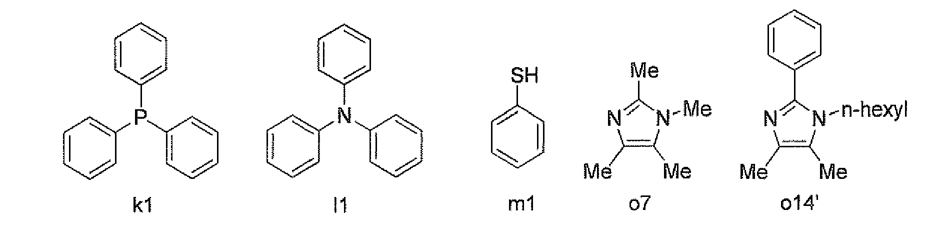

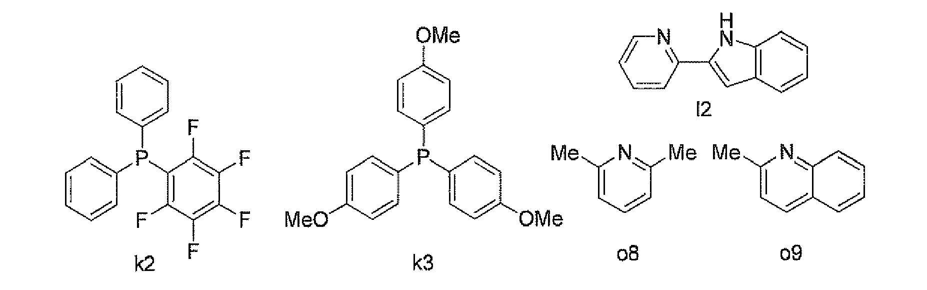

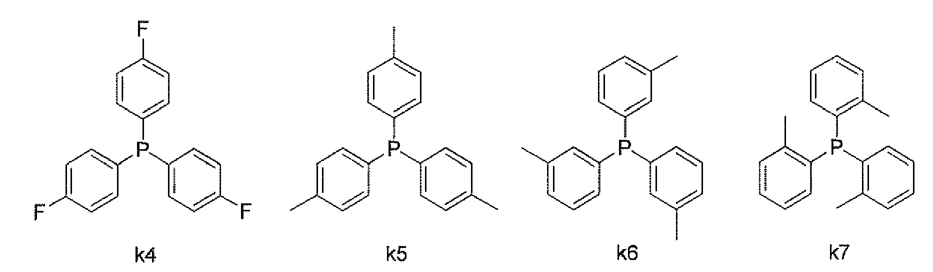

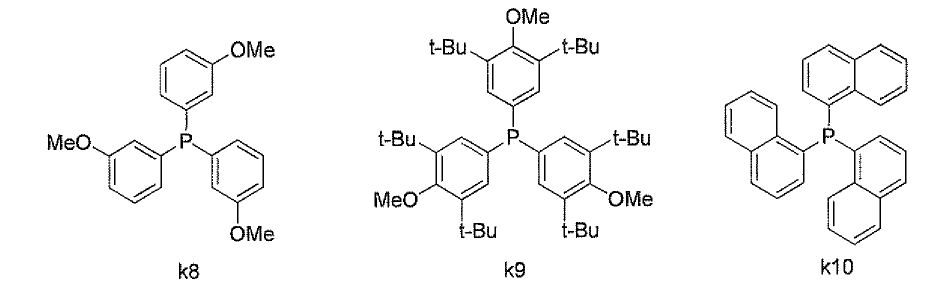

Among the above specific examples, k1 to k10, 11, 12, o7, o8, o14, and o9 are preferable, k1 to k10 are more preferable, k1 to k5 are still more preferable, and k1 is particularly preferable.

X² is a halide ion, and preferably a chloride ion, a bromide ion, and an iodide ion.

In compositional formula (3), d'1 and e'1 are independently a positive number that is smaller than 2.0, and f'1 is a positive number of 1.5 or smaller. Preferably, d'1, e'1 and f'1 are independently from 0.5 to 1.5, more preferably d'1, e'1, and f'1 are independently from 0.7 to 1.3, and still more preferably d'1, e'1, and f'1 are independently from 0.8 to 1.2.

Specific examples of the luminescent silver complex represented by compositional formula (3) include one in which L³ is a molecule represented by any one of formulae a1 to a33, b1 to b4, and c1 to c7, and L⁴ is a molecule represented by any one of formulae k1 to k10, 11, m1, o7 to o9, and o'14. Preferred specific examples of the luminescent silver complex represented by compositional formula (3) include one in which L³ is a molecule represented by any one of formulae a1 to a4, a5 to a13, a16 to a17, and a25 to a33, and L⁴ is a molecule represented by any one of formulae k1 to k10. More preferably, d'1, e'1, and f'1 are each independently from 0.5 to 1.5.

In the above composition formula (4), L⁵ is defined as the same as L¹ described above, and specific examples and preferred examples thereof are also the same as those of L¹ described above. L⁵ is particularly preferably a2, a4, and a6.

In the above composition formula (4), L⁶ is a molecule having a phosphorus atom, a nitrogen atom, an oxygen atom, a sulfur atom, or an arsenic atom as one atom capable of coordinating to Ag⁺, and having a phosphorus atom, an oxygen atom, a sulfur atom, or an arsenic atom as another atom capable of coordinating to Ag⁺. L⁶ is different from L⁵.

L⁶ is preferably a molecule represented by formula (B).

Q⁵-R⁵-Q⁵¹ (B)

Q⁵ is a group represented by -P(R⁵¹)₂, -As(R⁵²)₂, - P(=O) (R⁵³)₂, -OH, -CO₂H, -SH, -SO₃H, -OR⁵⁴, -CO₂R⁵⁵, -SR⁵⁶, or -SO₃R⁵⁷, Q⁵¹ is -P(R⁵⁸)₂, -As(R⁵⁹)₂, -P(=O)(R⁵¹⁰)₂, -OH, -CO₂H, -SH, -SO₃H, -OR⁵¹¹, -CO₂R⁵¹², -SR⁵¹³-SO₃R⁵¹⁴, or -N(R⁵¹⁵)₂, or an optionally substituted nitrogen-containing heterocyclic group. Q⁵ and Q⁵¹ may be the same as or different from each other, and may be bonded to each other to form a ring. R⁵¹ to R⁵⁹ and R⁵¹⁰ to R⁵¹⁵ are independently a hydrogen atom or an optionally substituted hydrocarbon group, and two R⁵¹s, two R⁵²s, two R⁵³s, two R⁵⁸s, two R⁵⁹s, two R⁵¹⁰s, and two R⁵¹⁵s may be the same as or different from each other. Two R⁵¹s may be bonded to each other to form a ring, two R⁵²s may be bonded to each other to form a ring, two R⁵³s may be bonded to each other to form a ring, two R⁵⁸s may be bonded to each other to form a ring, two R⁵⁹s may be bonded to each other to form a ring, two R⁵¹⁰s may be bonded to each other to form a ring, and two R⁵¹⁵s may be bonded to each other to form a ring. R⁵ is a divalent group, but may be a direct bonding when Q⁵¹ is an optionally substituted nitrogen-containing heterocyclic group.

Specific examples and preferred examples of the optionally substituted hydrocarbon groups in R⁵¹, R⁵², R⁵³, R⁵⁴, R⁵⁵, R⁵⁶, R⁵⁷, R⁵⁸, R⁵⁹, R⁵¹⁰, R⁵¹¹, R⁵¹², R⁵¹³, R⁵¹⁴, and R⁵¹⁵ are the same as those in R¹¹ described above. Specific examples and preferred examples of the divalent group in R⁵ are the same as those in R¹ described above.

The nitrogen-containing heterocyclic group in Q⁵¹ refers to a monovalent group formed by removing one hydrogen atom from the above nitrogen-containing heterocyclic compound. Specific examples and preferred examples of the nitrogen-containing heterocyclic compound are the same as described above, and a 2-pyridyl group is particularly preferable. The group optionally substituted by the nitrogen-containing heterocyclic group is defined as the same as the group optionally substituted by the above nitrogen-containing heterocyclic compound. Specific examples and preferred examples are also the same.

Q⁵ is preferably - P(R⁵¹)₂ wherein R⁵¹ is an optionally substituted aryl group, -OH, CO₂H, or -SH, more preferably -P(R⁵¹)₂ wherein R⁵¹ is an optionally substituted aryl group, and still more preferably -P(R⁵¹)₂ (R⁵¹ is an optionally substituted phenyl group, more preferably a phenyl group substituted at position 2, position 4 and/or position 6, and still more preferably a phenyl group substituted at position 4.).

Q⁵¹ is preferably -OH, CO₂H, -SH, or an optionally substituted nitrogen-containing heterocyclic group, more preferably -OH, CO₂H, or an optionally substituted nitrogen-containing heterocyclic group, and still more preferably -OH or an optionally substituted nitrogen-containing heterocyclic group.

Specific examples of L⁶ include the above a1 to a33, b1 to b4, c1 to c7, and the following d1 to d20, and s1 to s17.

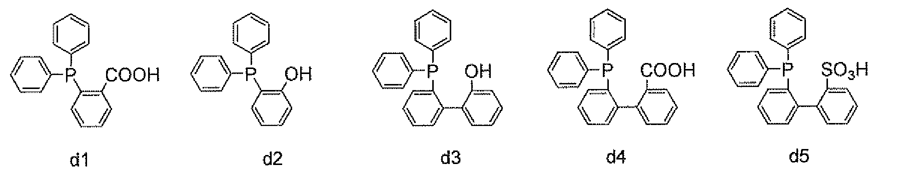

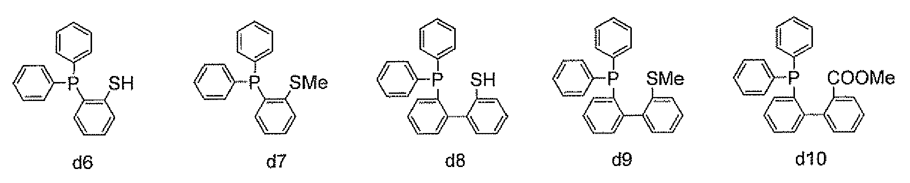

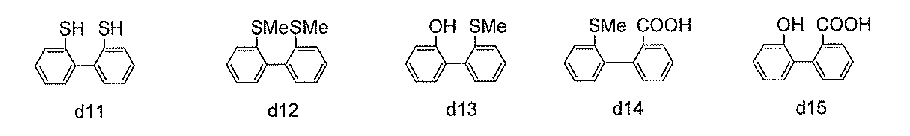

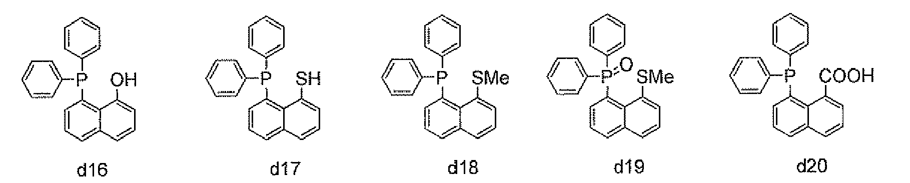

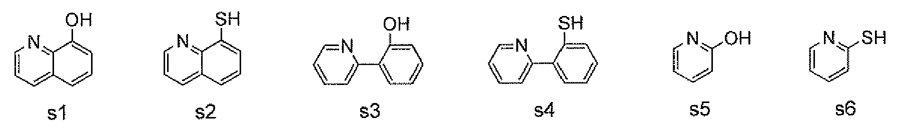

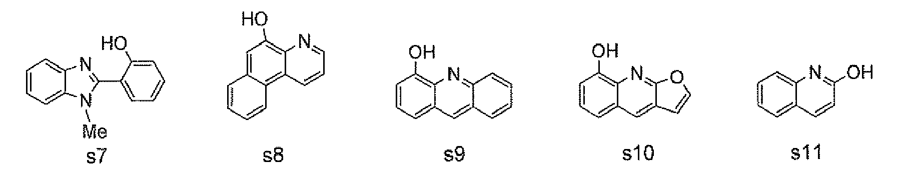

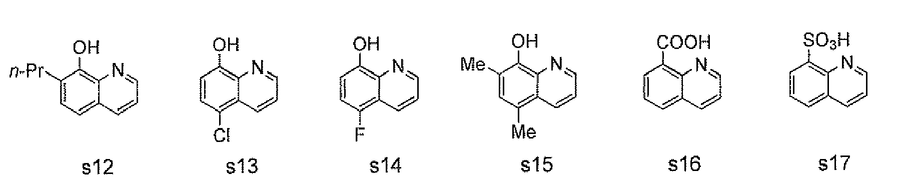

Among specific examples of L⁶, a1, a2, a3, a4, a5, a6, a7, a9, a10, a11, a12, a13, a15, a16, a17, a18, a21, a23, a26, a30, a31, a32, a33, b3, c1, c2, c3, c4, c5, c7, d1, d2, d3, d4, d6, d8, d16, d17, d20, s1, s2, s3, s4, s7, s8, s9, s10, s12, s13, s14, s15, and s16 are preferable, c1, c2, c3, c4, c5, c7, d1, d2, d3, d4, d6, d8, d16, d17, d20, s1, s2, s3, s4, s7, s8, s9, s10, s12, s13, s14, s15, and s16 are more preferable, c3, d3, s1, s3, and s12 are still more preferable, and d3 and s12 are particularly preferable.

X³ is an anion. Specific examples of X³ include a fluoride ion, a chloride ion, a bromide ion, an iodide ion, a sulfate ion, a nitrate ion, a carbonate ion, an acetate ion, a perchlorate ion, a tetrafluoroborate ion, a hexafluorophosphate ion, a hexafluoro antimony ion, a hexafluoro arsenic ion, a methanesulfonate ion, a trifluoromethanesulfonate ion, a trifluoroacetate ion, a benzenesulfonate ion, a p-toluenesulfonate ion, a dodecylbenzenesulfonate ion, a tetraphenylborate ion, and a tetrakis(pentafluorophenyl)borate ion. Examples of X³ also include anions of the high-molecular compounds containing a repeated unit having such an ion structure. Preferred examples of X³ include a fluoride ion, a chloride ion, a bromide ion, an iodide ion, a nitrate ion, a tetrafluoroborate ion, a hexafluorophosphate ion, a trifluoromethanesulfonate ion, and a tetraphenylborate ion, more preferred examples include a chloride ion, a bromide ion, an iodide ion, a nitrate ion, a tetrafluoroborate ion, and a hexafluorophosphate ion, and still more preferred examples include a bromide ion, an iodide ion, and a tetrafluoroborate ion.

In compositional formula (4), d'2 and e'2 are independently a positive number that is smaller than 2.0, f'2 is a number of from 0 to 1.5. Preferably, d'2, e'2, and f'2 are independently from 0.5 to 1.5, more preferably d'2, e'2, and f'2 are independently from 0.7 to 1.3, and still more preferably d'2, e'2, and f'2 are independently from 0.8 to 1.2.

Specific examples of the luminescent silver complex represented by compositional formula (4) include one in which L⁵ is a molecule represented by any one of formulae a1 to a33, b1 to b4, and c1 to c7, L⁶ is a molecule represented by any one of formulae a1 to a33, b1 to b4, and c1 to c7, d1 to d20, and s1 to s17, and X³ is the above anion. Preferred specific examples of the luminescent silver complex represented by compositional formula (4) include one in which L⁵ is a molecule represented by any one of formulae a1 to a4, a6 to 13, a16 to a17, and a25 to a33, L⁶ is a molecule represented by any one of formulae c1 to c5, c7, d1 to d4, d6, d8, d16 to d17, d20, s1 to s4, s7 to s10, and s12 to s16, and X³ is the above anion. More preferably, d'2, e'2 and f'2 are each independently from 0.5 to 1.5.

In compositional formula (5), L⁷ is defined as the same as L¹ described above, and specific examples and preferred examples thereof are also the same as those of L¹ described above. L⁷ is particularly preferably a2, a4, or a6.

In compositional formula (5), L⁸ is a molecule having two nitrogen atoms capable of coordinating to Ag⁺, and preferably a molecule represented by formula (D).

Q⁷-R⁷-Q⁷ (D)

Q⁷ is -N(R⁷¹)₂ or an optionally substituted nitrogen-containing heterocyclic group, two Q⁷s may be the same as or different from each other, and two Q⁷s may be bonded to each other to form a ring. R⁷¹ is a hydrogen atom or an optionally substituted hydrocarbon group, Each of two R⁷¹s may be the same as or different from each other, and two R⁷¹s may be bonded to each other to form a ring. R⁷ is a divalent group, but may be a direct bonding when either one of two Q⁷s is an optionally substituted nitrogen-containing heterocyclic group.

Specific examples and preferred examples of the optionally substituted hydrocarbon group in R⁷¹ are the same as those in R¹¹ described above. A phenyl group is particularly preferable. Specific examples and preferred examples of the nitrogen-containing heterocyclic group in Q⁷ are the same as those in Q⁵¹ described above. Specific examples of R⁷ are the same as those of R¹ described above. R⁷ is particularly preferably a phenylene group, or an alkanediyl group having 1 to 6 carbon atoms.

Preferred examples of Q⁷ include an optionally substituted nitrogen-containing heterocyclic group. More preferred examples of the nitrogen-containing heterocyclic group include a pyridyl group, a quinolyl group, and an imidazolyl group, still more preferred examples include a pyridyl group and a quinolyl group, and particularly preferred examples include a pyridyl group.

Specific examples of the molecule represented by (D) include f1 to f2, f4 to f11, f13, f18, f20, f2', f21 to f31, f33 to f37, and f39 to f54, as shown below.

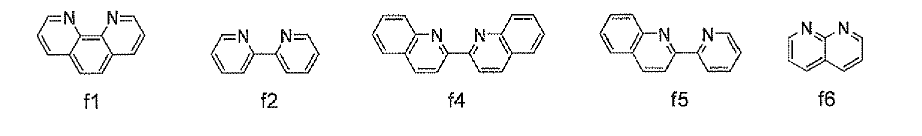

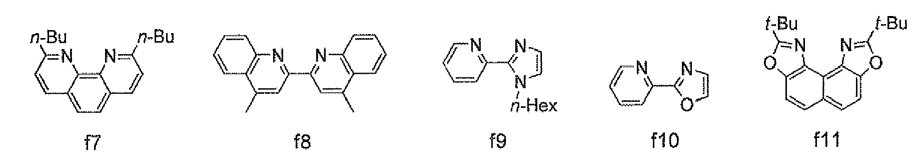

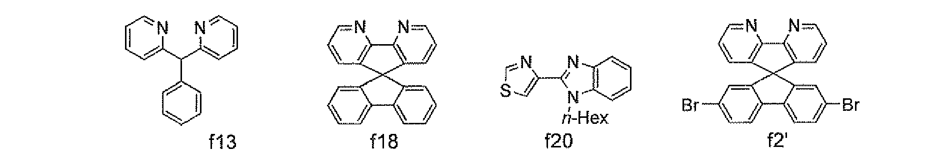

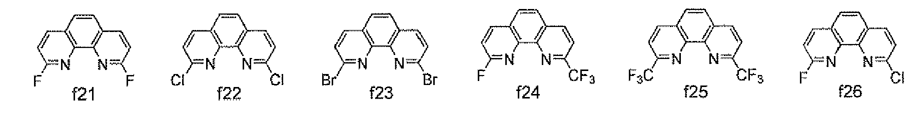

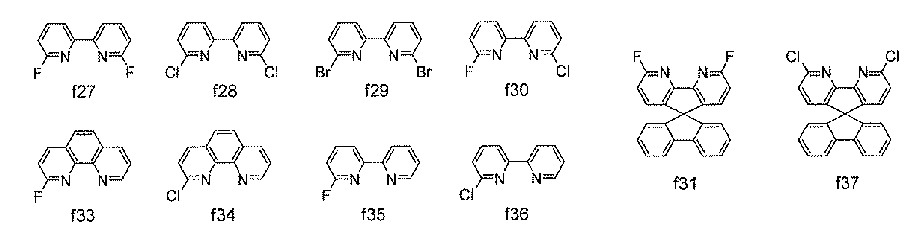

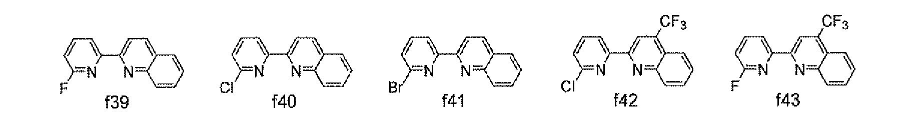

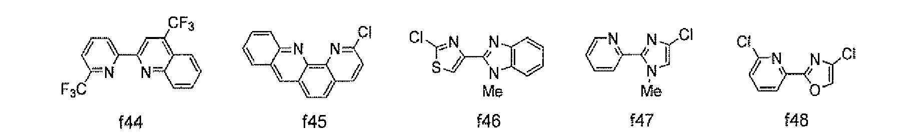

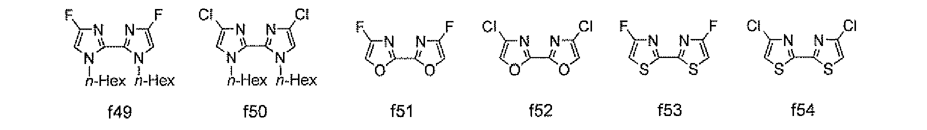

Comparison with formula (D) will be described with reference to f1 as an example. R⁷ is a direct bonding, and two Q⁷s are a 3-ethenyl-2-pyridyl group and a 2-pyridyl group, respectively. The residue formed by removing the hydrogen atom at 2-position of the ethenyl group from the 3-ethenyl-2-pyridyl group is bonded to the residue formed by removing the hydrogen atom at 3-position from the 2-pyridyl group to make a ring structure.

The molecule represented by (D) preferably has the structure of formula (Da).

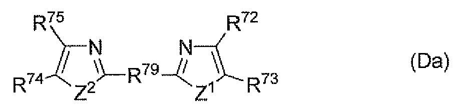

N is a nitrogen atom capable of coordinating to Ag⁺. Z¹ and Z² are each independently -C(R⁷⁶)=C(R⁷⁷)-wherein R⁷⁶ is arranged to be closer to R⁷³ when Z¹ is - C(R⁷⁶)=C(R⁷⁷)-, and R⁷⁶ is arranged to be closer to R⁷⁴ when Z² is -C(R⁷⁶)=C(R⁷⁷)-; -NR⁷⁸-, -O-, or -S-. Z¹ and Z² may be the same as or different from each other. R⁷⁹ is a direct bonding, -C(R⁸⁰)₂-, -NR⁷⁸-, -O-, or -S-. R⁷², R⁷³, R⁷⁴, R⁷⁵, R⁷⁶, R⁷¹, R⁷⁸, and R⁸⁰ are each independently a hydrogen atom, a halogen atom, an optionally substituted hydrocarbyloxy group, or an optionally substituted hydrocarbon group. Each of R⁷², R⁷³, R⁷⁴, R⁷⁵, R⁷⁶, R⁷⁷, R⁷⁸, and R⁸⁰ may be the same as or different from each other. R⁷² and R⁷³ may be bonded to each other to form a ring, R⁷⁴ and R⁷⁵ may be bonded to each other to form a ring; R⁷⁶ and R⁷³ may be bonded to each other to form a ring, and R⁷⁶ and R⁷⁷ may be bonded to each other to form a ring when Z¹ is - C(R⁷⁶)=C(R⁷⁷)-; R⁷⁶ and R⁷⁴ may be bonded to each other to form a ring, and R⁷⁶ and R⁷⁷ may be bonded to each other to form a ring when Z² is -C(R⁷⁶)=C(R⁷⁷) -; and two R⁷⁶S may be bonded to each other to form a ring when both Z¹ and Z² are -C(R⁷⁶)=C(R⁷⁷)-.

Specific examples and preferred examples of the optionally substituted hydrocarbon group in R⁷², R⁷³, R⁷⁴, R⁷⁵, R⁷⁶, and R⁷⁷ are the same as those of R¹¹ described above. Specific examples of the optionally substituted hydrocarbon groups in R⁷⁸ and R⁸⁰ are the same as those of R¹¹ described above. R⁷⁸ is preferably a methyl group, an ethyl group, a propyl group, a butyl group, a pentyl group, a hexyl group, an octyl group, a dodecyl group, a cyclohexyl group, an adamantyl group, a phenyl group, a 1-naphthyl group, a 2-naphthyl group, a 2-methylphenyl group, a 4-methylphenyl group, a 4-methoxyphenyl group, a 4-butylphenyl group, a 4-t-butylphenyl group, a 4-cyclohexylphenyl group, a 4-adamantylphenyl group, a 4-phenylphenyl group, a phenylmethyl group, a 2-phenylethyl group, a 4-phenyl-1-butyl group, a 6-phenyl-1-hexyl group, and the like; more preferably a methyl group, an ethyl group, a propyl group, a butyl group, a pentyl group, a hexyl group, an octyl group, and a dodecyl group; and still more preferably a methyl group, a butyl group, and a hexyl group. R⁸⁰ is preferably a methyl group, an ethyl group, a propyl group, a butyl group, a pentyl group, a hexyl group, an octyl group, a dodecyl group, a cyclohexyl group, a phenyl group, a 4-methylphenyl group, a 4-methoxyphenyl group, a 4-butylphenyl group, a 4-t-butylphenyl group, a 4-cyclohexylphenyl group, and the like; more preferably a methyl group, a butyl group, a hexyl group, an octyl group, a cyclohexyl group, a phenyl group, a 4-methylphenyl group, a 4-methoxyphenyl group, and a 4-t-butylphenyl group; and still more preferably a phenyl group.

Z¹ and Z² are preferably -C(R⁷⁶)=C(R⁷⁷)-, -O-, and -S-, more preferably -C(R⁷⁶)=C(R⁷⁷)- and -O-, and still more preferably -C(R⁷⁶)=C(R⁷⁷)-. The combination of Z¹ and Z² includes preferably a combination of -C(R⁷⁶)=C(R⁷⁷)- or -O-for Z¹ and -C(R⁷⁶)=C(R⁷⁷)-, -O-, or -S- for Z²; more preferably a combination of -C(R⁷⁶)=C(R⁷⁷)- for Z¹ and - C(R⁷⁶)=C(R⁷⁷)-, -O-, or -S- for Z² ; and still more preferably -C(R⁷⁶)=C(R⁷⁷)- for both Z¹ and Z².

R⁷⁹ is preferably a direct bonding, -C(R⁸⁰)₂-, -O-, or -S-, more preferably a direct bonding, -C(R⁸⁰)₂-, or -O-, and still more preferably a direct bonding.

The molecule represented by (D) is still more preferably presented by formula (Db) among formula (Da).

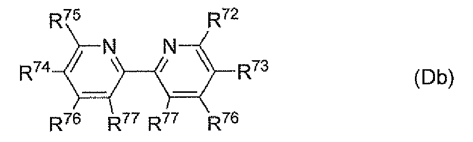

N is a nitrogen atom capable of coordinating to Ag⁺. R⁷², R⁷³, R⁷⁴, R⁷⁵, R⁷⁶, and R⁷⁷ are each independently a hydrogen atom, a halogen atom, an optionally substituted hydrocarbyloxy group, or an optionally substituted hydrocarbon group. Each of R⁷², R⁷³, R⁷⁴, R⁷⁵, R⁷⁶, and R⁷⁷ may be the same as or different from each other, R⁷² and R⁷³ may be bonded to each other to form a ring, R⁷³ and R⁷⁶ may be bonded to each other to form a ring, two R⁷⁶s and R⁷⁷ may be bonded to each other to form a ring, two R⁷⁷s may be bonded to each other to form a ring, R⁷⁶ and R⁷⁴ may be bonded to each other to form a ring, and R⁷⁴ and R⁷⁵ may be bonded to each other to form a ring.

Specific examples of the optionally substituted hydrocarbon groups in R⁷², R⁷³, R⁷⁴, R⁷⁵, R⁷⁶, and R⁷⁷ are the same as those in R¹¹ described above. R⁷² is preferably a hydrogen atom, a fluorine atom, a chlorine atom, a bromine atom, a methyl group, a trifluoromethyl group, a methoxy group, a butyl group, a hexyl group, a phenylmethyl group, and the like; more preferably a fluorine atom, a chlorine atom, a bromine atom, a methyl group, and a trifluoromethyl group; still more preferably a fluorine atom, a chlorine atom, a bromine atom, and a trifluoromethyl group; and particularly preferably a fluorine atom, and a chlorine atom. R⁷³ and R⁷⁴ are independently preferably a hydrogen atom, a fluorine atom, a chlorine atom, a bromine atom, an iodine atom, a methyl group, a trifluoromethyl group, a methoxy group, an isopropyl group, a t-butyl group, a hexyl group, a dodecyl group, a cyclobutyl group, a cyclohexyl group, an adamantyl group, an ethenyl group, a phenyl group, a 1-naphthyl group, a 2-naphthyl group, a 2-methylphenyl group, a 4-methylphenyl group, a 4-trifluoromethylphenyl group, a 4-methoxyphenyl group, a 4-butylphenyl group, a 4-t-butylphenyl group, a 4-cyclohexylphenyl group, a 4-adamantylphenyl group, a 4-phenylphenyl group, a phenylmethyl group, a 2-phenylethyl group, a 4-phenyl-1-butyl group, a 6-phenyl-1-hexyl group, and the like; more preferably a hydrogen atom, a fluorine atom, a chlorine atom, a bromine atom, a methyl group, a methoxy group, an isopropyl group, a t-butyl group, a hexyl group, a dodecyl group, a cyclohexyl group, an adamantyl group, a phenyl group, a 2-methylphenyl group, a 4-methylphenyl group, a 4-trifluoromethylphenyl group, a 4-methoxyphenyl group, a 4-butylphenyl group, a 4-t-butylphenyl group, a 4-cyclohexylphenyl group, a 4-adamantylphenyl group, a 4-phenylphenyl group, a 2-phenylethyl group, a 4-phenyl-1-butyl group, a 6-phenyl-1-hexyl group, and the like; still more preferably a hydrogen atom, a fluorine atom, a methyl group, a methoxy group, a t-butyl group, a hexyl group, a cyclohexyl group, an adamantyl group, a phenyl group, a 2-methylphenyl group, a 4-t-butylphenyl group, a 4-adamantylphenyl group, a 4-phenylphenyl group, and the like; and particularly preferably a hydrogen atom, a fluorine atom, and a t-butyl group. R⁷⁵ is preferably a hydrogen atom, a fluorine atom, a chlorine atom, a bromine atom, a methyl group, a trifluoromethyl group, a methoxy group, a butyl group, a hexyl group, a phenylmethyl group, and the like; more preferably a hydrogen atom, a fluorine atom, a chlorine atom, a bromine atom, a methyl group, and a trifluoromethyl group; still more preferably a hydrogen atom, a fluorine atom, a chlorine atom, a bromine atom, and a trifluoromethyl group; and particularly preferably a fluorine atom, and a chlorine atom. R⁷⁶ is preferably a hydrogen atom, a fluorine atom, a chlorine atom, a bromine atom, an iodine atom, a trifluoromethyl group, a methyl group, an isopropyl group, a t-butyl group, a hexyl group, a dodecyl group, a cyclobutyl group, a cyclohexyl group, an adamantyl group, an ethenyl group, a phenyl group, a 1-naphthyl group, a 2-naphthyl group, a 2-methylphenyl group, a 4-methylphenyl group, a 4-trifluoromethylphenyl group, a 4-methoxyphenyl group, a 4-butylphenyl group, a 4-t-butylphenyl group, a 4-cyclohexylphenyl group, a 4-adamantylphenyl group, a 4-phenylphenyl group, a phenylmethyl group, a 2-phenylethyl group, a 4-phenyl-1-butyl group, a 6-phenyl-1-hexyl group, and the like; more preferably a hydrogen atom, a fluorine atom, a chlorine atom, a bromine atom, a methyl group, a trifluoromethyl group, a t-butyl group, a hexyl group, an adamantyl group, a phenyl group, a 2-methylphenyl group, a 4-methylphenyl group, a 4-trifluoromethylphenyl group, a 4-t-butylphenyl group, a 2-phenylethyl group, and the like; still more preferably a hydrogen atom, a fluorine atom, a chlorine atom, a methyl group, a trifluoromethyl group, a t-butyl group, a hexyl group, a phenyl group, a 4-trifluoromethylphenyl group, a 4-t-butylphenyl group, and the like; and particularly preferably a fluorine atom, a methyl group, and a trifluoromethyl group. R⁷⁷ is preferably a hydrogen atom, a fluorine atom, a chlorine atom, a methyl group, an ethyl group, a methoxy group, a hexyl group, an octyl group, a dodecyl group, and the like; more preferably a hydrogen atom, a fluorine atom, a methyl group, an ethyl group, a methoxy group, and the like; still more preferably a hydrogen atom, a fluorine atom, a methyl group, and the like; and particularly preferably a hydrogen atom.

Among R⁷², R⁷³, R⁷⁴, R⁷⁵, R⁷⁶, and R⁷⁷ which may be bonded to each other to form a ring, preferably R⁷² and R⁷³ are bonded to each other to form a quinoline ring, R⁷⁴ and R⁷⁵ are bonded to each other to form a quinoline ring, and/or, two R⁷⁷s are bonded to each other to form a phenanthroline ring.

Preferably, R⁷² and/or R⁷⁵ are each independently bonded to R⁷³ and/or R⁷⁴ to form an aromatic ring, or are a fluorine atom, a chlorine atom, a bromine atom, or a trifluoromethyl group, more preferably R⁷² and/or R⁷⁵ are each independently a fluorine atom, a chlorine atom, or a trifluoromethyl group, still more preferably R⁷² and/or R⁷⁵ are each independently a fluorine atom or a chlorine atom, and particularly preferably R⁷² and R⁷⁵ are each independently a fluorine atom or a chlorine atom.

More preferred specific examples of the molecule represented by (D) are shown in the following f21 to f54.

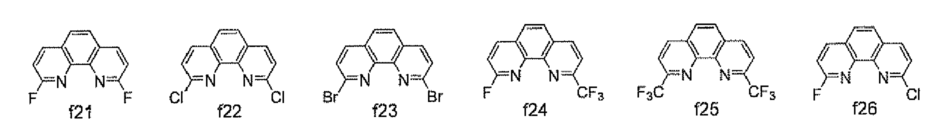

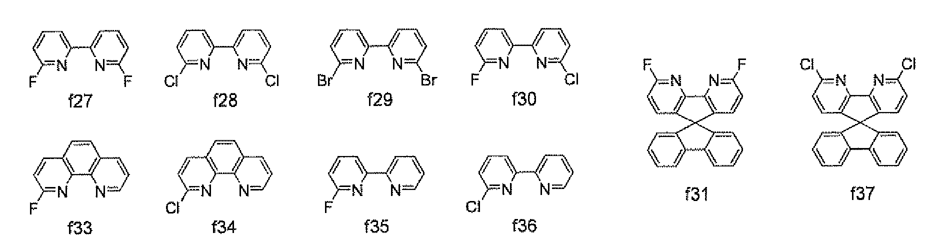

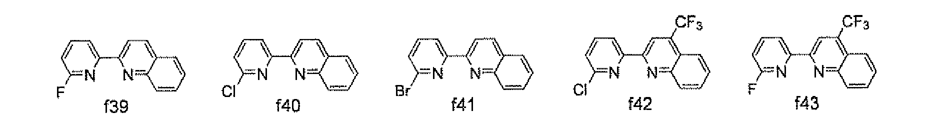

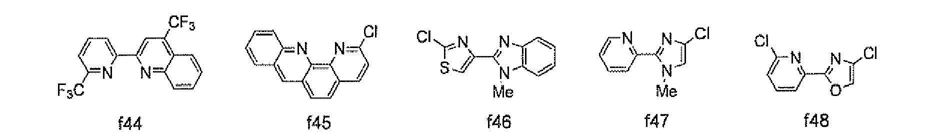

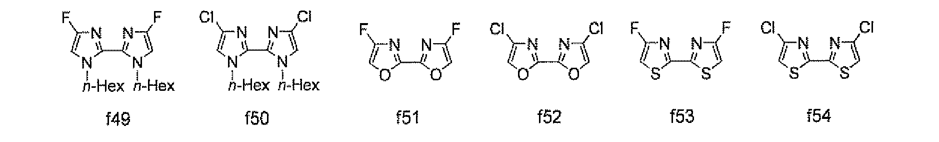

Among specific examples of L⁸, f1, f2, f2', f4 to f11, f13, f18, f20 to f31, f33 to f37, and f39 to f54 are preferable, f1, f2, f2', f4, f5, f7, f8, f9, f18, f21, f22, f23, f25, f26, f27, f28, f29, f30, f31, f33, f34, f35, f36, f37, f39, f40, f41, f42, f43, f44, f49, f51, f52, f53, and f54 are more preferable, f21, f22, f27, f28, f29, f30, f33, f34, f37, f39, f40, f42, and f43 are still more preferable, f21, f22, f27, f28, f37, f39, and f42 are particularly preferable, and f21, f22, f27, and f28 are most preferable.

X⁴ is an anion, and specific examples thereof include a fluoride ion, a chloride ion, a bromide ion, an iodide ion, a sulfate ion, a nitrate ion, a carbonate ion, an acetate ion, a perchlorate ion, a tetrafluoroborate ion, a hexafluorophosphate ion, a hexafluoro antimony ion, a hexafluoro arsenic ion, a methanesulfonate ion, a trifluoromethanesulfonate ion, a trifluoroacetate ion, a benzenesulfonate ion, a p-toluenesulfonate ion, a dodecylbenzenesulfonate ion, a tetraphenylborate ion, and a tetrakis(pentafluorophenyl)borate ion. Examples of X³ also include anions of the high-molecular compounds containing repeated unit having such an ion structure. Preferred examples of X³ include a fluoride ion, a chloride ion, a bromide ion, an iodide ion, a nitrate ion, a tetrafluoroborate ion, a hexafluorophosphate ion, a trifluoromethanesulfonate ion, and a tetraphenylborate ion, more preferred examples include a chloride ion, a bromide ion, an iodide ion, a nitrate ion, a tetrafluoroborate ion, and a hexafluorophosphate ion, and still more preferred examples include a bromide ion, an iodide ion, and a tetrafluoroborate ion.

In compositional formula (5), d'3 and e'3 are independently a positive number that is smaller than 2.0, f'3 is a number of from 0 to 1.5. Preferably, d'3, e'3, and f'3 are independently from 0.5 to 1.5, more preferably d'3, e'3, and f'3 are independently from 0.7 to 1.3, and still more preferably d'3, e'3, and f'3 are independently from 0.8 to 1.2.

Specific examples of the luminescent silver complex represented by compositional formula (5) include one in which L⁷ is a molecule represented by any one of formulae a1 to a33, b1 to b4, and c1 to c7, L⁸ is a molecule represented by any one of formulae f1 to f2, f4 to f11, f13, f18, f20, f2', f21 to f31, f33 to f37, and f39 to f54, and X⁴ is the above anion. Preferred specific examples of the luminescent silver complex represented by compositional formula (5) include one in which L⁷ is a molecule represented by any one of formulae a1 to a4, a6 to 13, a16 to a17, and a25 to a33, L⁸ is a molecule represented by any one of formulae f1 to f2, f4 to f11, f13, f18, f20, f2', f21 to f31, f33 to f37, and f39 to f54, and X³ is the above anion. More preferably, d'3, e'3, and f'3 are each independently from 0.5 to 1.5.

In compositional formula (6), L⁹ is defined as the same as L¹ described above, and specific examples and preferred examples thereof are also the same as those of L¹ described above. L⁹ is particularly preferably a2, a4, and a6.

In compositional formula (6), L¹⁰ is a molecule having a phosphorus atom, a nitrogen atom, an oxygen atom, a sulfur atom, or an arsenic atom, which are capable of coordinating to Ag⁺, as one atom capable of coordinating to Ag⁺, and having an oxygen anion or a sulfur anion as another ion capable of coordinating to Ag⁺. L¹⁰ is preferably a molecule represented by the following formula (G).

Q¹⁰-R¹⁰-Q¹⁰⁰ (G)

Q¹⁰ is -P(R¹⁰⁰)₂, -As(R¹⁰¹)₂, -P(=O)(R¹⁰²)₂, -OH, - CO₂H, -SH, -SO₃H, -OR¹⁰³, -CO₂R¹⁰⁴, -SR¹⁰⁵, -SO₃R¹⁰⁶, -SO₃R¹⁰⁷, - N(R¹⁰⁸)₂, or an optionally substituted nitrogen-containing heterocyclic group, and Q¹⁰⁰ is -O⁻, -S⁻, -CO₂⁻, or -SO₃⁻. Q¹⁰ and Q¹⁰⁰ may be bonded to each other to form a ring. R¹⁰⁰ to R¹⁰⁸ are each independently a hydrogen atom or an optionally substituted hydrocarbon group, and two R¹⁰⁰s, two R¹⁰¹s, two R¹⁰²s, two R¹⁰⁸s may be the same as or different from each other. Two R¹⁰⁰s may be bonded to each other to form a ring, two R¹⁰¹s may be bonded to each other to form a ring, two R¹⁰²s may be bonded to each other to form a ring, and two R¹⁰⁸s may be bonded to each other to form a ring. R¹⁰ is a divalent group, but may be a direct bonding when Q¹⁰ is an optionally substituted nitrogen-containing heterocyclic group.

Specific examples and preferred examples of the optionally substituted hydrocarbon groups in R¹⁰⁰ to R¹⁰⁸ are the same as those in R¹¹ described above. Specific examples of the optionally substituted nitrogen-containing heterocyclic group in Q¹⁰ are the same as those in Q⁷ described above. A pyridyl group, an imidazolyl group, and a quinolyl group are preferable, and a quinolyl group, for example, is more preferable. Specific examples and preferred examples of the divalent group in R¹⁰ are the same as those in R¹ described above.

Q¹⁰ is preferably -P(R¹⁰⁰)₂, -OH, -CO₂H, or a nitrogen-containing heterocyclic group, more preferably - P(R¹⁰⁰)₂ wherein R¹⁰⁰ is an optionally substituted aryl group, or a nitrogen-containing heterocyclic group, and still more preferably -P(R¹⁰⁰)₂ wherein R¹⁰⁰ is an optionally substituted phenyl group.

Q¹⁰⁰ is preferably -O⁻, -S⁻, or -CO₂⁻, more preferably -O⁻ or -S⁻, and still more preferably -O⁻.

Specific examples of the molecule represented by (G) are shown below.

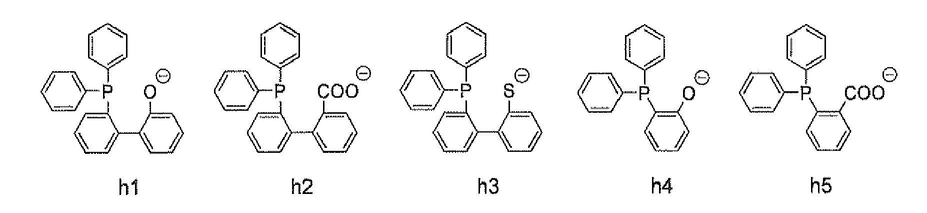

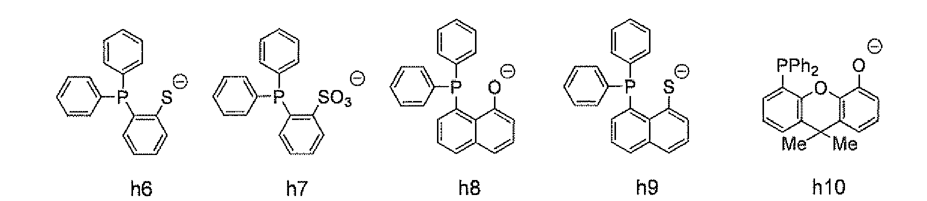

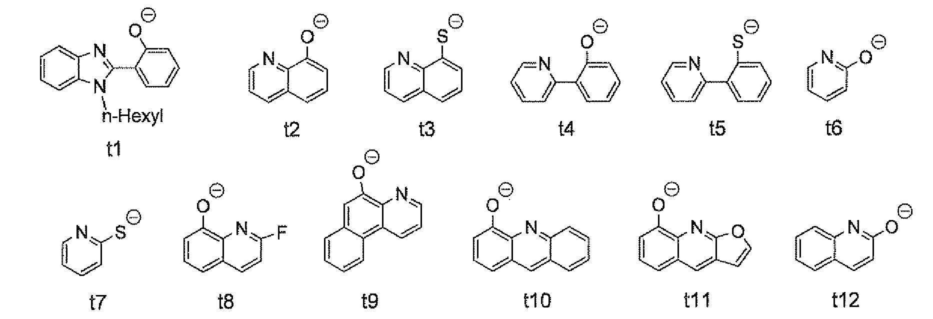

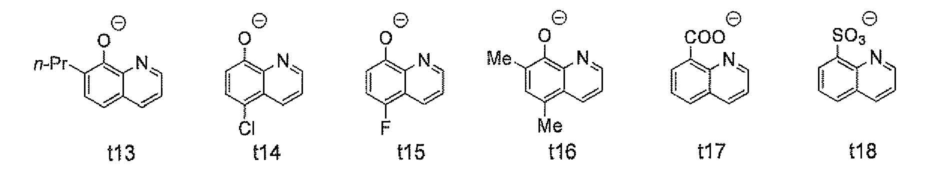

Among h1 to h10, and t1 to t18, preferred examples include h1, h2, h3, h4, h5, h6, h8, h9, h10, t1, t2, t3, t4, t5, t8, t9, t10, t11, t13, t14, t15, t16, and t17, more preferred examples include h1, h3, h4, h6, h10, t1, t2, t3, t4, t5, t13, t14, and t15, still more preferred examples include h1, h4, h10, t2, t4, t13, and t14, and particularly preferred examples include h1, h4, and h10.

d'4 and e'4 are independently a positive number that is smaller than 2.0. Preferably, d'4 and e'4 are independently from 0.5 to 1.5, more preferably d'4 and e'4 are independently from 0.7 to 1.3, and still more preferably d'4 and e'4 are independently from 0.8 to 1.2.

Specific examples of the luminescent silver complex represented by compositional formula (6) include one in which L⁹ is a molecule represented by any one of formulae a1 to a33, b1 to b4, and c1 to c7, and L¹⁰ is a molecule represented by any one of formulae h1 to h10 and t1 to t18. Preferred specific examples of the luminescent silver complex represented by compositional formula (6) include one in which L⁹ is a molecule represented by any one of formulae a1 to a4, a6 to 13, a16 to a17, and a25 to a33, L¹⁰ is a molecule represented by any one of formulae h1 to h6, h8 to h10, t1 to t5, t8 to t11, and t13 to t17. More preferably, d'4 and e'4 are each independently from 0.5 to 1.5.

The silver complex of the present invention may be a mononuclear complex, a binuclear complex, a trinuclear complex, a tetranuclear complex, a pentanuclear complex, a hexanuclear complex, or a complex having heptanuclear or more, or may be a mixture thereof. The silver complex of the present invention is preferably a mononuclear complex, a binuclear complex, or a trinuclear complex, more preferably a mononuclear complex or a binuclear complex, and still more preferably a mononuclear complex.

Specific examples of the luminescent silver complex of the present invention are shown in Tables 1-1 to 1-4. Table 1-1 shows examples of the silver complex represented by formula (3). Table 1-2 shows examples of the silver complex represented by formula (4). Table 1-3 shows examples of the silver complex represented by formula (5). Table 1-4 shows examples of the silver complex represented by formula (6). In the tables, X³ and X⁴ in formulae (4) and (5) are not listed, but include ions described as examples of the above X³ and X⁴ for each compound number; a fluoride ion, a chloride ion, a bromide ion, an iodide ion, a sulfate ion, a nitrate ion, a carbonate ion, an acetate ion, a perchlorate ion, a tetrafluoroborate ion, a hexafluorophosphate ion, a hexafluoro antimony ion, a hexafluoro arsenic ion, a methanesulfonate ion, a trifluoromethanesulfonate ion, a trifluoroacetate ion, a benzenesulfonate ion, a p-toluenesulfonate ion, a dodecylbenzenesulfonate ion, a tetraphenylborate ion, or a tetrakis(pentafluorophenyl)borate ion. Also, d'1, e'1, f'1, d'2, e'2, f'2, d'3, e'3, f'3, d'4, and e'4 in formulae (3) to (6) are not listed, but can represent any number within a defined range for each compound number.

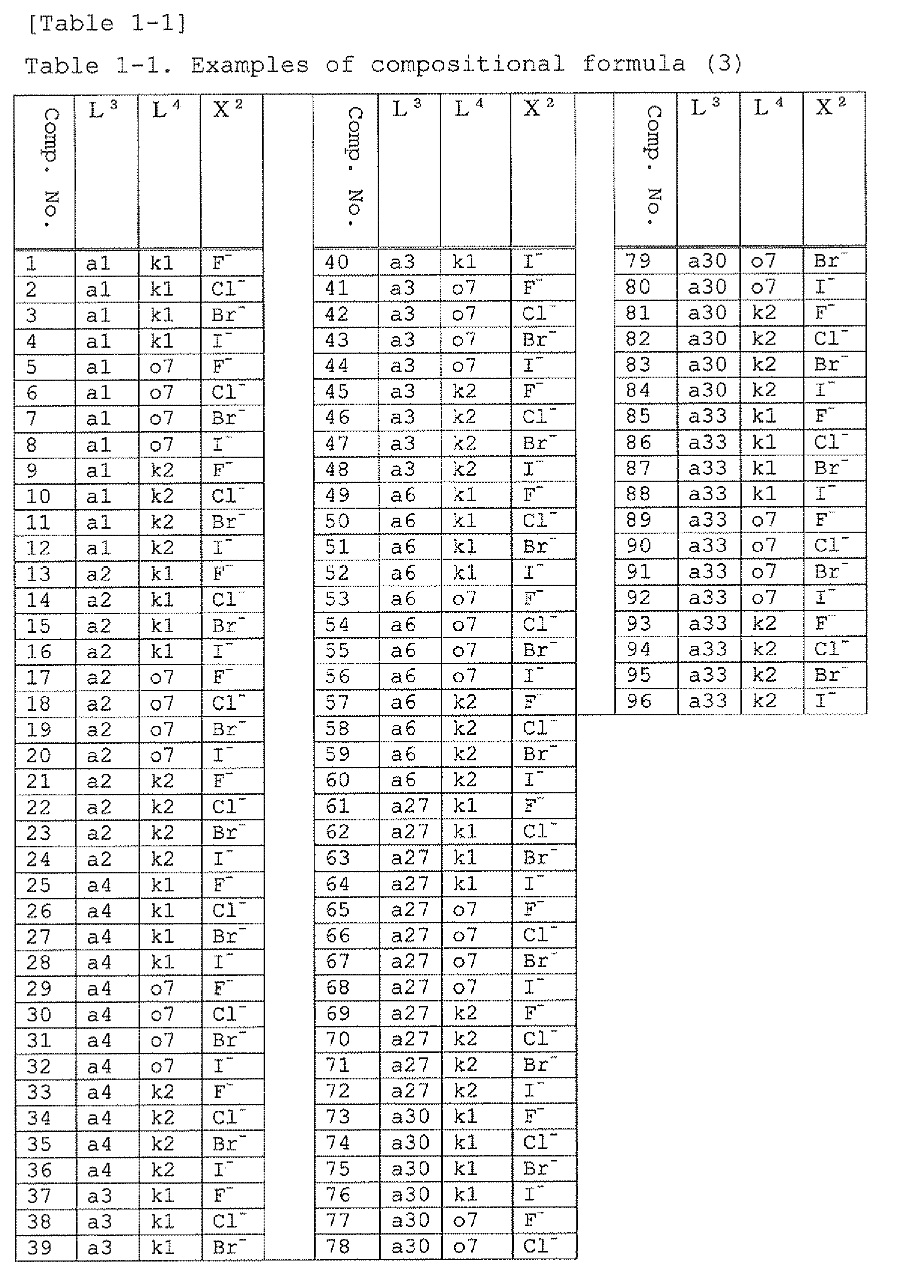

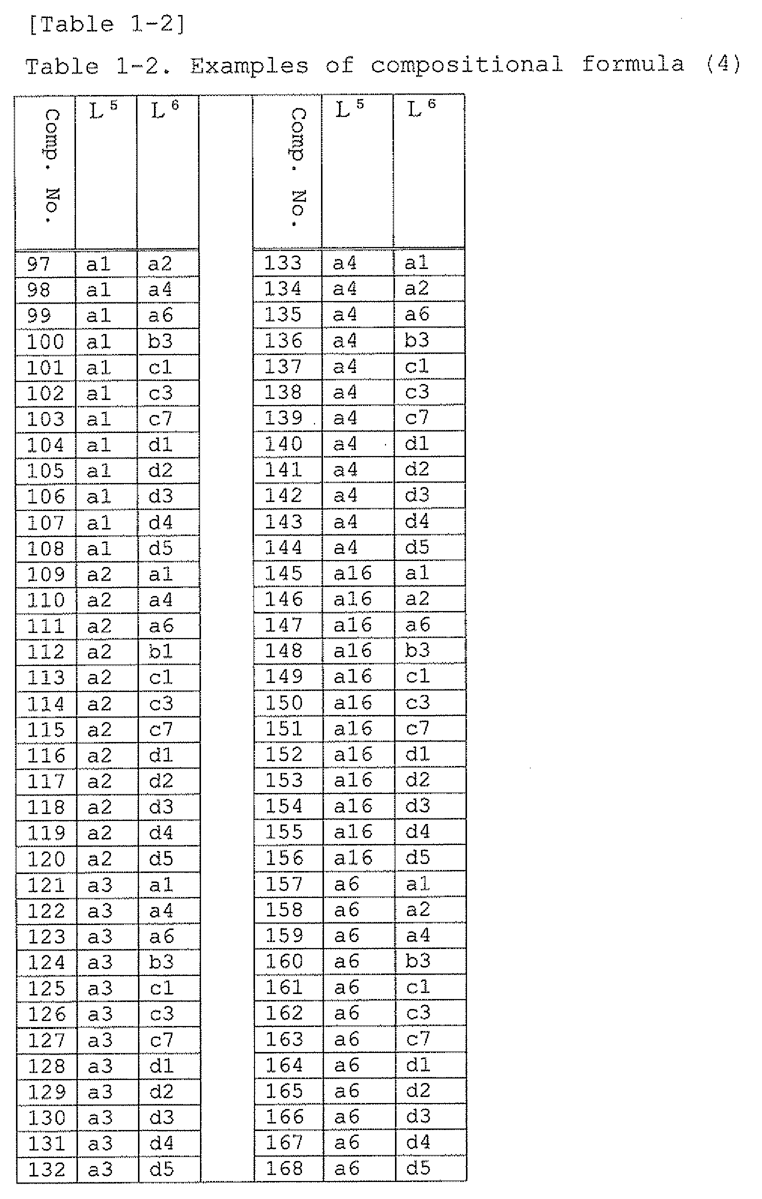

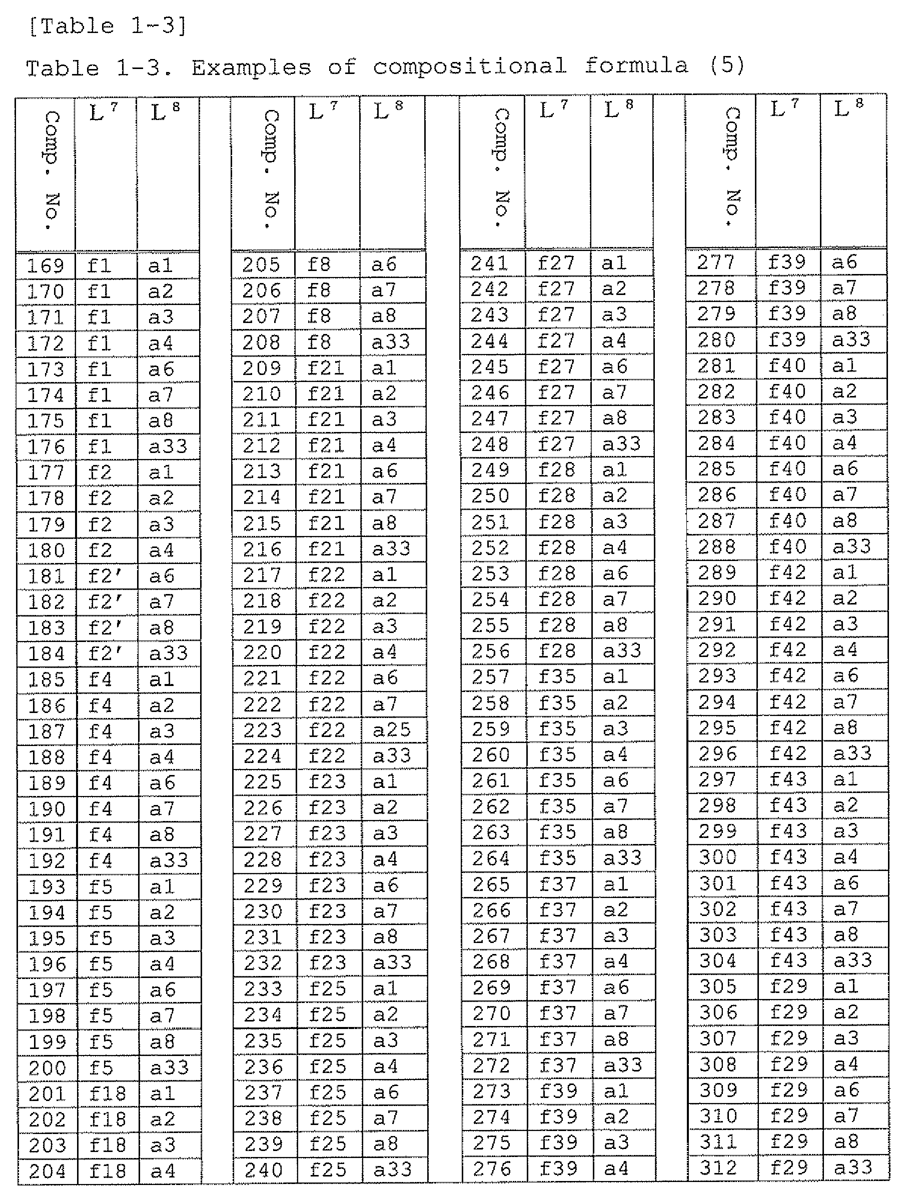

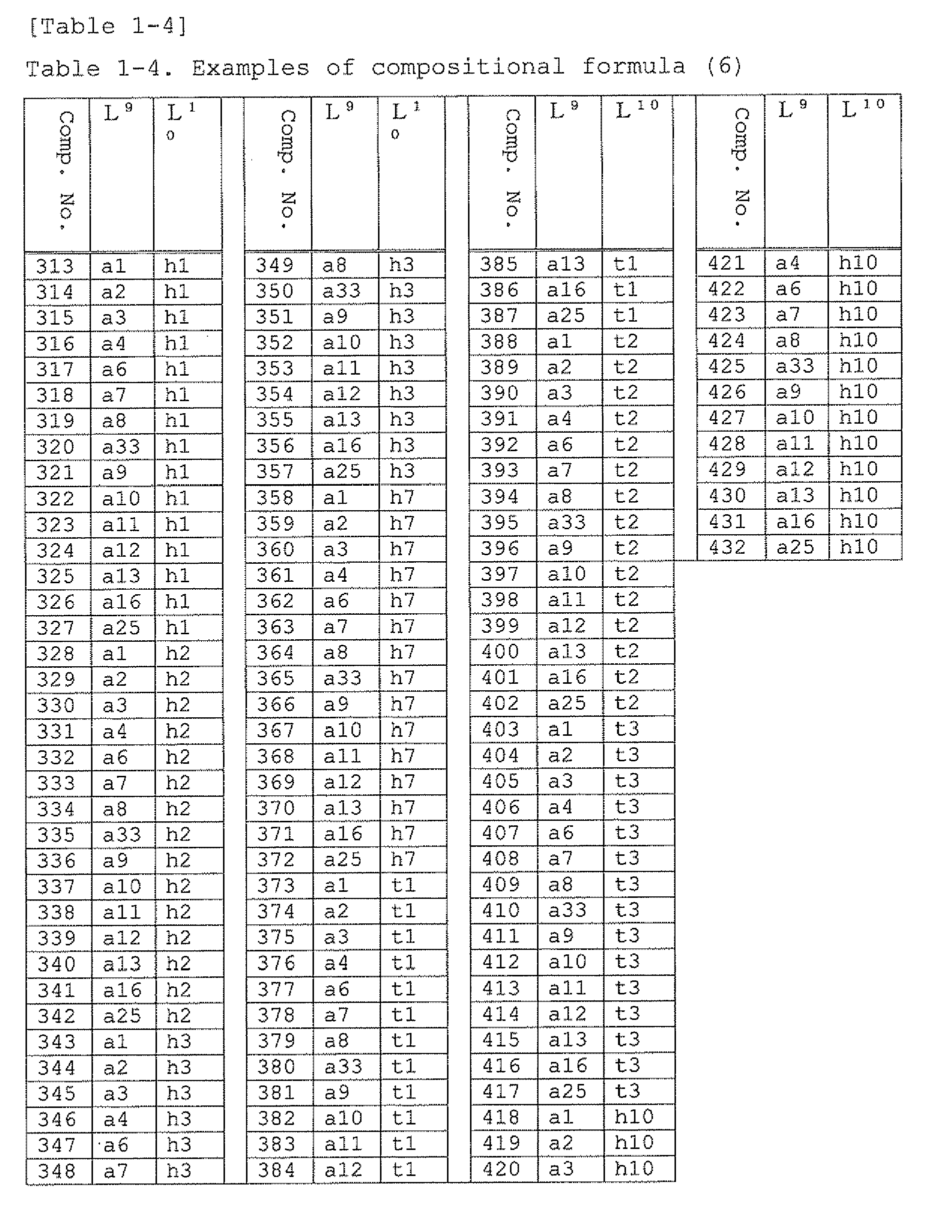

Among the compounds listed in Table 1-1, the compounds represented by the compound numbers 1 to 4, 9 to 16, 21 to 28, 33 to 40, 45 to 52, and 57 to 64 are preferable, and the compounds represented by the compound numbers 1 to 4, 13 to 16, 25 to 28, and 49 to 52 are more preferable.

Among the compounds listed in Table 1-2, the compounds represented by the compound numbers 102 to 107, 114 to 119, 126 to 131, 138 to 143, and 150 to 155 are preferable, and the compounds represented by the compound numbers 102, 103, 106, 107, 114, 115, 118, 119, 126, 127, 130, 131, 138, 139, 142, 143, 150, 151, 154, 155, 162, 163, 166, and 167 are more preferable.

Among the compounds listed in Table 1-3, the compounds represented by the compound numbers 172, 173, 176, 180, 181, 184, 188, 189, 192, 196, 197, 200, 204, 205, 208, 212, 213, 216, 220, 221, 224, 228, 229, 232, 236, 237, 240, 244, 245, 248, 252, 253, 256, 260, 261, 264, 268, 269, 272, 276, 277, 280, 284, 285, 288, 292, 293, 296, 300, 301, 304, 308, 309, and 312 are preferable, and the compounds represented by the compound numbers 212, 213, 216, 220, 221, 224, 244, 245, 248, 252, 253, 256, 260, 261, 264, 268, 269, 272, 276, 277, 280, 292, 293, 296, 300, 301, and 304 are more preferable.

Among the compounds listed in Table 1-4, the compounds represented by the compound numbers 313 to 320, 328 to 335, 343 to 350, 358 to 365, 373 to 380, 388 to 395, 403 to 410, and 418 to 425 are preferable, and the compounds represented by the compound numbers 314, 316, 317, 318, 320, 344, 346, 347, 348, 350, 374, 376, 377, 378, 380, 389, 391, 392, 393, 395, 419, 421, 422, 423, and 425 are more preferable.

Representative examples of the luminescent silver complex of the present invention are shown below. The representative silver complex of formula (3) is shown in a1-k1-i, the representative silver complex of formula (4) is shown in a1-c3-pf6, the representative silver complex of formula (5) is shown in f22-a6-bf4, and the representative silver complex of formula (6) is shown in a4-h1.

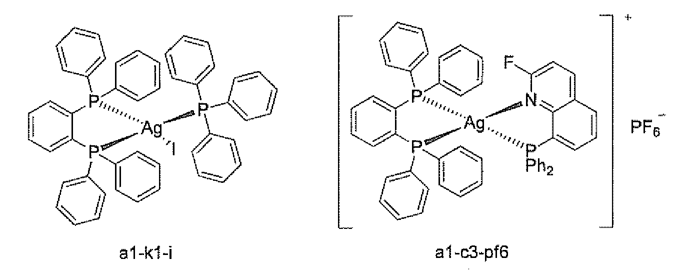

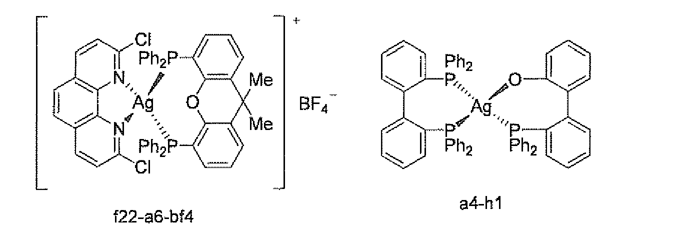

The luminescent silver complex of the present invention can utilize a triplet for EL luminescence, so that emission lifetime thereof is desirably longer. The emission lifetime of the luminescent silver complex in a solid state under air at room temperature is preferably 3 ns or more, more preferably 10 ns or more, still more preferably 200 ns or more, and particularly preferably 1000 ns or more. The maximum emission lifetime is 1 s.

To extend the emission lifetime of the luminescent silver complex of the present invention, difference between S1 energy and T1 energy is preferably 0.3 eV or smaller. As long as difference between S1 energy and T1 energy is 0.3 eV or smaller, the luminescent silver complex may exhibit an emission lifetime of 200 ns or more. Difference between S1 energy and T1 energy is more preferably 0.2 eV or smaller, and still more preferably 0.1 eV or smaller.

The way to obtain difference between S1 energy and T1 energy will be described below. First, structure optimizing calculation of each silver complex is carried out according to the density functional theory using B3LYP as a functional, LANL2DZ for a silver atom and a halogen atom as a basis function, and 6-31G(d) for other atoms. As a calculation program, Gaussian03 (produced by Gaussian Inc.) is used, but other programs can be used as long as using equivalent techniques.

For the initial structure of each silver complex to be used, in compositional formula (1), each ligand atom in L¹ and L², and X¹ are arranged to be away from Ag⁺ within 3.0 angstroms, with a = b = 1, k = 0 and a total charge of +1 when L² has two atoms capable of coordinating to Ag⁺; with a = b = 1, k = 0, and a total charge of 0 when L² has one atom capable of coordinating to Ag⁺ and one ion capable of coordinating to Ag⁺; and with a = b = k = 1, and a total charge of 0 when L² has only one atom capable of coordinating to Ag⁺. Accordingly, for the initial structure to be used, each ligand atom in L³ to L¹⁰, and X² to X⁴ are arranged to be away from a silver atom within 3.0 angstroms, with d'1 = 1, e'1 = 1, f'1 = 1, and a total charge of 0 in compositional formula (3); with d'2 = e'2 = 1, f'2 = 0, and a total charge of +1 in compositional formula (4); with d'3 = e'3 = 1, f'3 = 0, and a total charge of +1 in compositional formula (5); and with d'3 = e'3 = 1, and a total charge of 0 in compositional formula (6).

As used herein, S1 energy refers to energy in a minimum excited singlet state on the basis of the ground state in a single-electron excited state, and T1 energy refers to energy in a minimum excited triplet state on the basis of the ground state in a single-electron excited state. S1 energy and T1 energy can be obtained by applying the time-dependent density functional theory to the optimized structure. As calculation techniques used for the time-dependent density functional theory, B3LYP as a functional, LANL2DZ for a silver atom and a halogen atom as a basis function, and 6-31G(d) for other atoms are used. As a calculation program, Gaussian03 (produced by Gaussian Inc.) is used, but other programs can be used as long as using equivalent techniques.

The luminescent silver complex of the present invention can be produced according to conventional methods including mixing a molecule constituting the silver complex with a silver salt, for example, a fluoride, a chloride, a bromide, an iodide, a sulfate, a nitrate, a carbonate, an acetate, a perchlorate, a tetrafluoroborate, a hexafluorophosphate, a hexafluoroantimonate, a hexafluoroarsenate, a methanesulfonate, a trifluoromethanesulfonate, a trifluoroacetate, a benzenesulfonate, a p-toluenesulfonate, a dodecylbenzenesulfonate, a tetraphenylborate, and a tetrakis(pentafluorophenyl)borate, in an inert solvent.

The above f22-a6-bf4 will be described below as an example. 1 mmol) of 4,5-bis(diphenylphosphino)-9,9-dimethylxanthene, 1 mmol of silver(I) tetrafluoroborate, and 30 mL of solvent (for example, acetonitrile and dichloromethane) are mixed and reacted with stirring at room temperature for 30 minutes. Then, 1 mmol of 2,9-dichloro-1,10-phenanthroline is added to the resultant mixture, and heated to reflux about for one hour. Then, the reaction solution is filtrated and the filtrate solvent is evaporated slowly for recrystallization to produce f22-a6-bf4.

The polymer having the residue of the above luminescent silver complex can also be used as a luminescent material. The polymer can be produced by polymerizing the above luminescent silver complex, or chemically binding the above luminescent silver complex to other high-molecular materials.

For the polymer, the polymer having the repeated unit represented by formula (25) and the repeated unit formed by removing two hydrogen atoms from the silver complex represented by formulae (1), and (3) to (6); and the polymer having the repeated unit in which the group formed by removing one hydrogen atom from the structure represented by formula (25) is bonded to the group formed by removing one hydrogen atom from the silver complex represented by formulae (1), and (3) to (6) are desirable.

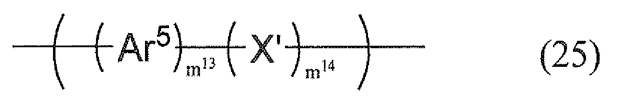

Ar⁵ is a divalent aromatic group which may have a substituent, X' is an imino group which may have a substituent, a silylene group which may have a substituent, an ethenylene group and an ethynylene group which may have a substituent. m¹³ and m¹⁴ are each independently a number of 0 or more, and at least one of m¹³ and m¹⁴ is a positive number. When m¹³ and/or m¹⁴ represents a number of 2 or more, there are m¹³ and/or m¹⁴ of Ar⁵s and/or X' s, and they may be each independently the same as or different from each other. All Ar⁵s in the polymer may not have the same structure.

Examples of the divalent aromatic group represented by Ar⁵ in the above formula (25) include a divalent aromatic hydrocarbon group and a divalent aromatic heterocyclic group. Specific examples of the divalent aromatic group include the divalent group formed by removing two hydrogen atoms from a monocyclic aromatic ring such as a benzene ring, a pyridine ring, a pyridazine ring, a pyrimidine ring, a pyrazine ring, a 1,3,5-triazine ring, a 1,2,4-triazine ring, a 1,2,4,5-tetrazine ring, a furan ring, a pyrrole ring, a thiophene ring, a pyrazole ring, an imidazole ring, an oxazole ring, an isoxazole ring, a 1,2,5-oxadiazole ring, a 1,3,4-oxadiazole ring, a 2,3-diazafuran ring, a thiazole ring, an isothiazole ring, a 2,4-diazafuran ring, a 1,3,4-thiadiazole ring, a 1,2,3-thiadiazole ring, a 1,2,4-thiadiazole ring, or a 2H-1,2,3-triazole ring; the divalent group formed by removing two hydrogen atoms from a condensed polycyclic aromatic ring in which two or more of the monocyclic aromatic rings are condensed; the divalent group formed by removing two hydrogen atoms from an aromatic ring assembly having two or more of the aromatic rings which are selected from the group consisting of the monocyclic aromatic ring and the condensed polycyclic aromatic ring, linked to one another with a single bond, an ethenylene group, or an ethynylene group; and the divalent group formed by removing two hydrogen atoms from a bridged polycyclic aromatic ring having a cross-linkage of the condensed polycyclic aromatic rings or two adjacent aromatic rings of the aromatic ring assembly through a divalent group such as a methylene group, an ethylene group, a carbonyl group, and an imino group.

The number of the monocyclic aromatic ring constituting the condensed polycyclic aromatic ring is preferably from 2 to 4, more preferably 2 to 3, and still more preferably 2. In the aromatic ring assembly, the number of the aromatic ring to be linked is preferably 2 to 4, more preferably 2 to 3, and still more preferably 2 in terms of solubility. In the bridged polycyclic aromatic ring, the number of the aromatic ring to be bridged is preferably 2 to 4, more preferably 2 to 3, and still more preferably 2 in terms of solubility of the polymer.

Examples of the monocyclic aromatic ring include the following rings.

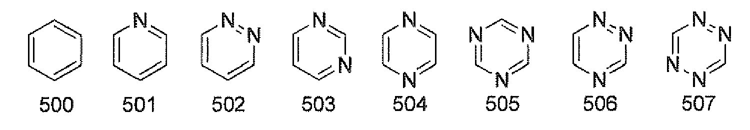

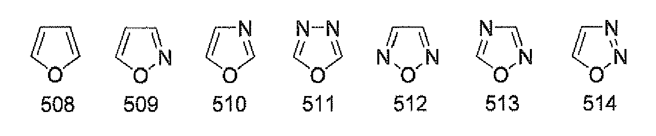

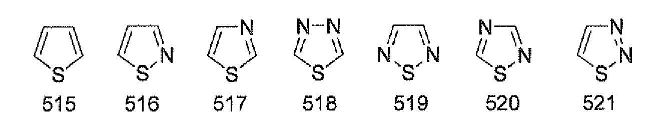

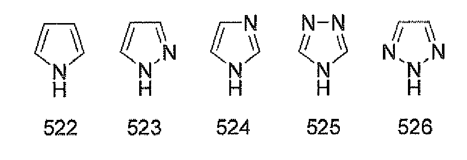

Examples of the condensed polycyclic aromatic ring include the following rings.

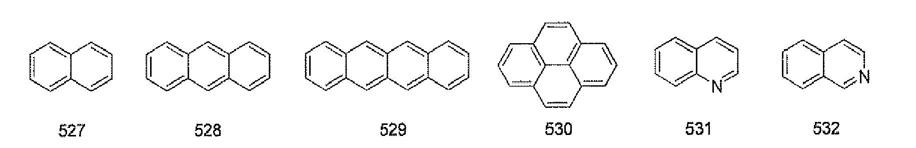

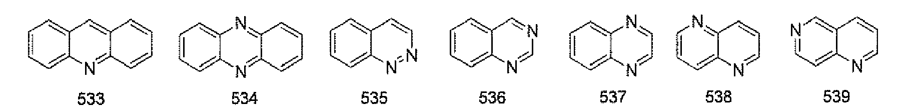

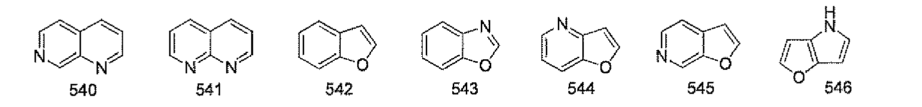

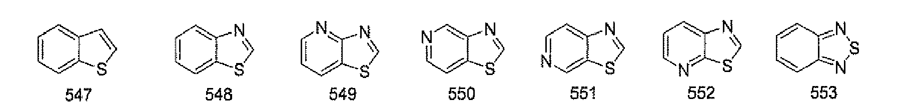

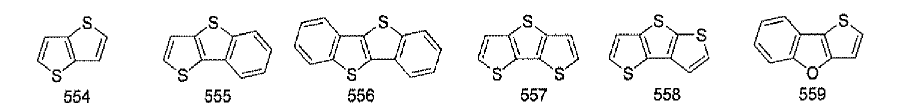

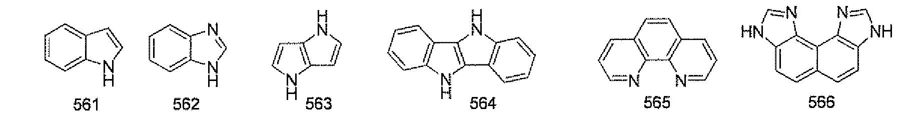

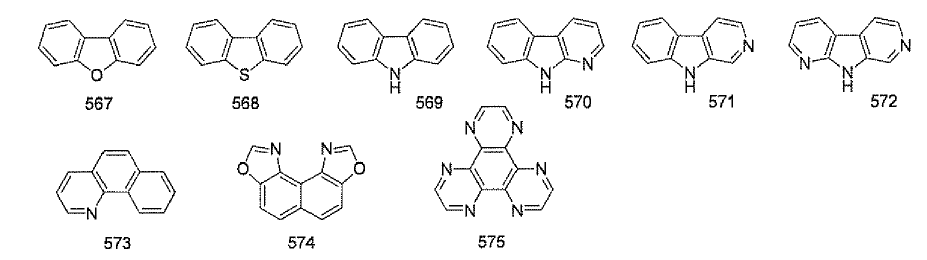

Examples of the aromatic ring assembly include the following rings.

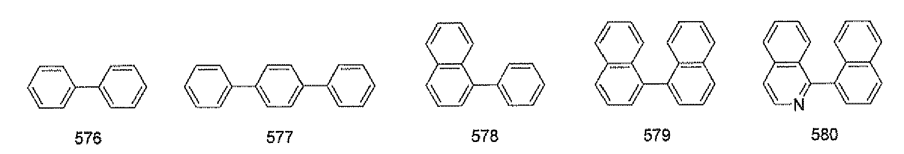

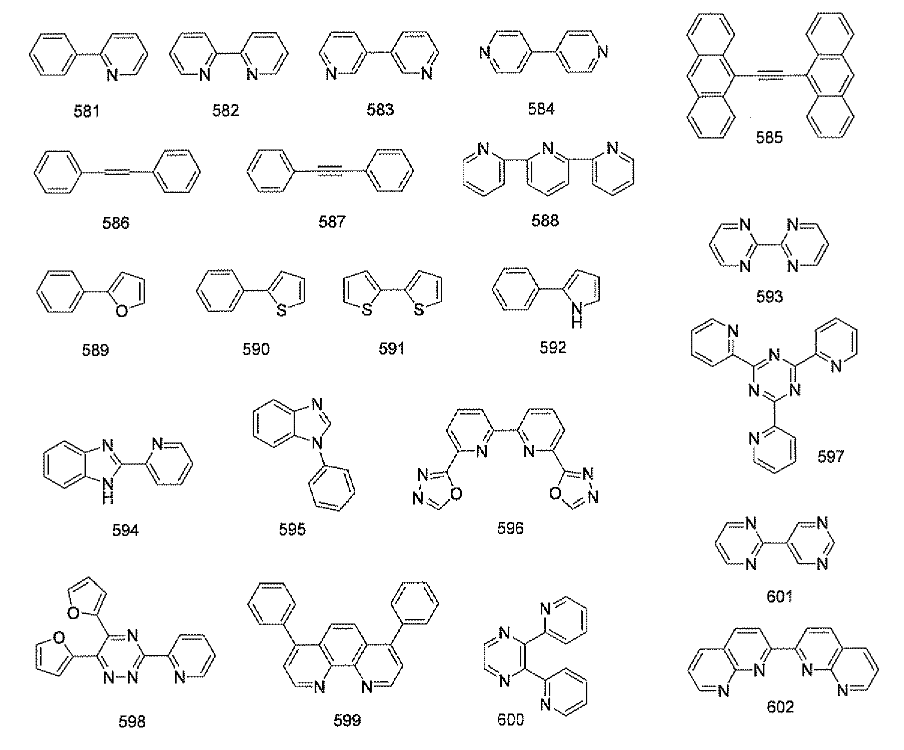

Examples of the bridged polycyclic aromatic ring include the following rings.

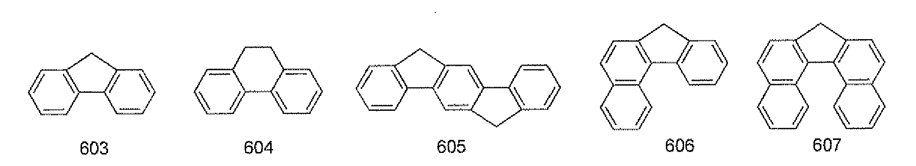

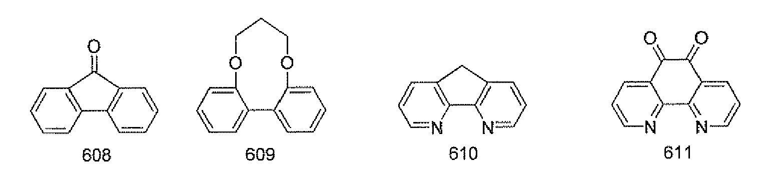

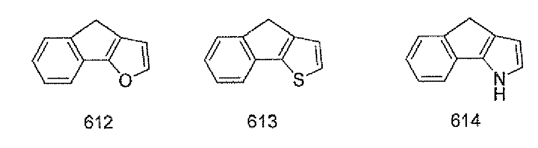

The divalent aromatic group represented by the Ar⁵ is preferably the divalent group formed by removing two hydrogen atoms from the ring represented by 500 to 505, 508 to 514, 527 to 534, 543, 561, 562, 565, 567 to 574, 576 to 584, 587 to 603, or 609, more preferably the divalent group formed by removing two hydrogen atoms from 500 to 505, 511, 527, 543, 565, 569, 576, 582, 603, or 610, and still more preferably the divalent group formed by removing two hydrogen atoms from 500, 576, or 603. The aromatic group may have a substituent.

Examples of the residue of the luminescent silver complex include the divalent group or the monovalent group formed by removing two or one hydrogen atoms from the complex having the composition described in the Tables 1-1 to 1-4. Specific examples thereof include the divalent group or the monovalent group formed by removing two or one hydrogen atoms from the a1-ka-i, a1-c3-pf6, f22-a6-bf4, and a4-h1.

The content of the residue of the luminescent silver complex of the present invention in the polymer having the residue of the luminescent silver complex of the present invention is generally from 0.01 to 100% by weight, preferably from 1 to 100% by weight, more preferably from 10 to 80% by weight, and particularly preferably from 20 to 40% by weight based on the total polymer weight.

For the polymer having the residue of the luminescent silver complex, the number-average molecular weight in terms of polystyrene is generally from 1 × 10³ to 1 × 10⁸, preferably from 1 × 10³ to 1 × 10⁷, more preferably from 2 × 10³ to 1 × 10⁶, still more preferably from 3 × 10³ to 5 × 10⁵, and particularly preferably from 5 × 10³ to × 10⁵.

The above luminescent silver complex or the polymer having the residue of the above luminescent silver complex can be used as a luminescent material in the form of the composition mixed with the high-molecular compound.

Examples of the high-molecular compound in the composition include the compound having the repeated unit represented by the above formula (25); a polymer including a residue of a hole transport material such as a carbazole derivative, a pyrazoline derivative, a pyrazolone derivative, an arylamine derivative, a stilbene derivative, a triphenyldiamine derivative, a phenylenediamine derivative, a styrylanthracene derivative, a styrylamine derivative, an aromatic dimethylidyne derivative, a hydrazone derivative, an aromatic tertiary amine compound, and an amino-substituted chalcone derivative; a high-molecular hole transport material including a conductive high-molecular oligomer such as a polyarylalkane derivative, a polyvinylcarbazole derivative, a polysilane derivative, a polysiloxane derivative having an aromatic amine in a side-chain or a main-chain, a polyaniline derivative, a polythiophene derivative, a poly(2,5-thienylenevinylene) derivative, an aniline-based copolymer, and polythiophene; a polymer including a residue of an electron transport material such as a triazine derivative, a triazole derivative, an oxazole derivative, an oxadiazole derivative, an imidazole derivative, a diphenylquinone derivative, a thiopyrandioxide derivative, a carbodiimide derivative, a fluorenylidenemethane derivative, a distyrylpyrazine derivative, an aromatic ring carboxylic acid anhydride derivative such as naphthalene or perylene, various kinds of metal complexes represented by a metal complex of an 8-quinolinol derivative and a metal complex having, for example, benzoxazole or benzothiazole as a ligand, an organic silane derivative, a naphthoquinone derivative, an anthraquinone derivative, a tetracyanoanthraquinodimethane derivative, a fluorenone derivative, a diphenylenedicyanoethylene derivative, a diphenoquinone derivative, an 8-hydroxyquinoline derivative, a phthalocyanine derivative, and a metalloporphyrin derivative; an electron transport material such as a polytriazine derivative, a polyoxazole derivative, a polynaphthalene derivative, a polyaniline derivative, a polythiophene derivative, a polythienylenevinylene derivative, a polyquinoline derivative, a polyquinoxaline derivative, and a polymer including an aromatic amine structure in a main-chain or a side-chain; and a high-molecular matrix such as polyvinyl chloride, polycarbonate, polystyrene, polymethyl methacrylate, polybutyl methacrylate and a derivative thereof, a polyfluorene derivative, polyester and a derivative thereof, polysulfone and a derivative thereof, a polyphenyleneoxide derivative, a polybutadiene derivative, hydrocarbon resin, ketone resin, phenoxy resin, polyamide, ethylcellulose, vinyl acetate, ABS resin, polyurethane, melamine resin, unsaturated polyester resin, alkyd resin, epoxy resin, silicon resin, polyethyleneoxide and a derivative thereof, polyacrylonitrile and a derivative thereof, and a copolymer of vinylidene fluoride and propylene hexafluoride. The compound having the repeated unit represented by the above formula (25) and polymethyl methacrylate are preferable.

For the high-molecular compound, the number-average molecular weight in terms of polystyrene is generally from 1 × 10³ to 1 × 10⁸, preferably from 1 × 10³ to 1 × 10⁷, more preferably from 2 × 10³ to 1 × 10⁶, still more preferably from 3 × 10³ to 5 × 10⁵, and particularly preferably from 5 × 10³ to 1 × 10⁵.

The content of the luminescent silver complex in the composition is generally from 0.01 to 99.99% by weight, preferably from 0.1 to 99% by weight, more preferably from 1 to 90% by weight, still more preferably from 5 to 80% by weight, and particularly preferably from 10 to 50% by weight based on the total weight of the composition.

The composition having the luminescent silver complex of the present invention mixed with the high-molecular compound can be obtained by preparing a suspension or a solution containing the silver complex and the high-molecular compound and drying it. As a solvent to prepare the suspension or the solution, water or an organic solvent can be used. Examples of the organic solvent include benzene, toluene, xylene, chloroform, 1,2-dichloroethane, 1,1,2,2-tetrachloroethane, dichloromethane, tetrahydrofuran, 2-methyltetrahydrofuran, 1,4-dioxane, N,N-dimethylformamide, dimethyl sulfoxide, acetone, methyl ethyl ketone, acetonitrile, ethyl acetate, methanol, ethanol, isopropyl alcohol, hexane, cyclohexane, and mixtures thereof.

The method to remove solvent can be appropriately selected from, for example, air drying, heat drying, drying under reduced pressure, heat drying under reduced pressure, and blow-drying with nitrogen gas. Air drying and heat drying are preferable, and heat drying is more preferable.

The above luminescent silver complex or the polymer having the residue of the above luminescent silver complex can be used as a luminescent material in the form of the thin-film containing it.

The thickness of the thin-film is generally from 1 nm to 50 µm, preferably from 3 nm to 10 µm, more preferably from 5 nm to 5 µm, still more preferably from 10 nm to 1 µm, and particularly preferably from 20 nm to 300 nm. The thin-film may contain a pinhole or a concavo-convex shape, but preferably does not contain a pinhole or a concavo-convex shape.

The content of the luminescent silver complex in the thin-film is generally from 0.01 to 100% by weight, preferably from 0.1 to 99% by weight, more preferably from 1 to 90% by weight, still more preferably from 5 to 80% by weight, and particularly preferably from 10 to 50% by weight based on the total weight of the thin-film.

The thin-film may contain a carrier to form the thin-film. As the carrier, a low-molecular organic material, a high-molecular organic material, an organic-inorganic composite material, an inorganic material, and mixtures thereof can be used. The carrier can be optionally selected depending on the application.

The thin-film of the present invention can be produced by, for example, the method including a step of vapor-depositing the silver complex and a carrier onto a substrate in an arbitrary ratio, or the method including a step of suspending or dissolving the silver complex and a carrier in a solvent in an arbitrary ratio followed by coating. The latter method is preferable to coat the suspension or the solution. Examples of the solvent to prepare the suspension or the solution include a solvent used for preparing the composition containing the high-molecular compound and the luminescent silver complex or the polymer including the residue of the luminescent silver complex.

Examples of the coating method include spin coating, casting, dip coating, Gravure coating, bar coating, roll coating, spray coating, screen printing, flexo printing, and offset printing. Spin coating, casting, roll coating, spray coating, screen printing, flexo printing, and offset printing are preferable, and roll coating, spray coating, and flexo printing are more preferable.

The thin-film can be obtained by removing solvent after coating. The removing method can be appropriately selected from, for example, air drying, heat drying, drying under reduced pressure, heat drying under reduced pressure, and blow-drying with nitrogen gas. Air drying and heat drying are preferable, and heat drying is more preferable.

The present invention also provides a luminescent device containing the above thin-film.

Examples of the luminescent device include one holding a thin-film layer formed of a single layer or a plurality of layers having a luminescent layer between a pair of electrodes including an anode and a cathode wherein at least one layer of the thin-film layer is the thin-film.

The content of the luminescent silver complex of the present invention in the thin-film layer containing the luminescent silver complex of the present invention is generally from 0.01% to 99.99% by weight, preferably from 0.1 to 99% by weight, more preferably from 1 to 90% by weight, still more preferably from 5 to 80% by weight, and particularly preferably from 10 to 50% by weight based on the total weight of the layer.

Examples of the luminescent device of the present invention include a single-layer luminescent device (anode/luminescent layer/cathode). This luminescent layer contains the thin-film of the present invention. Examples of the layer configuration of a multi-layer luminescent device include:
(a) anode/hole injection layer/(hole transport layer)/luminescent layer/cathode;
(b) anode/luminescent layer/electron injection layer/(electron transport layer)/cathode;
(c) anode/hole injection layer/(hole transport layer)/luminescent layer/electron injection layer/(electron transport layer)/cathode;
(d) anode/luminescent layer/(electron transport layer)/electron injection layer/cathode;
(e) anode/hole injection layer/(hole transport layer)/luminescent layer/(electron transport layer)/electron injection layer/cathode; and the like.

In the above (a) to (e), (hole transport layer) and (electron transport layer) mean that each of these layers is any layer which may be or may not be present at that position.

The anode provides holes to the hole injection layer, the hole transport layer, the luminescent layer, and the like, and preferably has a work function of 4.5 eV or more. As materials for the anode, for examples, a metal, an alloy, a metal oxide, an electrically conductive compound, and combinations thereof can be used. Specific examples include conductive metal oxides such as tin oxide, zinc oxide, indium oxide, and indium tin oxide (ITO); metals such as gold, silver, chromium, and nickel; mixtures and laminates including the conductive metal oxide and the metal; inorganic conductive substances such as copper iodide and copper sulfide; and organic conductive materials such as polyanilines, polythiophenes (for example, poly(3,4)ethylenedioxythiophene), polypyrroles, and combinations thereof with ITO.

The cathode provides electrons to the electron injection layer, electron transport layer, luminescent layer, and the like. As materials for the cathode, for example, a metal, an alloy, a metal halide, a metal oxide, an electrically conductive compound, or combinations thereof can be used. Specific examples include alkali metal (e.g., Li, Na, and K) and a fluoride and oxide thereof, alkali-earth metal (e.g., Mg, Ca, Ba, and Cs) and a fluoride and oxide thereof, gold, silver, lead, aluminum, alloys and mixed metals (e.g., sodium-potassium alloy, sodium-potassium mixed metal, lithium-aluminum alloy, lithium-aluminum mixed metal, magnesium-silver alloy, and magnesium-silver mixed metal), and rare-earth metals (e.g., indium, ytterbium).

The hole injection layer and the hole transport layer have a function to inject holes from the anode, a function to transport holes, or a function as a barrier to electrons injected from the cathode. Examples of the materials used for these layers include a carbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine derivative, a styrylamine derivative, an aromatic dimethylidyne derivative, a porphyrin derivative, a polysilane derivative, a poly(N-vinylcarbazole) derivative, an organic silane derivative, and polymers containing these residues. Also, examples of the materials include a conductive high-molecular oligomer such as an aniline-based copolymer, a thiophene oligomer, and polythiophene. The hole injection layer and the hole transport layer may have a single-layer structure including one or two or more kinds of these materials, or may have a multi-layer structure including a plurality of layers with the same composition or different compositions.

The electron injection layer and the electron transport layer have a function to inject electrons from the cathode, a function to transport electrons, or a function as a barrier to holes injected from the anode. Examples of the materials used for these layers include a triazole derivative, an oxazole derivative, an oxadiazole derivative, an imidazole derivative, a fluorenone derivative, an anthraquinodimethane derivative, an anthrone derivative, a diphenylquinone derivative, a thiopyrandioxide derivative, a carbodiimide derivative, a fluorenylidenemethane derivative, a distyrylpyrazine derivative, a tetracarboxylic acid anhydride of an aromatic ring such as naphthalene or perylene, a phthalocyanine derivative, a metal complex (for example, a metal complex of an 8-quinolinol derivative, a metal complex having metalphthalocyanine as a ligand, a metal complex having benzoxazole as a ligand, a metal complex having benzothiazole as a ligand), and an organic silane derivative. The electron injection layer and the electron transport layer may have a single-layer structure including one or two or more kinds of these materials, or may have a multi-layer structure including a plurality of layers with the same composition or different compositions.

As the material for the electron injection layer and the electron transport layer, an inorganic compound of an insulator or a semiconductor can be used. As long as the electron injection layer and the electron transport layer are constituted by an insulator or a semiconductor, current leakage can be prevented effectively, thereby improving electron injection properties. Examples of such an insulator include at least one kind of metal compound selected from the group consisting of alkali metal chalcogenide, alkali-earth metal chalcogenide, a halide of alkali metal, and a halide of alkali-earth metal. The insulator is preferably CaO, BaO, SrO, BeO, BaS, or CaSe. Also, examples of the semiconductor constituting the electron injection layer and the electron transport layer include an oxide, a nitride, and an oxynitride of at least one kind of device selected from the group consisting of Ba, Ca, Sr, Yb, Al, Ga, In, Li, Na, Cd, Mg, Si, Ta, Sb, and Zn.

In the present invention, a reducing dopant may be added in the interfacial region between the cathode and the thin-film contacting the cathode. Examples of preferable reducing dopant include alkali metal, alkali-earth metal, rare-earth metal, an oxide of alkali metal, a halide of alkali metal, an oxide of alkali-earth metal, a halide of alkali-earth metal, an oxide of rare-earth metal or a halide of rare-earth metal, an alkali metal complex, an alkali-earth metal complex, and a rare-earth metal complex.

The luminescent layer has a function to inject holes from the anode, the hole injection layer, or the hole transport layer, and inject electrons from the cathode, the electron injection layer, or the electron transport layer when an electric field is applied; a function to move injected charge (electron and hole) by the force of the electric field; and a function to provide a field for recombination of electron and hole, thereby resulting in luminescence. A host material may be contained in the luminescent layer when the luminescent silver complex of the present invention is contained in the luminescent layer as a guest material. Examples of the host material include one having a fluorene skeleton, one having a carbazole skeleton, one having a diarylamine skeleton, one having a pyridine skeleton, one having a pyrazine skeleton, one having a triazine skeleton, and one having an arylsilane skeleton. T1 of the host material is preferably greater than that of the guest material, and more preferably difference therebetween is greater than 0.2 eV. The host material may be a low-molecular compound or may be a high-molecular compound. The host material may further contain an electrolyte. Examples of the electrolyte include a solvent (e.g., propylene carbonate, acetonitrile, 2-methyltetrahydrofuran, 1,3-dioxofuran, nitrobenzene, N,N-dimethylformamide, dimethyl sulfoxide, glycerin, propylalcohol, and water) which may contain a supporting salt (e.g., lithium trifluoromethanesulfonate, lithium perchlorate, tetrabutylammonium perchlorate, potassium hexafluorophosphate, and tetra-n-butylammonium tetrafluoroborate), or a gelled high molecule (e.g., polyethyleneoxide, polyacrylonitrile, and copolymer of vinylidene fluoride tetrafluoropropylene) swelled by the solvent. Further, the luminescent layer having the luminescent material doped into the host material can be formed by, for example, mixing the host material and the luminescent silver complex to coat or codeposit the resultant mixture onto the layer.

With regard to the luminescent device of the present invention, examples of the method for forming each of the layers include a vacuum deposition method (e.g., resistance heating deposition method, and electron beam method), a sputtering method, an LB method, a molecular stacking method, and a coating method (e.g., casting method, spin coating method, bar coating method, blade coating method, roll coating method, Gravure printing, screen printing, and ink-jet method). Among them, the coating method is preferable due to simplified manufacturing process. In the coating method, the luminescent silver complex, the polymer having the residue of the luminescent silver complex, or the mixture of the luminescent silver complex and the high-molecular compound is mixed with the solvent to prepare a coating liquid, and then the coating liquid is coated and dried on the desired layer (or electrode) to form the layer. The coating liquid may contain a resin as a host material and/or a binder. This resin can be in a dissolved state or in a dispersed state in the solvent. As the resin, a non-conjugated high molecule such as polyvinyl carbazole, and a conjugated high molecule such as a polyolefin high molecule can be used. Specific examples of the resin include polyvinyl chloride, polycarbonate, polystyrene, polymethyl methacrylate, polybutyl methacrylate, polyester, polysulfone, polyphenyleneoxide, polybutadiene, poly(N-vinylcarbazole), hydrocarbon resin, ketone resin, phenoxy resin, polyamide, ethylcellulose, vinyl acetate, ABS resin, polyurethane, melamine resin, unsaturated polyester resin, alkyd resin, epoxy resin, and silicon resin. The solution of the resin may further contain an antioxidant, a viscosity modifier, and the like. The solvent for the solution preferably dissolves components of the thin-film uniformly or provides a stable dispersion. Examples of the solvent include alcohols (e.g., methanol, ethanol, and isopropyl alcohol), ketones (e.g., acetone, and methyl ethyl ketone), chlorinated hydrocarbons (e.g., chloroform, and 1,2-dichloroethane), aromatic hydrocarbons (e.g., benzene, toluene, and xylene), aliphatic hydrocarbons (e.g., n-hexane, and cyclohexane), amides (e.g., dimethylformamide), sulfoxides (e.g., dimethyl sulfoxide), and mixtures thereof, and the like.

For the ink-jet method, for example, a high boiling point solvent (e.g., anisole, and bicyclohexylbenzene) can be used to prevent evaporation from a nozzle. The viscosity of the solution is preferably from 1 to 100 mPa·s.

The thickness of each layer in the luminescent device of the present invention is preferably from 1 nm to 100 µm, and more preferably from several nm to 1 µm.

The luminescent device of the present invention can be used for an illuminating light source, a light source for signs, a light source for backlighting, a display device, a printer head, and the like. The display device adopts a known driving technique, a driving circuit, and the like, and can have a configuration such as a segment-type or a dot-matrix type.

### Examples

Next, the present invention will be described by providing examples, but the present invention is not to be limited to these examples.
Used were 300 MHz NMR spectrometer manufactured by Varian, Inc. for NMR measurement, and The AccuTOF TLC (JMS-T100TD) manufactured by JEOL Ltd. for DART-MS measurement.
In elemental analysis of the complex, the calculated values in Examples 1 to 14 were obtained considering a possibility of containing a water molecule or an organic solvent used for the complex synthesis.

### Example 1

Under argon atmosphere, silver(I) iodide (235 mg, 1.00 mmol) and 50 mL of the solution of 1,2-bis(diphenylphosphino)benzene (447 mg, 1.00 mmol) in acetonitrile were mixed and the mixture was heated to reflux with stirring for seven hours. The reaction solution was allowed to reach room temperature and the precipitated colorless crystal was filtrated. The obtained filtrated matter was washed with acetonitrile and dried to obtain 531 mg of the complex.
The mixture of this complex (49.7 mg) and triphenylphosphine (19.2 mg, 0.0730 mmol) was dissolved in 3 mL of dichloromethane, and the resulting solution was stirred for 30 minutes at room temperature. The reaction solution was concentrated, subjected to recrystallization by slow diffusion of chloroform-diethylether, and dried to provide 30.9 mg of the colorless solid complex.
The result of elemental analysis for the obtained complex is shown in Table 2-1, and the composition ratio of the complex was obtained. The present complex corresponds to the above composition formula (3).

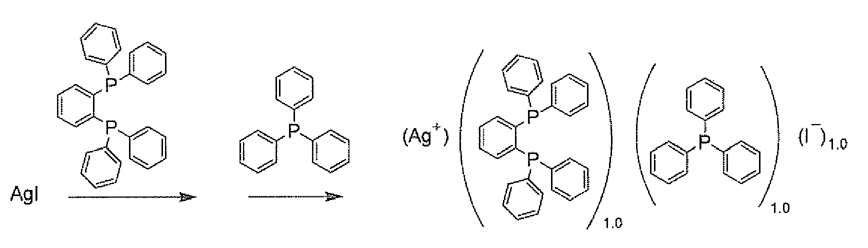

The NMR data of the obtained complex is provided below.

**¹H NMR (300 MHz, CDCl₃) δ 7.44-7.14 (m, 31H), 7.03 (t, *J*= 7.2 Hz, 8H); ¹³C NMR (75 MHz, CDCl₃) δ 141.2 (t, *J*= 22.7 Hz), 134.5 (t, *J*= 3.0 Hz), 134.2-134.0 (m), 133.3 (d, *J*= 22.2 Hz), 132.2 (t, *J*= 10.9 Hz), 129.6 (s), 129.3 (s), 128.5 (d, *J*= 9.0 Hz), 128.2 (t, *J*= 4.5 Hz); ³¹P NMR (122 MHz, CDCl₃) δ 3.7 (br, *W*_{1/2}=159 Hz), -14.8 (br, *W*_{1/2} = 450 Hz).**

The result of DART-MS measurement of the obtained complex is provided below.

**DART-MS (M/Z): found; 815.16. calcd; 815.13 (M-I)⁺.**

Based on the DART-MS measurement of the obtained complex, it was confirmed that the obtained complex contained the following structure.

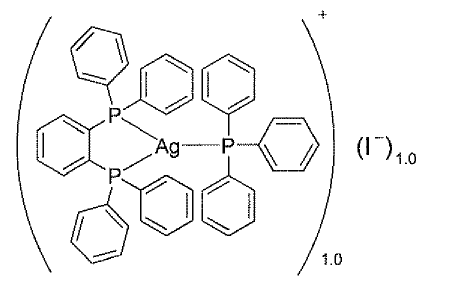

### Example 2

Under argon atmosphere, bis[2-(diphenylphosphino)phenyl]ether (125 mg, 0.231 mmol) was added to 10 mL of the suspension of silver(I) tetrafluoroborate (45.0 mg, 0.231 mmol) in dry dichloromethane, and the mixture was heated to reflux with stirring for one hour. Then, 2-dimethylamino-2'-(diphenylphosphino)biphenyl (88.2 mg, 0.231 mmol) was added to the reaction solution, which was heated to reflux for another one hour. The obtained colorless uniform solution was concentrated. The obtained residue was dissolved in chloroform, and hexane was added thereto followed by reprecipitation, filtration, and vacuum drying of the filtrated matter, thereby providing 206 mg of the colorless solid complex.
The result of elemental analysis for the obtained complex is shown in Table 2-1, and the composition ratio of the complex was obtained. The present complex corresponds to the above composition formula (4).

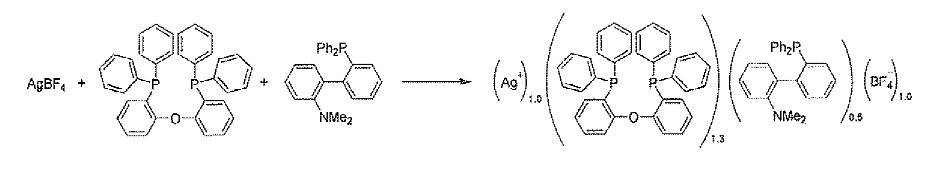

### Example 3

Under argon atmosphere, 1,8-bis(diphenylphosphino)naphthalenedioxide (64.5 mg) was added to 5 mL of the suspension of silver(I) tetrafluoroborate (25.3 mg, 0.130 mmol) in dry dichloromethane, and the mixture was heated to reflux with stirring for one hour. Then, 2-dimethylamino-2'-(diphenylphosphino)biphenyl (49.6 mg, 0.130 mmol) was added to the reaction solution, which was heated to reflux for another one hour. The obtained brown suspension was filtrated, and the filtrate was concentrated and the residue was dissolved in chloroform followed by slow diffusion of diethylether. The precipitate was isolated by filtration, and the filtrated matter was subjected to vacuum drying, thereby providing 101 mg of the pale yellow solid complex.
The result of elemental analysis for the obtained complex is shown in Table 2-1, and the composition ratio of the complex was obtained. The present complex corresponds to the above composition formula (1).

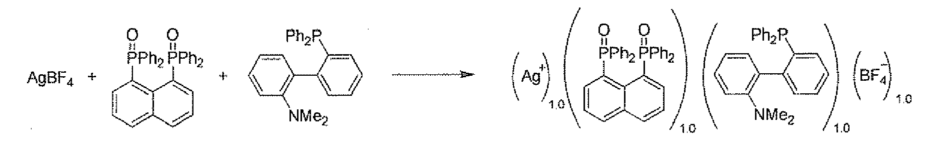

### Example 4

Under argon atmosphere, 1,8-bis(diphenylphosphino)naphthalenedioxide (102 mg) was added to 8 mL of the suspension of silver(I) tetrafluoroborate (39.8 mg, 0.204 mmol) in dry dichloromethane, and the mixture was heated to reflux with stirring for one hour. Then, 2-diphenylphosphino benzoic acid (62.6 mg, 0.204 mmol) was added to the reaction solution, which was heated to reflux for another one hour. The obtained solution was concentrated, and the residue was dissolved in methanol followed by slow evaporation after addition of ethyl acetate. The black precipitate was isolated by filtration, and the filtrate was concentrated followed by vacuum drying, thereby providing 192 mg of the colorless solid complex.
The result of elemental analysis for the obtained complex is shown in Table 2-1, and the composition ratio of the complex was obtained. The present complex corresponds to the above composition formula (1).

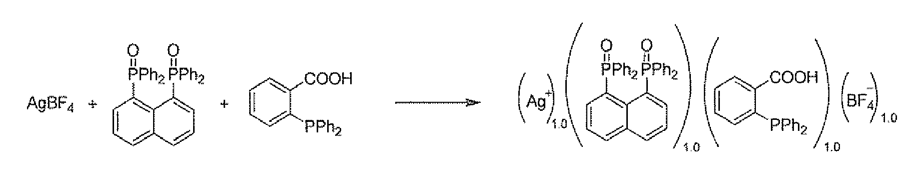

### Example 5

Under argon atmosphere, 2-dimethylamino-2'-(diphenylphosphino)biphenyl (34.3 mg, 0.0899 mmol) was added to 5 mL of the suspension of silver(I) tetrafluoroborate (17.5 mg, 0.0899 mmol) in dry dichloromethane, and the mixture was heated to reflux with stirring for one hour. Then, 2,9-di-n-butyl-1,10-phenanthroline (26.3 mg, 0.0899 mmol) was added to the obtained solution, which was heated to reflux for additional one and half hours. The reaction solution was filtrated, and the filtrate was concentrated and then the residue was dissolved in chloroform followed by slow diffusion of diethylether. The pale yellow precipitate was filtrated, and the filtrated matter was subjected to vacuum drying, thereby providing 45.0 mg of the pale yellow solid complex.
The result of elemental analysis for the obtained complex is shown in Table 2-1, and the composition ratio of the complex was obtained. The present complex corresponds to the above composition formula (1).

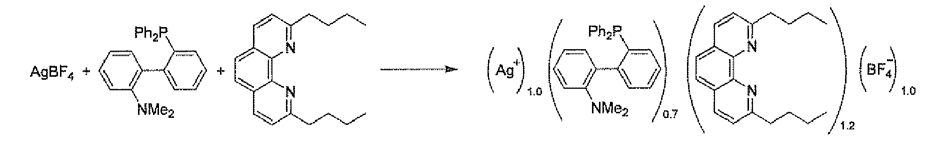

### Example 6

Under argon atmosphere, bis[2-(diphenylphosphino)phenyl]ether (67.9 mg, 0.126 mmol) was added to 5 mL of the suspension of silver(I) tetrafluoroborate (24.5 mg, 0.126 mmol) in dry dichloromethane, and the mixture was heated to reflux with stirring for one hour. Then, 2-diphenylphosphino benzoic acid (38.6 mg, 0.126 mmol) was added to the reaction solution, which was heated to reflux for another one hour. The obtained solution was concentrated, the residue was dissolved in 1.5 mL of chloroform followed by thermal recrystallization, and the precipitated needle crystal was isolated by filtration. The obtained filtrated matter was subjected to vacuum drying, thereby providing 98.0 mg of the colorless solid complex.
The result of elemental analysis for the obtained complex is shown in Table 2-1, and the composition ratio of the complex was obtained. The present complex corresponds to the above composition formula (4).

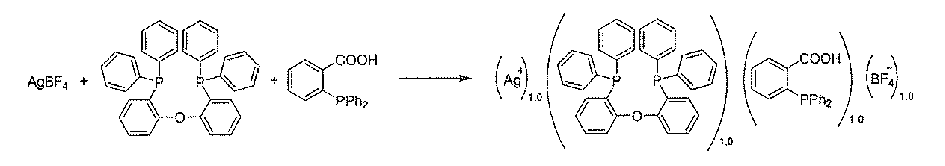

**[Table 2-1]**

| Comp. No. | Molecular Formula | calcd (found) / % | | | |
|---|---|---|---|---|---|
| | | C | H | N | B |
| Example 1 | C₄₈H₃₉IAgP₃·0.75CHCl₃ | 56.68 (56.35) | 3.88 (3.86) | 0 (< 0.3) | - |
| Example 2 | C₂₃₂H₁₈₈N₂Ag₄B₄F₁₆O₅P₁₂·11H₂O | 62.86 (62.73) | 4.78 (4.68) | 0.63 (0.56) | 0.98 (0.99) |
| Example 3 | C₆₀H₅₀NagBF₄OP₃·2.3H₂O | 62.85 (62.66) | 4.81 (4.65) | 1.22 (1.30) | 0.94 (1.10) |
| Example 4 | C₅₃H₄₁AgBF₄O₄P₃·0.2H₂O | 61.62 (62.04) | 4.04 (4.53) | 0 (< 0.3) | 1.05 (1.00) |
| Example 5 | C₉₃₀H₁₀₀₈N₆₉Ag₂₂B₂₂F₈₈P₁₅ | 62.40 (62.48) | 5.68 (5.69) | 5.40 (5.22) | 1.33 (1.59) |
| Example 6 | C₅₅H₄₃AgBF₄O₃P₃·1.2CHCl₃ | 57.43 (57.44) | 3.79 (3.81) | 0 (< 0.3) | 0.92 (0.89) |

| | | | | | |
|---|---|---|---|---|---|
| (In Table, "-" means no measurement performed.) | | | | | |

### Example 7

Under argon atmosphere, 1,2-bis(diphenylphosphino)benzene (106 mg, 0.237 mmol) was added to 7 mL of the suspension of silver(I) tetrafluoroborate (46.1 mg, 0.257 mmol) in dry dichloromethane, and the mixture was heated to reflux with stirring for one hour. The reaction solution was allowed to reach room temperature followed by addition of 2,2'-bipyridyl (37.0 mg, 0.237 mmol), and heated to reflux for another one hour. The reaction solution was filtrated, and the filtrate was concentrated, subjected to recrystallization by slow diffusion of chloroform-ether, and dried to provide 188 mg of the pale yellow solid complex.
The result of elemental analysis for the obtained complex is shown in Table 2-2, and the composition ratio of the complex was obtained. The present complex corresponds to the above composition formula (5).

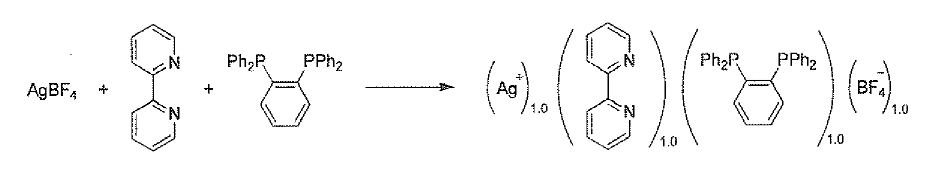

The NMR data of the obtained complex is provided below.
¹H NMR (300 MHz, CDCl₃) δ 8.50 (d, J = 4.5 Hz, 2H), 8.37 (d, J = 8.1 Hz, 2H), 8.08 (t, J = 7.9 Hz, 2H), 7.59-7.53 (m, 6H), 7.46-7.29 (m, 8H), 7.22-7.16 (m, 6H), 7.13-7.09 (m, 6H) ; ¹³C NMR (75 MHz, CDCl₃) δ 152.2, 151.0, 140.0, 133.7-133.4 (m), 131.4, 130.9, 129.4-129.3 (m), 126.3, 123.4; ³¹P NMR (122 MHz, CDCl₃) δ 1.3 (d, J (³¹P-Ag¹⁰⁷, ³¹P-Ag¹⁰⁹) = 231, 266 Hz).

### Example 8

Under argon atmosphere, 2,2'-bis(diphenylphosphino)biphenyl (89.9 mg, 0.172 mmol) was added to 7 mL of the suspension of silver(I) tetrafluoroborate (33.5 mg, 0.172 mmol) in dry dichloromethane, and the mixture was heated to reflux with stirring for one hour. The reaction solution was allowed to reach room temperature followed by addition of 2,2'-bipyridyl (26.9 mg, 0.172 mmol), and heated to reflux for another one hour. The reaction solution was filtrated, and the filtrate was concentrated, subjected to recrystallization by slow diffusion of chloroform-ether, and dried to provide 144 mg of the pale yellow solid complex.
The result of elemental analysis for the obtained complex is shown in Table 2-2, and the composition ratio of the complex was obtained. The present complex corresponds to the above composition formula (5).

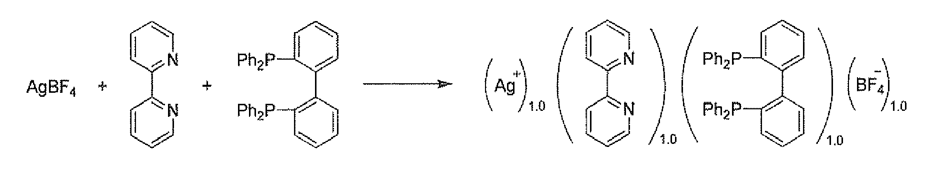

### Example 9

Under argon atmosphere, 1,2-bis(diphenylphosphino)benzene (91.7 mg, 0.205 mmol) was added to 5 mL of the suspension of silver(I) tetrafluoroborate (40.0 mg, 0.205 mmol) in dry dichloromethane, and the mixture was stirred at room temperature for one hour. Then, 2,2'-biquinoline (52.7 mg, 0.205 mmol) was added to the reaction solution, which was stirred at room temperature for another one hour. The pale yellow reaction solution was filtrated, and the filtrate was concentrated, subjected to recrystallization by slow diffusion of chloroform-ether, and dried to provide 171 mg of the pale yellow solid complex.
The result of elemental analysis for the obtained complex is shown in Table 2-2, and the composition ratio of the complex was obtained. The present complex corresponds to the above composition formula (5).

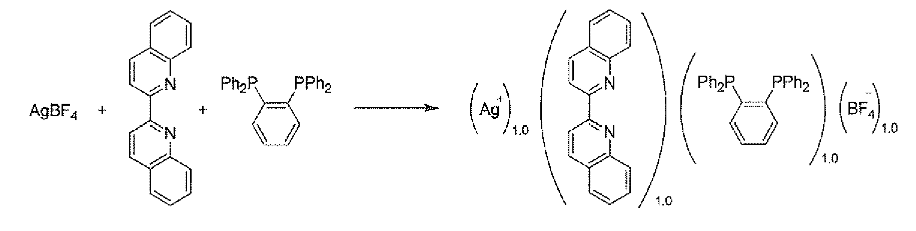

### Example 10

Under argon atmosphere, 2,2'-bis(diphenylphosphino)biphenyl (69.8 mg, 0.133 mmol) was added to 5 mL of the suspension of silver(I) tetrafluoroborate (26.0 mg, 0.133 mmol) in dry dichloromethane, and the mixture was stirred at room temperature for one hour. Then, 2,2'-biquinoline (34.2 mg, 0.133 mmol) was added to the reaction solution, which was stirred at room temperature for another one hour. The pale yellow reaction solution was filtrated, and the filtrate was concentrated, subjected to recrystallization by slow diffusion of chloroform-ether, and dried to provide 92.5 mg of the pale yellow solid complex.
The result of elemental analysis for the obtained complex is shown in Table 2-2, and the composition ratio of the complex was obtained. The present complex corresponds to the above composition formula (5).

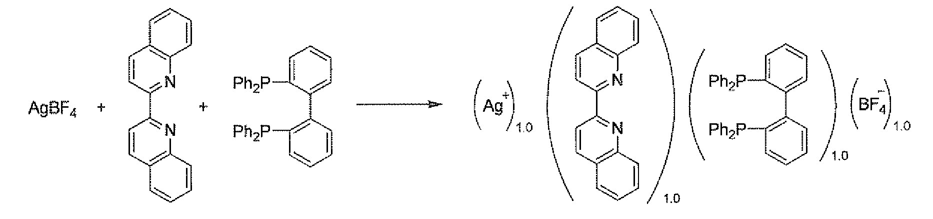

### Example 11

According to the method described in Bill. Chem. Soc. Jpn. 65, 2007-2009 (1992), 2,9-dichloro-1,10-phenanthroline (f22) was synthesized.
Under argon atmosphere, 4,5-bis(diphenylphosphino)-9,9-dimethylxanthene (81.7 mg, 0.141 mmol) was added to 8 mL of the solution of silver(I) tetrafluoroborate (27.5 mg, 0.141 mmol) in dichloromethane, and the mixture was stirred at room temperature for 15 minutes. Then, f22 (44.0 mg, 0.177 mmol) was added to the reaction solution, which was heated to reflux for one hour. The reaction solution was filtrated, and the filtrate was concentrated, subjected to recrystallization by slow diffusion of chloroform-ether, and dried to provide 135 mg of the pale yellow solid complex.
The result of elemental analysis for the obtained complex is shown in Table 2-2, and the composition ratio of the complex was obtained. The present complex corresponds to the above composition formula (5).

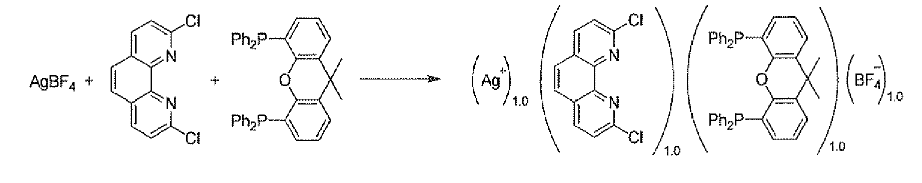

The NMR data of the obtained complex is provided below.
¹H NMR (300 MHz, CDCl₃) δ 8.64 (d, J = 8.5 Hz, 2H), 8.16 (s, 2H), 7.72 (d, J = 8.5 Hz, 2H), 7.64 (d, J = 7.8 Hz, 2H), 7.26-7.07 (m, 22H), 6.72-6.69 (m, 2H), 1.72 (s, 6H); ³¹P NMR (122 MHz, CDCl₃) δ -4.90 (d, J (³¹P-¹⁰⁷Ag, ¹⁰⁹Ag) = 390, 450 Hz).

### Example 12

Under argon atmosphere, 2,2'-bis(diphenylphosphino)-1,1'-biphenyl (99.3 mg, 0.190 mmol) was added to 8 mL of the solution of silver(I) tetrafluoroborate (37.0 mg, 0.190 mmol) in dichloromethane, and the mixture was stirred at room temperature for 15 minutes. Then, 2,9-dichloro-1,10-phenanthroline (59.2 mg, 0.238 mmol) was added to the reaction solution, which was heated to reflux with stirring for one hour. The reaction solution was filtrated, and the filtrate was concentrated, subjected to recrystallization by slow diffusion of chloroform-ether, and dried to provide 176 mg of the pale yellow solid complex.
The result of elemental analysis for the obtained complex is shown in Table 2-2, and the composition ratio of the complex was obtained. The present complex corresponds to the above composition formula (5).

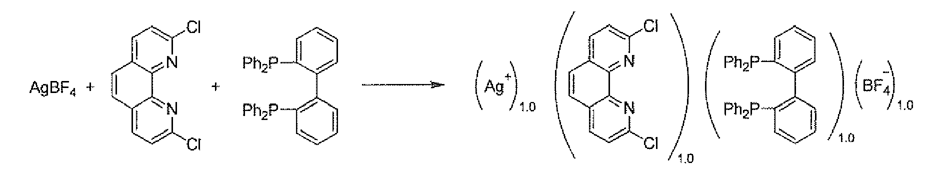

The NMR data of the obtained complex is provided below.
¹H NMR (300 MHz, CDCl₃) δ 8.86 (d, J = 8.4 Hz, 2H), 8.29 (s, 2H), 8.04 (d, J = 8.4 Hz, 2H), 7.53-7.47 (m, 4H), 7.42-7.04 (m, 20H), 6.89 (t, J = 7.4 Hz, 2H), 6.65 (d, J = 7.4 Hz, 2H); ³¹P NMR (122 MHz, CDCl₃) δ 10.3 (d, J (³¹P-¹⁰⁷Ag, ¹⁰⁹Ag) = 354, 409 Hz).

### Example 13

Under argon atmosphere, 20 mL of dry acetonitrile was added to silver(I) bromide (170 mg , 0.904 mmol) and 1,2-bis(diphenylphosphino)benzene (404 mg, 0.904 mmol), and the mixture was stirred at room temperature for one hour and then heated to reflux for seven hours. The reaction solution was allowed to reach room temperature, concentrated, and filtrated after being suspended in 9 mL of chloroform. The filtrated matter was subjected to thermal recrystallization from acetonitrile-chloroform and dried to obtain 399 mg of the colorless crystal complex.
Under argon atmosphere, 3 mL of dry dichloromethane was added to the above obtained complex (80.0 mg, 0.0631 mmol) and triphenylphosphine (33.1 mg, 0.126 mmol), and the mixture was stirred at 40°C for 10 minutes. The reaction solution was concentrated, subjected to recrystallization by slow diffusion of chloroform-ether, and dried to provide 108 mg of the complex.
The result of elemental analysis for the obtained complex is shown in Table 2-2, and the composition ratio of the complex was obtained. The present complex corresponds to the above composition formula (3).

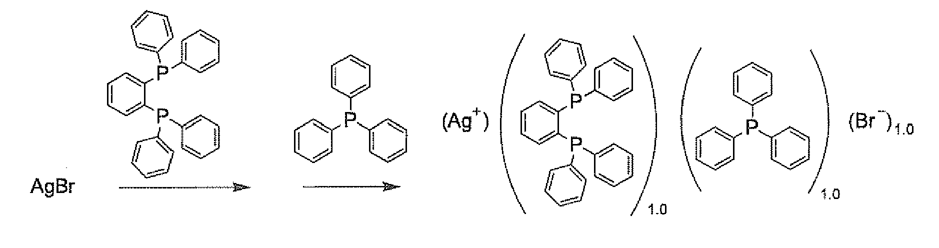

The NMR data of the obtained complex is provided below.
¹H NMR (300 MHz, CDCl₃) δ 7.48-7.17 (m, 31H), 7.07-7.03 (m, 8H); ¹³C NMR (75 MHz, CDCl₃) δ 134.8 (t, J = 2.4 Hz), 134.6-134.2 (m), 130.2-130.0 (m), 129.7 (br), 129.0 (br), 128.9 (br), 128.7-128.6 (m); ³¹P NMR (122 MHz, CDCl₃) δ 8.1 (br, W_{1/2} = 87 Hz) , -14.8 (br, W_{1/2} = 340 Hz).
The result of DART-MS measurement for the obtained complex is provided below.
DART-MS (M/Z): found; 815.16. calcd; 815.13 (M-Br)⁺.
Based on the DART-MS measurement of the obtained complex, it was confirmed that the obtained complex contained the following structure.

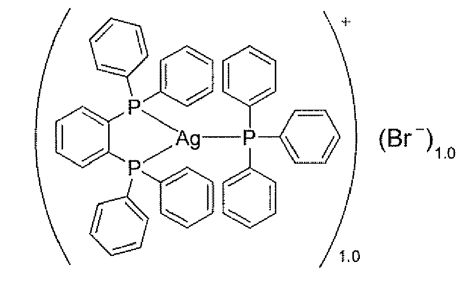

### Example 14

Under argon atmosphere, 25 mL of dry acetonitrile was added to silver(I) chloride (150 mg, 1.04 mmol) and 1,2-bis(diphenylphosphino)benzene (467 mg, 1.04 mmol), and the mixture was stirred at room temperature for one hour, followed by reflux for five hours. The reaction solution was allowed to reach room temperature, concentrated, and filtrated after being suspended in 7 mL of chloroform. The filtrated matter was subjected to thermal recrystallization from acetonitrile-chloroform and dried to obtain 258 mg of the colorless crystal complex.
Under argon atmosphere, 3 mL of dry dichloromethane was added to the above obtained complex (80.0 mg, 0.0678 mmol) and triphenylphosphine (35.6 mg, 0.136 mmol), and the mixture was stirred at 40°C for 10 minutes. The reaction solution was concentrated, subjected to recrystallization by slow diffusion of chloroform-ether, and dried to provide 107 mg of the colorless crystal complex.
The result of elemental analysis for the obtained complex is shown in Table 2-2, and the composition ratio of the complex was obtained. The present complex corresponds to the above composition formula (3).

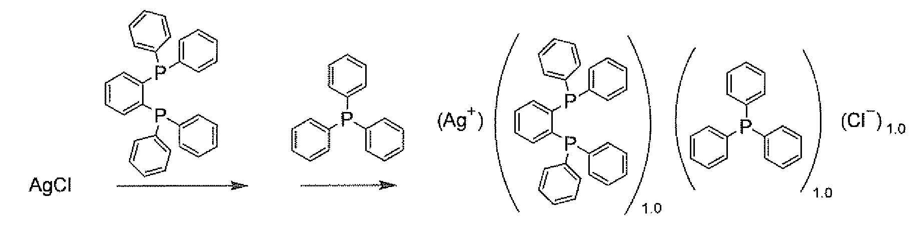

The NMR data of the obtained complex is provided below.
¹H NMR (300 MHz, CDCl₃) δ 7.48-7.17 (m, 31H), 7.06 (t, J = 7.0 Hz, 8H); ¹³C NMR (75 MHz, CDCl₃) δ 134.9-134.8 (m), 134.5 (br), 134.4-134.1 (m), 130.1 (br), 129.7 (br), 129.8-129.7 (m), 129.0 (br), 128.9 (br), 128.8-128.7 (m); ³¹P NMR (122 MHz, CDCl₃) δ 9.1 (br, W_{1/2} = 66 Hz), -14.8 (br, W_{1/2} = 390 Hz).
The result of DART-MS measurement for the obtained complex is provided below.
DART-MS (M/Z): found; 815.16. calcd; 815.13 (M-C1)⁺.
Based on the DART-MS measurement of the obtained complex, it was confirmed that the obtained complex contained the following structure.

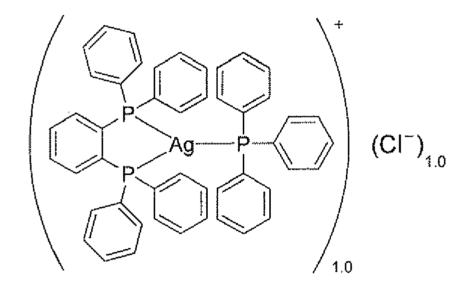

**[Table 2-2]**

| Comp. No. | Molecular Formula | calcd (found) / % | | | | |
|---|---|---|---|---|---|---|
| | | C | H | N | B | Halogen |
| Example 7 | C₄₀H₃₂N₂AgBF₄P₂·2H₂O | 57.65 (57.48) | 4.35 (3.95) | 3.36 (3.37) | - | - |
| Example 8 | C₄₆H₃₆N₂AgBF₄P₂·2H₂O | 60.75 (60.79) | 4.43 (4.11) | 3.08 (2.58) | - | - |
| Example 9 | C₄₈H₃₆N₂AgBF₄P₂·1.3H₂O | 62.57 (62.29) | 4.23 (3.95) | 3.04 (2.96) | 1.17 (1.27) | - |
| Example 10 | C₅₄H₄₀N₂AgBF₄P₂·CHCl₃ | 60.44 (60.93) | 3.78 (3.83) | 2.56 (2.52) | 0.99 (0.98) | - |
| Example 11 | C₅₁H₃₉Cl₂AgBF₄N₂OP₂· 0.8H₂O·0.2CH₂Cl₂ | 58.36 (58.10) | 3.83 (3.64) | 2.68 (2.70) | 1.03 (0.98) | Cl:8.07 (8.47) |
| Example 12 | C₄₈H₃₅AgBCl₂F₄N₂P₂· 0.5H₂O·0.5CHCl₃ | 56.23 (55.90) | 3.55 (3.33) | 2.70 (2.67) | 1.04 (1.03) | Cl:11.98 (12.05) |
| Example 13 | C₄₈H₃₉AgClP₃·0.6H₂O | 60.29 (61.04) | 4.12 (4.19) | 0 (<0.3) | - | Br:8.25 (8.04) |
| Example 14 | C₄₈H₃₉AgClP₃·0.3CHCl₃ | 65.05 (64.64) | 4.55 (4.47) | 0 (<0.3) | - | Cl:6.96 (6.79) |

| | | | | | | |
|---|---|---|---|---|---|---|
| (In Table, "-" means no measurement performed.) | | | | | | |

### Example 15

Under argon atmosphere, 4,5-bis(diphenylphosphino)-9,9-dimethylxanthene (119 mg, 0.205 mmol) was added to 8 mL of the solution of silver(I) tetrafluoroborate (40.0 mg, 0.205 mmol) in dichloromethane, and the mixture was stirred at room temperature for 15 minutes. Then, 6,6'-dibromo-2,2'-bipyridyl (38.5 mg, 0.247 mmol) was added to the reaction solution, which was heated to reflux with stirring for one hour. The reaction solution was filtrated, and the filtrate was concentrated, subjected to recrystallization by slow diffusion of chloroform-ether, and dried to provide 120 mg of the pale yellow solid complex.

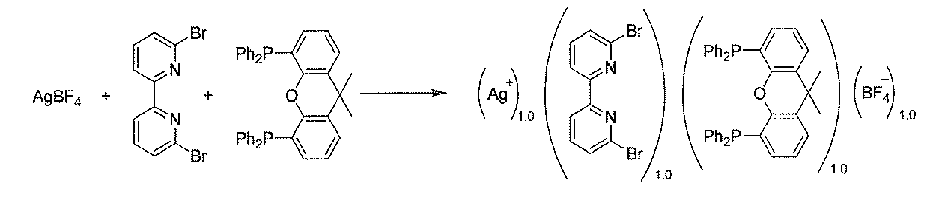

The NMR data of the obtained complex is provided below.
¹H NMR (300 MHz, CDCl₃) 5 8.55 (d, J = 7.9 Hz, 2H), 7.98 (t, J = 7.9 Hz, 2H), 7.60 (d, J = 7.9 Hz, 2H), 7.50 (d, J = 7.7 Hz, 2H), 7.35-7.31 (m, 4H), 7.26-7.14 (m, 18H), 6.75-6.72 (m, 2H) , 1.68 (s, 6H) ; ³¹P NMR (122 MHz, CDCl₃) δ -5.24 (d, J (³¹P-¹⁰⁷Ag, ¹⁰⁹Ag) = 403, 465 Hz).
The composition of the obtained complex was determined as follows. From the ¹H NMR data, unreacted ligands were not observed at all and the ratio of 4,5-bis(diphenylphosphino)-9,9-dimethylxanthene to 6,6'-dibromo-2,2'-bipyridyl was 1:1. From the ³¹P NMR data, it was found that the chemical shift and the coupling constant of phosphine had the values similar to the complex obtained in Example 11, thereby forming the similar complex. The number of Ag⁺ and the number of BF₄⁻ are the same in the complex. From the above, the composition of the present complex was obtained. The present complex corresponds to the above composition formula (5).

### Example 16

Under argon atmosphere, 4,5-bis(diphenylphosphino)-9,9-dimethylxanthene (72.1 mg, 0.125 mmol) was added to 7 mL of the solution of silver(I) hexafluorophosphate (31.5 mg, 0.125 mmol) in dichloromethane, and the mixture was stirred at room temperature for 15 minutes. Then, 2,9-dichloro-1,10-phenanthroline (37.2 mg, 0.149 mmol) was added to the reaction solution, which was heated to reflux with stirring for one hour. The reaction solution was filtrated, and the filtrate was concentrated, subjected to recrystallization by slow diffusion of chloroform-ether, and dried to provide 102 mg of the pale yellow solid complex.

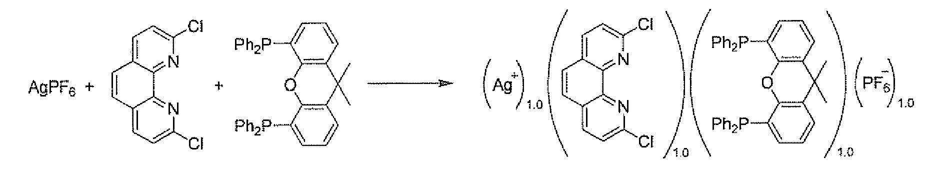

The NMR data of the obtained complex is provided below.
¹H NMR (300 MHz, CDCl₃) δ 8.57 (d, J = 8.5 Hz, 2H), 8.10 (s, 2H), 7.71 (d, J = 8.5 Hz, 2H), 7.64 (d, J = 7.8 Hz, 2H), 7.27-7.25 (m, 4H), 7.15 (t, J = 7.8 Hz, 2H), 7.09-7.07 (m, 16H), 6.74-6.70 (m, 2H), 1.72 (s, 6H); ³¹P NMR (122 MHz, CDCl₃) δ 4.9 (d, J (³¹P-¹⁰⁷Ag, ¹⁰⁹Ag) = 391, 451 Hz).
The composition of the obtained complex was determined according to the same method as in Example 15. The present complex corresponds to the above composition formula (5).

### Example 17

Under argon atmosphere, 4,5-bis(diphenylphosphino)-9,9-dimethylxanthene (95.7 mg, 0.165 mmol) was added to 7 mL of the solution of silver(I) trifluoromethanesulfonate (42.5 mg, 0.165 mmol) in dichloromethane, and the mixture was stirred at room temperature for 15 minutes. Then, 2,9-dichloro-1,10-phenanthroline (49.4 mg, 0.198 mmol) was added to the reaction solution, which was heated to reflux with stirring for one hour. The reaction solution was filtrated, and the filtrate was concentrated, subjected to recrystallization by slow diffusion of chloroform-ether, and dried to provide 157 mg of the pale yellow solid complex.

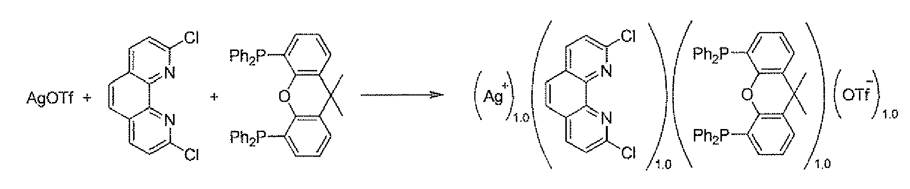

The NMR data of the obtained complex is provided below.
¹H NMR (300 MHz, CDCl₃) δ 8.61 (d, J = 8.5 Hz, 2H), 8.16 (s, 2H), 7.73 (d, J = 8.5 Hz, 2H), 7.64 (d, J = 7.8 Hz, 2H), 7.26-7.23 (m, 4H), 7.15 (t, J = 7.8 Hz, 2H), 7.09-7.06 (m, 16H), 6.74-6.69 (m, 2H), 1.72 (s, 6H); ³¹P NMR (122 MHz, CDCl₃) δ 4.9 (d, J (³¹P-¹⁰⁷Ag, ¹⁰⁹Ag) = 391, 452 Hz).
The composition of the obtained complex was determined according to the same method as in Example 15. The present complex corresponds to the above composition formula (5).

### Example 18

According to the method described in Inorg. Chem. 43, 8282-8289 (2004), 2,9-bis(trifluoromethyl)-1,10-phenanthroline (f25) was synthesized.
Under argon atmosphere, 4,5-bis(diphenylphosphino)-9,9-dimethylxanthene (83.2 mg, 0.144 mmol) was added to 8 mL of the solution of silver(I) tetrafluoroborate (30.3 mg, 0.156 mmol) in dichloromethane, and the mixture was stirred at room temperature for 15 minutes. Then, f25 (45.5 mg, 0.144 mmol) was added to the reaction solution, which was heated to reflux with stirring for one hour. The reaction solution was filtrated, and the filtrate was concentrated, subjected to recrystallization by slow diffusion of chloroform-ether, and dried to provide 134 mg of the pale yellow solid complex.

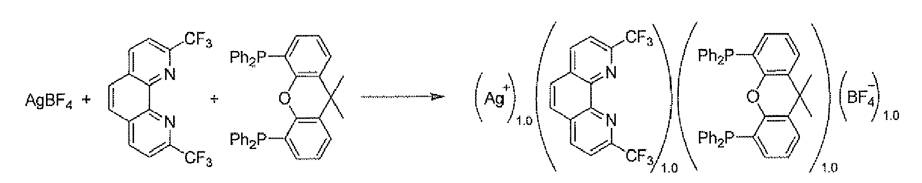

The NMR data of the obtained complex is provided below.
¹H NMR (300 MHz, CDCl₃) δ 8.91 (d, J = 8.0 Hz, 2H), 8.25 (s, 2H), 8.15 (d, J = 8.0 Hz, 2H), 7.63 (d, J = 7.7 Hz, 2H), 7.29-7.00 (m, 22H), 6.86-6.83 (m, 2H), 1.72 (s, 6H); ³¹P NMR (122 MHz, CDCl₃) δ -5.2 (d, J (³¹P-¹⁰⁷Ag, ¹⁰⁹Ag) = 404, 468 Hz).
The composition of the obtained complex was determined according to the same method as in Example 15. The present complex corresponds to the above composition formula (5).

### Example 19

According to the method described in Org. Lett. 7, 1979-1982 (2005), 4,5-diaza-2',7'-dibromo-9,9'-spirofluorene (f2') was synthesized.
Under argon atmosphere, 4,5-bis(diphenylphosphino)-9,9-dimethylxanthene (92.1 mg, 0.159 mmol) was added to 8 mL of the solution of silver(I) tetrafluoroborate (31.0 mg, 0.159 mmol) in dichloromethane, and the mixture was stirred at room temperature for 15 minutes. Then, f2' (91.0 mg, 0.191 mmol) was added to the reaction solution, which was heated to reflux with stirring for 1.5 hours. The reaction solution was filtrated, and the filtrate was concentrated, subjected to recrystallization by slow diffusion of chloroform-ether, and dried to provide 199 mg of the colorless crystal complex.

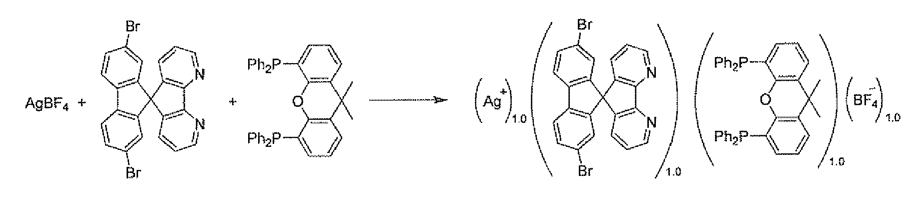

The NMR data of the obtained complex is provided below.
¹H NMR (300 MHz, CDCl₃) δ 8.60 (d, J = 5.0 Hz, 2H), 7.76 (d, J = 8.1 Hz, 2H), 7.68 (d, J = 7.7 Hz, 2H), 7.59 (d, J = 8.1 Hz, 2H), 7.55-7.50 (m, 2H), 7.39 (t, J = 7.1 Hz, 4H), 7.32-7.16 (m, 20H) 6.72-6.68 (m, 2H), 1.73 (s, 6H); ³¹P NMR (122 MHz, CDCl₃) δ -6.3 (d, J (³¹P-¹⁰⁷Ag, ¹⁰⁹Ag) = 396, 458 Hz).
The composition of the obtained complex was determined according to the same method as in Example 15. The present complex corresponds to the above composition formula (5).
The dibromo sites derived from the obtained complex f2' can be reactive sites to be polymerized to synthesize a polymer. The present complex can be used as a monomer to carry out the polymerization reaction, thereby providing the polymer having the luminescent silver complex. In addition, when f2' is polymerized in advance before the complexation reaction and then subjected to complexation, the polymer having the luminescent silver complex as a residue is provided.

### Example 20

Under argon atmosphere, 1,2-bis(diphenylphosphino)benzene (34.6 mg, 0.0776 mmol) was added to 5 mL of the solution of silver(I) tetrafluoroborate (15.1 mg, 0.0776 mmol) in dichloromethane, and the mixture was stirred at room temperature for 30 minutes. Then, 2,9-dichloro-1,10-phenanthroline (23.2 mg, 0.0931 mmol) was added to the reaction solution, which was heated to reflux with stirring for two hours. The reaction solution was filtrated, and the filtrate was concentrated, subjected to recrystallization by slow diffusion of dichloromethane-ether, and dried to provide 46.0 mg of the yellow solid complex.

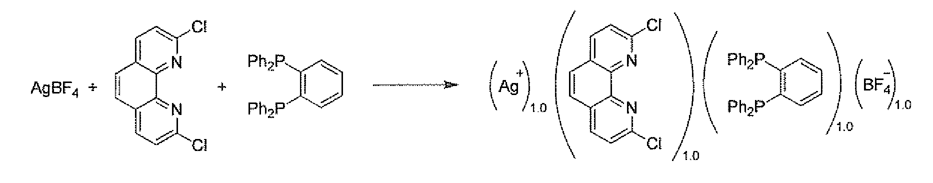

The NMR data of the obtained complex is provided below.
¹H NMR (300 MHz, CDCl₃) δ 8.80 (d, J = 8.1 Hz, 2H), 8.24 (s, 2H), 8.15 (d, J = 8.1 Hz, 2H), 7.62-7.51 (m, 4H), 7.39-7.29 (m, 20H); ³¹P NMR (122 MHz, CDCl₃) δ -4.4 (d, J (3¹P-¹⁰⁷Ag, ¹⁰⁹Ag) = 325, 373 Hz).
The composition of the obtained complex was determined according to the same method as in Example 15. The present complex corresponds to the above composition formula (5).

### Example 21

Under argon atmosphere, bis[2-(diphenylphosphino)phenyl]ether (29.6 mg, 0.0550 mmol) was added to 4 mL of the solution of silver(I) tetrafluoroborate (10.7 mg, 0.0550 mmol) in dichloromethane, and the mixture was stirred at room temperature for 30 minutes. Then, 2,9-dichloro-1,10-phenanthroline (16.4 mg, 0.0660 mmol) was added to reaction solution, which was heated to reflux with stirring for two hours. The reaction solution was filtrated, and the filtrate was concentrated, subjected to recrystallization by slow diffusion of dichloromethane-ether, and dried to provide 35.2 mg of the pale yellow solid complex.

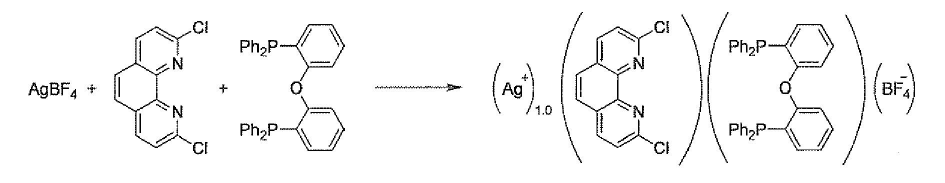

The NMR data of the obtained complex is provided below.
¹H NMR (300 MHz, CDCl₃) δ 8.63 (d, J = 8.4 Hz, 2H), 8.25 (s, 2H), 8.14 (d, J = 8.0 Hz, 2H), 7.73 (d, J = 8.4 Hz, 2H), 7.30-7.14 (m, 22H), 7.06 (t, J = 7.5 Hz, 2H), 6.98-6.93 (m, 2H), 6.80-6.78 (m, 2H); ³¹P NMR (122 MHz, CDCl₃) δ-5.6 (d, J (³¹P-¹⁰⁷Ag, ¹⁰⁹Ag) = 386, 447 Hz).
The composition of the obtained complex was determined according to the same method as in Example 15. The present complex corresponds to the above composition formula (5).

### Example 22

According to the method described below, 2,9-dibromo-1,10-phenanthroline (f23) was synthesized.
Under argon atmosphere, 2.0 mL of phosphorus tribromide was added to 2,9-dichloro-1,10-phenanthroline (70.0 mg, 0.281 mmol), and the mixture was stirred at 165°C for seven hours. The reaction solution was cooled with ice, and the aqueous solution of sodium hydrogen carbonate was added thereto little by little until the reaction solution became weakly basic. The resulting mixture was filtrated and the filtrated matter was washed lightly with methanol. The filtrated matter was extracted with chloroformpotassium carbonate aqueous solution, and the organic phase was dried over anhydrous sodium sulfate, filtrated, and concentrated to provide 76.6 mg (81.1% yield) of the colorless solid (f23).

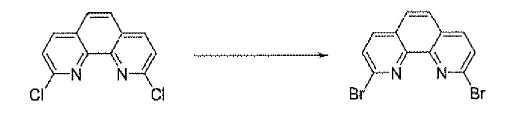

The NMR data and the DART-MS data of f23 are provided below.
¹H NMR (300 MHz, CDCl₃) δ 8.09 (d, J = 8.4 Hz, 2H), 7.83 (s, 2H), 7.79 (d, J = 8.4 Hz, 2H); DART-MS (M/Z): found; 336.89. calcd; 336.90 (M+H)⁺.
To 1 mL of the solution of silver(I) tetrafluoroborate (1.17 mg, 0.00601 mmol) in dichloromethane was added 4,5-bis(diphenylphosphino)-9,9-dimethylxanthene (3.48 mg, 0.00601 mmol), and the mixture was stirred at room temperature for 15 minutes. Then, f23 (2.03 mg, 0.00601 mmol) was added to the reaction solution, which was stirred at 40°C for five minutes. The reaction solution was subjected to recrystallization by slow diffusion of dichloromethane-ether and dried to provide 5.40 mg of the complex of the pale yellow crystal.

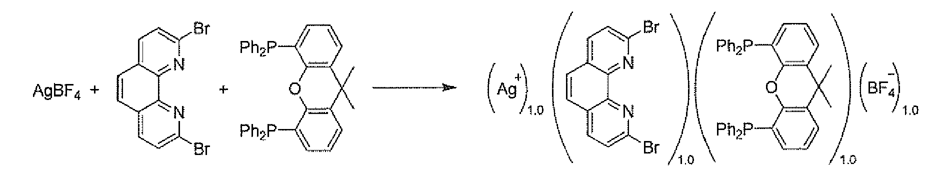

The NMR data of the obtained complex is provided below.
¹H NMR (300 MHz, CDCl₃) δ 8.50 (brd, 2H), 8.13 (brs, 2H), 7.84 (brd, 2H), 7.62 (brd, 2H), 7.26-7.04 (m, 22H), 6.78 (br, 2H), 1.71 (s, 6H); ³¹P NMR (122 MHz, CDCl₃); ³¹P NMR (122 MHz, CDCl₃) δ -4.9 (d, J (³¹P-¹⁰⁷Ag, ¹⁰⁹Ag) = 392, 451 Hz).
The composition of the obtained complex was determined according to the same method as in Example 15. The present complex corresponds to the above composition formula (5).

### Example 23

To 1 mL of the solution of silver(I) tetrafluoroborate (1.15 mg, 0.00591 mmol) in dichloromethane was added 2,2'-bis(diphenylphosphino)biphenyl (3.09 mg, 0.00591 mmol), and the mixture was stirred at room temperature for 15 minutes. Then, 2,9-dibromo-1,10-phenanthroline (2.00 mg, 0.00591 mmol) was added to the reaction solution, which was stirred at 40°C for five minutes. The reaction solution was subjected to recrystallization by slow diffusion of dichloromethane-ether and dried to provide 3.50 mg of the complex of the pale yellow crystal.

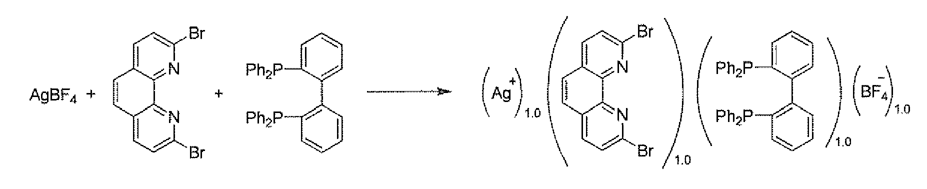

The NMR data of the obtained complex is provided below.
¹H NMR (300 MHz, CDCl₃) δ 8.75 (d, J = 8.5 Hz, 2H), 8.33 (s, 2H), 8.15 (d, J = 8.5 Hz, 2H), 7.54-6.67 (m, 28H); ³¹P NMR (122 MHz, CDCl₃) 5 9.7 (d, J (³¹P-107_{A}g, ¹⁰⁹Ag) = 355, 410 Hz).
The composition of the obtained complex was determined according to the same method as in Example 15. The present complex corresponds to the above composition formula (5).

### Example 24

Under argon atmosphere, 4,5-bis(diphenylphosphino)-9,9-dimethylxanthene (66.0 mg, 0.114 mmol) was added to 4 mL of the solution of silver(I) tetrafluoroborate (22.2 mg, 0.114 mmol) in dichloromethane, and the mixture was stirred at room temperature for 15 minutes. Then, 2,2'-biquinoline (32.2 mg, 0.125 mmol) was added to the reaction solution, which was heated to reflux with stirring for one hour. The reaction solution was filtrated, and the filtrate was subjected to recrystallization by slow diffusion of dichloromethane-ether and dried to provide 103 mg of the complex of the yellow crystal.

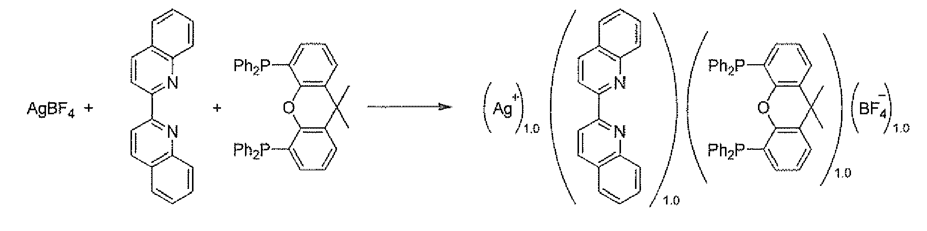

The NMR data of the obtained complex is provided below.
¹H NMR (300 MHz, CDCl₃) δ 8.79 (d, J = 8.7 Hz, 2H), 8.68 (d, J = 8.7 Hz, 2H), 7.92 (d, J = 8.2 Hz, 2H), 7.82 (d, J = 8.2 Hz, 2H), 7.73 (d, J = 6.8 Hz, 2H), 7.48 (t, J = 7.4 Hz, 2H), 7.28-7.23 (m, 6H), 7.13-7.06 (m, 10H), 7.02-6.96 (m, 8H), 6.54-6.50 (m, 2H), 1.85 (s, 6H); ³¹P NMR (122 MHz, CDCl₃) δ -4.6 (d, J (³¹P-¹⁰⁷Ag, ¹⁰⁹Ag) = 361, 417Hz).
The composition of the obtained complex was determined according to the same method as in Example 15. The present complex corresponds to the above composition formula (5).

### Example 25

Under argon atmosphere, 4,5-bis(diphenylphosphino)-9,9-dimethylxanthene (70.7 mg, 0.122 mmol) was added to 4 mL of the solution of silver(I) tetrafluoroborate (23.8 mg, 0.122 mmol) in dichloromethane, and the mixture was stirred at room temperature for 15 minutes. Then, 4,4'-dimethyl-2,2'-biquinoline (38.2 mg, 0.134 mmol) was added to the reaction solution, which was heated to reflux with stirring for one hour. The reaction solution was filtrated, and the filtrate was subjected to recrystallization by slow diffusion of dichloromethane-ether and dried to provide 81.2 mg of the complex of the yellow crystal.

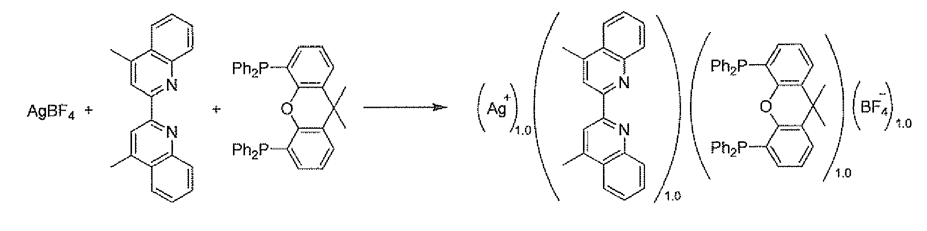

The NMR data of the obtained complex is provided below.
¹H NMR (300 MHz, CDCl₃) δ 8.65 (s, 2H), 8.03 (d, J = 8.4 Hz, 2H), 7.82 (d, J = 8.4 Hz, 2H), 7.72 (d, J = 7.7 Hz, 2H), 7.48 (t, J = 7.5 Hz, 2H), 7.28-7.23 (m, 6H), 7.13-7.06 (m, 10H), 7.02-6.96 (m, 8H), 6.52-6.48 (m, 2H), 2.96 (s, 6H), 1.85 (s, 6H); ³¹P NMR (122 MHz, CDCl₃) δ -4.9 (d, J (³¹P-¹⁰⁷Ag, ¹⁰⁹Ag) = 358, 413 Hz).
The composition of the obtained complex was determined according to the same method as in Example 15. The present complex corresponds to the above composition formula (5).

### Example 26

According to the method described below, 2-(6-chloro-2-pyridinyl)-quinoline (f40) was synthesized.
Under argon atmosphere, 2-bromoquinoline (174 mg, 0.835 mmol), cesium carbonate (544 mg, 1.67 mmol), copper(I) chloride (41.4 mg, 0.418 mmol), palladium(II) acetate (4.69 mg, 0.0209 mmol), and 1,1'-bis(diphenylphosphino)ferrocene (23.1 mg, 0.0418 mmol) are mixed, and 7 mL of the solution of 6-chloropyridine-2-boronic acid pinacol ester (100 mg, 0.418 mmol) in dry DMF was added to the mixture, which was stirred at 95°C for three hours. Water was added to the pale brown suspension, which was then washed with water by chloroform extraction. The organic layer was dried over sodium sulfate, filtrated, and concentrated. The silica gel column was eluted twice with the developing solvent chloroform twice, and the crude purification product was subjected to recrystallization by slow diffusion of chloroform-hexane and dried to provide 25.3 mg (25.1% yield) of the colorless solid (f40).

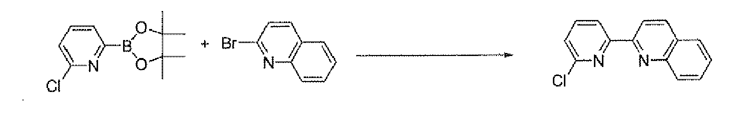

The NMR data of f40 is provided below.
¹H NMR (300 MHz, CDCl₃) δ 8.63 (d, J = 7.7 Hz, 1H), 8.57 (d, J = 8.6 Hz, 1H), 8.29 (d, J = 8.6 Hz, 1H), 8.16 (d, J = 8.4 Hz, 1H), 7.88-7.81 (m, 2H), 7.75 (t, J = 8.4 Hz, 1H), 7.58 (t, J = 7.7 Hz, 1H), 7.40 (d, J = 8.4 Hz, 1H); DART-MS (M/Z): found; 241.05. calcd; 241.05 (M+H)⁺.
To 1 mL of the suspension of silver(I) tetrafluoroborate (1.70 mg, 0.00873 mmol) in dichloromethane was added 4,5-bis(diphenylphosphino)-9,9-dimethylxanthene (5.05 mg, 0.00873 mmol), and the mixture was stirred at room temperature for 15 minutes. Then, f40 (2.31 mg, 0.00960 mmol) was added to the reaction solution, which was stirred at 40°C for 10 minutes. The reaction solution was filtrated, and the filtrate was subjected to recrystallization by slow diffusion of dichloromethane-ether and dried to provide 6.40 mg of the complex of the yellow crystal.

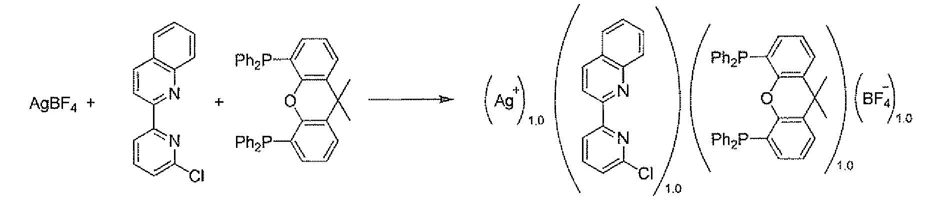

The NMR data of the obtained complex is provided below.
¹H NMR (300 MHz, CDCl₃) δ 8.77 (d, J = 8.0 Hz, 1H), 8.68 (d, J = 8.6 Hz, 1H), 8.59 (d, J = 8.6 Hz, 1H), 8.23 (t, J = 8.0 Hz, 1H), 7.85 (d, J = 8.2 Hz, 1H), 7.67 (d, J = 7.7 Hz, 2H), 7.52-7.45 (m, 2H), 7.38-6.55 (m, 26H), 1.77 (brs, 6H); ³¹P NMR (122 MHz, CDCl₃) δ ?4.6 (d, J (³¹P-¹⁰⁷Ag, ¹⁰⁹Ag) = 376, 434 Hz).
The composition ratio of the obtained complex was determined according to the same method as in Example 15. The present complex corresponds to the above composition formula (5).

### Example 27

According to the method described below, 2-(6-chloro-2-pyridinyl)-4-trifluoromethylquinoline (f42) was synthesized.
Under argon atmosphere, 2-bromo-4-(trifluoromethyl)quinoline (270 mg, 0.835 mmol), cesium carbonate (636 mg, 1.95 mmol), copper(I) chloride (48.3 mg, 0.488 mmol), palladium(II) acetate (5.48 mg, 0.0244 mmol), and 1,1'-bis(diphenylphosphino)ferrocene (27.0 mg, 0.0488 mmol) were mixed, and 7 mL of the solution of 6-chloropyridine-2-boronic acid pinacol ester (117 mg, 0.488 mmol) in dry DMF was added to the mixture, which was stirred at 90°C for eight hours. Water was added to the pale brown suspension reaction solution, which was then washed with water by ethyl acetate extraction. The organic layer was dried over sodium sulfate, filtrated, and concentrated. The silica gel column was eluted with the developing solvent (chloroform: hexane = 1:1) followed by drying to provide 83.7 mg (55.5% yield) of the colorless solid (f42).

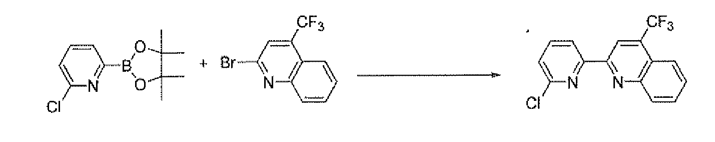

The NMR data and the DART-MS data of f42 were provided below.
¹H NMR (300 MHz, CDCl₃) δ 8.88 (s, 1H), 8.62 (d, J = 7.9 Hz, 1H), 8.26 (d, J = 8.5 Hz, 1H), 8.18 (d, J = 8.9 Hz, 1H), 7.88-7.81 (m, 2H), 7.70 (t, J = 7.9 Hz, 1H), 7.44 (d, J = 7.9 Hz, 1H), 7.40 (d, J = 8.4 Hz, 1H); ¹⁹F NMR (282 MHz, CDCl₃) δ -61.6; DART-MS (M/Z): found; 308.03. calcd; 308.03 (M)⁺.
To 1 mL of the solution of silver(I) tetrafluoroborate (9.48 mg, 0.0487 mmol) in dichloromethane was added 4,5-bis(diphenylphosphino)-9,9-dimethylxanthene (28.2 mg, 0.0487 mmol), and the mixture was stirred at room temperature for 15 minutes. Then, f42 (17.3 mg, 0.0560 mmol) was added to the reaction solution, which was stirred at 40°C for 15 minutes. The reaction solution was filtrated, and the filtrate was subjected to recrystallization by slow diffusion of dichloromethane-ether and dried to provide 46.0 mg of the complex of the yellow crystal.

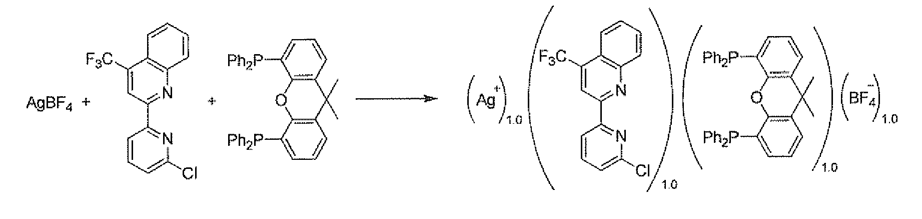

The NMR data of the obtained complex is provided below.
¹H NMR (300 MHz, CDCl₃) δ 8.73-8.70 (m, 2H), 8.35 (t, J = 7.5 Hz, 1H), 8.12 (d, J = 8.6 Hz, 1H), 7.79 (d, J = 8.7 Hz, 1H), 7.68 (d, J = 7.9 Hz, 2H), 7.59-7.50 (m, 3H), 7.34-7.29 (m, 4H), 7.18-7.04 (m, 1H), 6.88 (br, 2H), 6.63 (br, 2H), 1.77 (s, 6H); ³¹P NMR (122 MHz, CDCl₃) δ -4.8 (d, J (³¹P-¹⁰⁷Ag, ¹⁰⁹Ag) = 392, 453 Hz).
The composition of the obtained complex was determined according to the same method as in Example 15. The present complex corresponds to the above composition formula (5).

### Example 28

According to the method described in Synthesis, 7, 1009-1011 (2003), 6,6'-difluoro-2,2'-bipyridine (f27) was synthesized.
To 2 mL of the solution of silver(I) tetrafluoroborate (9.90 mg, 0.0509 mmol) in dichloromethane was added 4,5-bis(diphenylphosphino)-9,9-dimethylxanthene (29.4 mg, 0.0509 mmol), and the mixture was stirred at room temperature for five minutes. Then, f27 (11.2 mg, 0.0585 mmol) was added to the reaction solution, which was stirred at 40°C for five minutes. The reaction solution was filtrated, and the filtrate was subjected to recrystallization by slow diffusion of dichloromethane-ether and dried to provide 43.2 mg of the colorless solid complex.

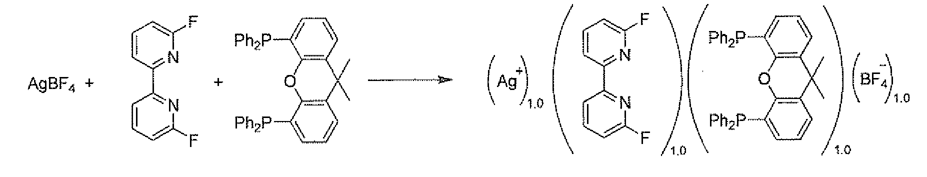

The NMR data of the obtained complex is provided below.
¹H NMR (300 MHz, CDCl₃) δ 8.57-8.54 (m, 2H), 8.29-8.21 (m, 2H), 7.64-7.61 (m, 2H), 7.33-7.28 (m, 4H), 7.19-6.99 (m, 18H), 6.88-6.87 (m, 2H), 6.65-6.63 (m, 2H), 1.71 (s, 6H); ³¹P NMR (122 MHz, CDCl₃) δ -6.1 (d, J (³¹P-¹⁰⁷Ag, ¹⁰⁹Ag) = 399, 460 Hz).
The composition of the obtained complex was determined according to the same method as in Example 15. The present complex corresponds to the above composition formula (5).

### Example 29

To 1.5 mL of the solution of the silver(I) tetrafluoroborate (1.00 mg, 0.00513 mmol) was added 4,5-bis(diphenylphosphino)-9,9-dimethylxanthene (2.97 mg, 0.00513 mmol), and the mixture was stirred at room temperature for five minutes. Then, 2'-(diphenylphosphino)-1,1'-biphenyl-2-ol (1.82 mg, 0.00513 mmol) was added to the reaction solution, which was stirred at 40°C for five minutes. The reaction solution was allowed to reach room temperature followed by addition of 0.18 mL of the solution of potassium methoxide (0.36 mg, 0.00513 mmol) in methanol, and further stirred at 40°C for five minutes. The reaction solution was concentrated, suspended in water, decanted, and dried to provide 5.35 mg of the pale yellow complex.

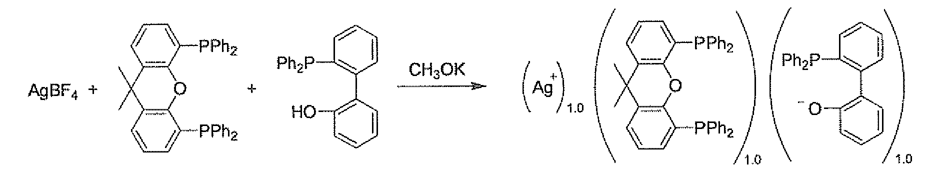

The composition of the obtained complex was determined based on the mixing ratio since the yield was quantitative. The present complex corresponds to the above composition formula (6).

### Comparative Example 1

Under argon atmosphere, 2,9-di-n-butyl-1,10-phenanthroline (63.8 mg, 0.218 mmol) was added to 5 mL of the suspension of silver(I) tetrafluoroborate (42.5 mg, 0.218 mmol) in dry dichloromethane, and the mixture was heated to reflux with stirring for one hour. Then, 2-pyridine-2-yl-1H-indole (42.4 mg, 0.218 mmol) was added to the resulting colorless solution, which was heated to reflux with stirring for additional two hours. The obtained black precipitate suspension was filtrated. The filtrate was concentrated, and the residue was dissolved in 2 mL of methanol and subjected to recrystallization by slow evaporation. The precipitated colorless prismatic crystal was filtrated, and the filtrated matter was vacuum-dried to provide 47.5 mg of the colorless solid complex.

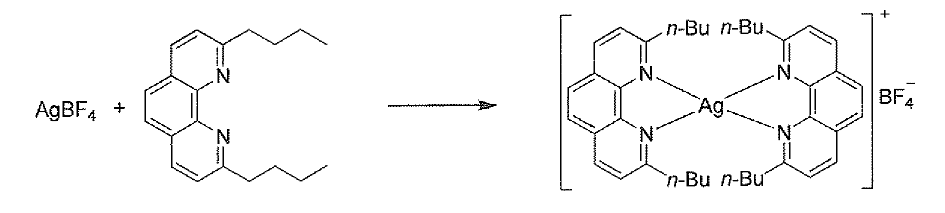

Based on the NMR measurement, it was confirmed that the material ligand (compound) was lost and the obtained complex did not contain the unit derived from 2-pyridine-2-yl-1H-indole. The NMR data and the data of CHN elemental analysis of the complex are provided below.

¹H NMR (300 MHz, CDCl₃) δ8.55 (d, *J=* 8.4 Hz, 2H), 8.04 (s, 2H), 7.79 (d, *J=* 8.4 Hz, 2H), 2.97 (t, *J* = 7.8 Hz, 4H), 1.62-1.51 (m, 4H), 0.91-0.79 (m, 6H), 0.38 (t, *J =* 7.2 Hz, 6H); ¹³C NMR (75 MHz, CDCl₃) δ 162.5 (d, *J =* 1.7 Hz), 142.2 (d, *J =* 2.4 Hz), 139.0 (s), 128.0 (d, *J =* 2.0 Hz), 126.5 (s), 124.4 (d, *J =* 2.4 Hz), 41.9 (s), 32.5 (s), 22.4 (s), 13.2 (s); Anal. Calcd for C₄₀H₄₈N₄AgBF₄·H₂O: C, 60.24; H, 6.32; N, 7.03. Found: C, 60.06; H, 5.89; N, 7.23.

The composition of the complex was determined according to the values of CHN elemental analysis.

### Comparative Example 2

The following complex was synthesized with reference to Non patent Literature: Inorg. Chem. Commun. 9, 866-868 (2006).
Under argon atmosphere, 60 mL of dry methanol was added to silver(I) nitrate (51.0 mg, 0.300 mmol) and (R)-(+)-2,2'-bis(diphenylphosphino)-1,1'-binaphthalene (187 mg, 0.300 mmol), and the mixture was heated to reflux with stirring for one hour while being shaded. The silver nitrate dissolved immediately after the reflux began. The reaction solution was concentrated to about 8 mL and filtrated, and the filtrate was subjected to recrystallization by slow evaporation. The precipitated colorless crystal was filtrated and vacuum-dried to provide 49.5 mg (20.8% yield) of the colorless solid complex. The NMR data of the complex is provided below.

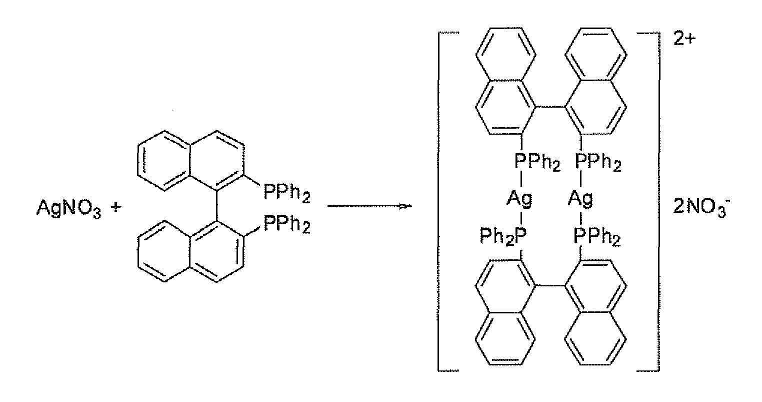

³¹P NMR(122 MHz, CDCl₃) δ 16.4 (d, J (³¹P-¹⁰⁷Ag, ³¹P-¹⁰⁹Ag) = 226, 261 Hz).

### Comparative Example 3

Under argon atmosphere, 4 mL of THF and 1,2-bis(diphenylphosphino)benzene (61.9 mg, 0.139 mmol) were added to silver (I) tetrafluoroborate (27.0 mg, 0.139 mmol), and the mixture was heated to reflux for one hour and the reaction solution was then allowed to cool to -60°C, Separately, under argon atmosphere, 10-bromobenzo[h]quinoline (28.2 mg, 0.0487 mmol) synthesized according to the method described in J. Am. Chem. Soc. 126, 2300-2301 (2004) was dissolved in 4 mL of THF, to which was added the solution of 1.66 M n-butyllithium (83.7 µL, 0.139 mmol) in hexane at -60°C. The mixture was stirred for 30 minutes, to which the reaction solution cooled to -60°C was then added dropwise, and was allowed to reach room temperature and stirred for two hours. The reaction solution was concentrated, suspended in chloroform, and filtrated. The filtrate was concentrated and subjected to recrystallization by slow diffusion of chloroform-ether to provide 61.5 mg of the colorless solid complex. The NMR data of the complex is provided below. The NMR spectrum had a pattern similar to that of the complex described in Chem. Commun. 6384-6386 (2008), thereby showing that the complex had the following structure.

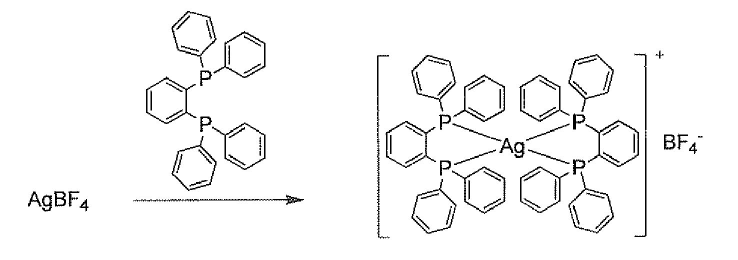

¹H NMR (300 MHz, CDCl₃) δ 7.57 (br, 8H), 7.39-7.34 (m, 8H), 7.14-7.12 (m, 32H); ³¹P NMR (122 MHz, CDCl₃) δ 1.25 (d, J (³¹P-¹⁰⁷Ag, ¹⁰⁹Ag) = 231, 267 Hz).

### [Luminescence Properties of Complex in Solid State]

Solid Emission Wavelength: The emission spectrum of the complex in a solid state was measured by fluorescence spectrophotometer (Fluorolog-Tau3, produced by JOBINYVON-SPEX). In addition, the solid emission quantum efficiency under air at room temperature was measured by quantum efficiency measurement apparatus (produced by Sumitomo Heavy Industries, Ltd.).

Solid Emission Quantum Efficiency: The sample was prepared as follows. Under air at room temperature, about 1.5 mg of the sample consisting only of the complex synthesized in above Example or Comparative Example was interposed between two 18-mm square glass plates having a thickness of from 0.12 to 0.17 mm, and the glass plates were pressed so that the sample is extended to an ellipse of about 10 mm × 5 mm and sealed on four sides with non-luminescent tapes.
The configuration of the equipment is as follows. A light source used was the He-Cd CW laser of Class 3B produced by KIMMON Koha Co., Ltd. To an emitting unit, the ND filter FDU 0.5 produced by OFR, Inc. was inserted and guided to an integrating sphere by an optical fiber. The integrating sphere, a polychromator and a CCD multichannel detector which were produced by Optel department of Sumitomo Heavy Industries Mechatronics, Ltd. were sequentially linked to Model 2400 SourceMeter produced by Keythley Instruments Inc. and then connected to a general notebook computer.
The measurement method was as follows. Under air at room temperature, the sample prepared under the above conditions was placed in the integrating sphere, and the aperture of the integrating sphere was set to three. The laser excitation light was set to 325 nm. In CW light, the integration time was set to 300 ms, the excitation light integrating range was set to 315 to 335 nm, and PL wavelength integrating range was set to 390 to 800 nm. According to the procedure of measurement-analysis software produced by Sumitomo Heavy Industries Mechatronics, Ltd., the solid emission quantum efficiency was calculated.

Solid Emission Lifetime: The measurement and analysis were carried out as follows. The sample prepared by the same method as in the solid emission quantum efficiency measurement was placed on the sample position for a unknown sample in Fluorolog-Tau3 produced by JOBINYVON-SPEX, and the LUDOX-containing pure water was placed on the sample position for a reference sample. The emission lifetime of the LUDOX was set to zero and the lifetime of the sample was measured according to the frequency modulation method at the maximum emission wavelength and the maximum excited wavelength of the silver complex which were measured in advance by the apparatus. The measurement result was analyzed according to the theoretical formula described in Anal. Chem. 68, 9-17 (1996).

The values of the solid emission quantum efficiency, the solid emission wavelength, and the solid emission lifetime of the complexes in Examples 1 to 29 and Comparative Examples 1 to 3 are shown in Tables 3-1 and 3-2.

**[Table 3-1]**

| Comp. No. | Solid Emission Quantum Efficiency (%) | Solid Emission Wavelength (nm) | Solid Emission Lifetime (ns) |
|---|---|---|---|
| Example 1 | 28 | 488 | 4800 |
| Example 2 | 2.3 | 434 | 7 |
| Example 3 | 1.1 | 511 | 4 |
| Example 4 | 2.3 | 480 | 4 |
| Example 5 | 1.1 | 359 | 7 |
| Example 6 | 2.4 | 496 | 1000 |

**[Table 3-2]**

| Comp. No. | Solid Emission Quantum Efficiency (%) | Solid Emission Wavelength (nm) | Solid Emission Lifetime (ns) |
|---|---|---|---|
| Example 7 | 24 | 494 | 3300 |
| Example 8 | 9.0 | 506 | 2200 |
| Example 9 | 33 | 563 | - |
| Example 10 | 4.3 | 601 | - |
| Example 11 | 33 | 526 | 3700 |
| Example 12 | 65 | 540 | 3000 |
| Example 13 | 5.5 | 446 | 2800 |
| Example 14 | 8.3 | 456 | 2500 |
| Example 15 | 26 | 501 | 6000 |
| Example 16 | 14 | 493 | - |
| Example 17 | 23 | 506 | - |
| Example 18 | 4 | 537 | 1600 |
| Example 19 | 7 | 538 | - |
| Example 20 | 38 | 520 | 1600 |
| Example 21 | 23 | 508 | 7800 |
| Example 22 | 11 | 480 | 6200 |
| Example 23 | 19 | 522 | 2600 |
| Example 24 | - | - | - |
| Example 25 | - | - | - |
| Example 26 | 12 | 569 | - |
| Example 27 | 30 | 565 | - |
| Example 28 | 5 | 518 | - |
| Example 29 | 3.7 | - | - |
| Comparative Example 1 | 0.4 | - | 5 |
| Comparative Example 2 | 0.4 | - | - |
| Comparative Example 3 | 16 | 440 | - |

| | | | |
|---|---|---|---|
| (In Table, "-" means no measurement performed.) | | | |

### [S1-T1 Energy of Complex]

### Calculation Examples 1 to 13

As the model of the complex obtained in Example 11, one Ag⁺ atom, one molecule of 4,5-bis(diphenylphosphino)-9,9-dimethylxanthene, and one molecule of 2,9-dichloro-1,10-phenanthroline were used, and the structure with counter ions removed was used. As the initial coordination, two phosphorus atoms capable of coordinating to Ag⁺, contained in 4,5-bis(diphenylphosphino)-9,9-dimethylxanthene, and two nitrogen atoms capable of coordinating to Ag⁺, contained in 2,9-dichloro-1,10-phenanthroline all were arranged within 3.0 angstroms from Ag⁺, and the structure optimizing calculation was carried out using the density functional theory of Gaussian 03 program (revision D.02). Moreover, calculation of a single-electron excited state of the structure was carried out using the time-dependent density functional theory. In both the structure optimizing calculation and the calculation of single-electron excited state, as calculation techniques, B3LYP as a functional, LANL2DZ for Ag⁺ and a halogen atom as a basis function, and 6-31G(d) for other atoms were used. As a result of calculation, in the complex calculated with the structure of Example 11, S1 energy was 2.72 eV, T1 energy was 2.68 eV, and difference between S1 energy and T1 energy was 0.04 eV.
According to the same method as described above, S1 energy, T1 energy, and S1-T1 energy difference were calculated for the complexes shown in the following Table 4.

**[Table 4]**

| Number | Complex No. | S1 Energy (eV) | T1 Energy (eV) | S1-T1 Energy difference (eV) |
|---|---|---|---|---|
| Calculation Example 1 | Example 1 | 3.29 | 3.26 | 0.03 |
| Calculation Example 2 | Example 7 | 2.96 | 2.86 | 0.06 |
| Calculation Example 3 | Example 8 | 3.12 | 3.06 | 0.06 |
| Calculation Example 4 | Example 9 | 2.61 | 2.45 | 0.16 |
| Calculation Example 5 | Example 11 | 2.72 | 2.68 | 0.04 |
| Calculation Example 6 | Example 12 | 2.67 | 2.63 | 0.05 |
| Calculation Example 7 | Example 16 | 2.72 | 2.68 | 0.04 |
| Calculation Example 8 | Example 17 | 2.72 | 2.68 | 0.04 |
| Calculation Example 9 | Example 18 | 2.61 | 2.58 | 0.03 |
| Calculation Example 10 | Example 19 | 3.13 | 2.93 | 0.21 |
| Calculation Example 11 | Example 20 | 2.51 | 2.45 | 0.06 |
| Calculation Example 12 | Example 21 | 2.77 | 2.73 | 0.03 |
| Calculation Example 13 | Comparative Example 1 | 3.68 | 2.82 | 0.85 |

Regarding S1-T1 energy difference in Table 4 and the solid emission lifetime in Tables 3-1 and 3-2, it was found that the excitation lifetime exhibited 1000 ns or more when S1-T1 energy difference was 0.3 eV or smaller. On the other hand, the lifetime was below 10 ns when S1-T1 energy difference was greater than 0.3 eV.

### Example 30

About 100 mg of the chloroform solution containing 1% by weight of the complex of Example 11 was placed on a 2-cm square glass substrate. The substrate was spun at 500 rpm for 5 seconds and at 1500 rpm for 15 seconds using the spin coater (H3CA, produced by OMRON Corporation) to provide a thin-film having a thickness of 65 nm. Emission was observed when the thin-film was irradiated with a UV lamp.

### Examples 31 to 58, and Comparative Example 4

About 100 mg of the chloroform solution containing 1% by weight of each of the complexes of Examples 1 to 29 and Comparative Example 3 and 6.2% by weight of PMMA was placed on a 1×2 cm-square quartz substrate. The substrate was spun at 500 rpm for 5 seconds and at 1500 rpm for 15 seconds using the spin coater (H3CA, produced by OMRON Corporation) to provide a thin-film. The thickness of Example 41 was 1.6 µm.

### [Luminescence Properties in the Form of Thin-film of Composition Including Complex and Polymer]

The thin-film was placed in the integrating sphere of the quantum efficiency measurement apparatus (produced by Sumitomo Heavy Industries Mechatronics, Ltd.), and measured for the emission quantum efficiency at about 5 seconds and about 15 seconds after irradiated with laser beam under the same conditions as in the measurement of the solid emission quantum efficiency. Difference of the attenuation ratios of the emission quantum efficiencies therebetween was divided by the elapsed time to provide the value of the oxidative degradation rate. Also, the value of the emission quantum efficiency measured at about 5 seconds after the thin-film was irradiated with laser beam in the same way under nitrogen atmosphere was defined as the thin-film emission quantum efficiency in Tables 5-1 and 5-2.

**[Table 5-1]**

| Thin-Film | Complex | Thin-Film Emission Quantum Efficiency (%) | Oxidative Degradation Rate (min⁻¹) |
|---|---|---|---|
| Example 31 | Example 1 | 28 | 0.38 |
| Example 32 | Example | 2 6 | ~0 |
| Example 33 | Example | 3 2 | ~0 |
| Example 34 | Example | 4 2 | ~0 |
| Example 35 | Example 5 | 11 | 0.35 |
| Example 36 | Example | 6 3 | ~0 |
| Comparative Example 4 | Comparative Example 3 | 16 | 1.46 |

**[Table 5-2]**

| Thin-Film | Complex | Thin-Film Emission Quantum Efficiency (%) | Oxidative Degradation Rate (min⁻¹) |
|---|---|---|---|
| Example 37 | Example 7 | 8 | 0.42 |
| Example 38 | Example 8 | 12 | 0.45 |
| Example 39 | Example 9 | 18 | 0.40 |
| Example 40 | Example 10 | 22 | 0.08 |
| Example 41 | Example 11 | 55 | 0.02 |
| Example 42 | Example 12 | 57 | ~0 |
| Example 43 | Example 13 | 17 | 1.06 |
| Example 44 | Example 14 | 18 | 1.09 |
| Example 45 | Example 15 | 50 | 0.14 |
| Example 46 | Example 16 | 53 | ~0 |
| Example 47 | Example 17 | 65 | ~0 |
| Example 48 | Example 18 | 38 | ~0 |
| Example 49 | Example 19 | 16 | ~0 |
| Example 50 | Example 20 | 29 | 0.86 |
| Example 51 | Example 21 | 45 | -0 |
| Example 52 | Example 22 | 23 | 0.18 |
| Example 53 | Example 23 | 23 | 0.80 |
| Example 54 | Example 24 | 40 | 0.47 |
| Example 55 | Example 25 | 42 | 0.80 |
| Example 56 | Example 26 | 57 | 0.57 |
| Example 57 | Example 27 | 50 | 0.13 |
| Example 58 | Example 28 | 51 | ~0 |

### Example 59

The suspension of poly(ethylenedioxythiophene) /polystyrene sulfonate (trade name: Bytron P AI4083, produced by Bayer AG) was spin-coated to form a film having a thickness of 65 nm on the glass substrate with a 150-nm thick ITO film attached, and the resulting substrate was dried at 200°C for 10 minutes on a hot plate. On this substrate, the suspension containing 1.3% by weight of the complex of Example 1 in toluene was spin-coated to form a film, and dried at 130°C for 10 minutes. Subsequently, as a cathode, about 4 nm of barium and finally about 100 nm of aluminum were vapordeposited to produce a luminescent device. To the obtained device was applied a voltage and therefore emission was observed.

### Industrial Applicability

The silver complex of the present invention can be used as a luminescent material.

## Claims

1. A luminescent silver complex represented by compositional formula (1):
(Ag⁺) (L¹)ₐ (L²)_{b} (X¹)ₖ (1)

2. The luminescent silver complex according to claim 1, wherein L¹ has two phosphorus atoms capable of coordinating to Ag⁺ in compositional formula (1).

3. The luminescent silver complex according to claim 2, wherein, in compositional formula (1), L¹ is a molecule represented by formula (A):
Q¹-R¹-Q¹ (A)
wherein Q¹ is -P(R¹¹)₂; R¹¹ is an optionally substituted hydrocarbon group; four R¹¹s may be the same as or different from each other; any two of the four R¹¹s may be bonded to each other to form a ring; and R¹ is a divalent group.

4. The luminescent silver complex according to claim 3, wherein, in formula (A), R¹¹ is an optionally substituted aryl group, each of the four R¹¹s may be the same as or different from each other, any two of the four R¹¹s may be bonded to each other to form a ring, and R¹ is a divalent group represented by optionally substituted r1 to r12: 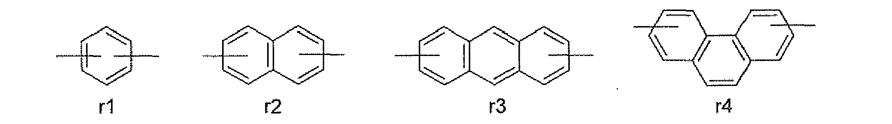 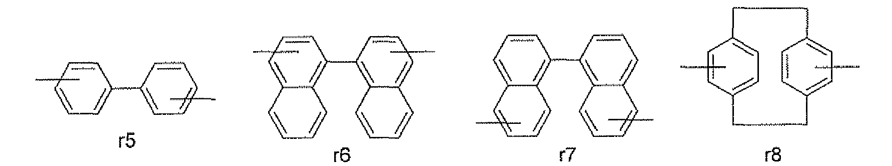 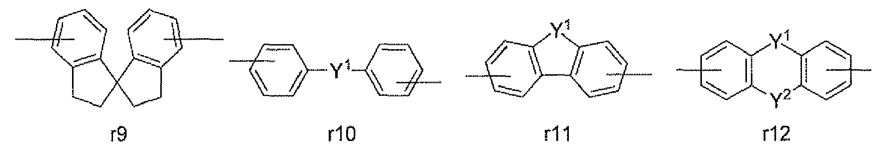 wherein Y¹ and Y² are each independently a divalent group represented by - (CH₂) n-, -O-, -S-, -N(R^{x})-, -Si(R^{x})₂-, -O (CH₂) n-, or -O (CH₂) nO-; Y¹ and Y² may be the same as or different from each other; n is an integer of from 1 to 3; and R^{x} is a hydrocarbon group.

5. The luminescent silver complex according to claim 4, wherein, in formula (A), R¹¹ is an optionally substituted phenyl group, each of the four R¹¹s may be the same as or different from each other, and R¹ is a divalent group represented by optionally substituted r1', r5', r6', r10', or r12':

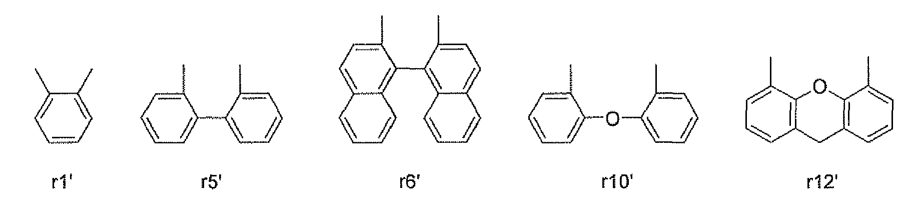

6. The luminescent silver complex according to claims 1 to 5, which is represented by any one of compositional formulae (3) to (6):
(Ag⁺) (L³) _{d'1} (L⁴) _{e'1} (X²) _{f'1} (3)
wherein L³ is defined as the same as L¹ described above; L⁴ is a molecule having only one of a phosphorus atom, a nitrogen atom, an oxygen atom, a sulfur atom, and an arsenic atom as an atom capable of coordinating to Ag⁺; X² is a halide ion; and d'1 and e'1 are each independently a positive number that is smaller than 2.0, and f'1 is a positive number of 1.5 or smaller,
(Ag⁺) (L⁵) _{d'2} (L⁶) _{e'2} (X³) _{f'2} (4)
wherein L⁵ is defined as the same as L¹ described above; L⁶ is a molecule having a phosphorus atom, a nitrogen atom, an oxygen atom, a sulfur atom, or an arsenic atom as one atom capable of coordinating to Ag⁺, and having a phosphorus atom, an oxygen atom, a sulfur atom, or an arsenic atom as another atom capable of coordinating to Ag⁺, and L⁶ is different from L⁵ ; X³ is an anion; d'2 and e'2 are each independently a positive number that is smaller than 2.0; and f'2 is a number of from 0 to 1.5,
(Ag⁺) (L⁷) _{d'3} (L⁸) _{e'3} (X⁴) _{f'3} (5)
wherein L⁷ is defined as the same as L¹ described above; L⁸ is a molecule having two nitrogen atoms capable of coordinating to Ag⁺; X⁴ is an anion; d'3 and e'3 are each independently a positive number that is smaller than 2.0; and f'3 is a number of from 0 to 1.5,
(Ag⁺) (L⁹) _{d'4} (L¹⁰) _{e'4} (6)
wherein L⁹ is defined as the same as L¹ described above; L¹⁰ is a molecule having a phosphorus atom, a nitrogen atom, an oxygen atom, a sulfur atom, or an arsenic atom as one atom capable of coordinating to Ag⁺, and having an oxygen anion or a sulfur anion as another ion capable of coordinating to Ag⁺; and d'4 and e'4 are independently a positive number that is smaller than 2.0.

7. The luminescent silver complex according to claim 6, wherein the luminescent silver complex is represented by compositional formula (3), in which L⁴ is a molecule represented by P(R²¹⁰)₃, N(R²²⁰)₃, an optionally substituted nitrogen-containing heterocyclic compound molecule, O(R²³⁰)₂, S(R²⁴⁰)₂, R²⁵⁰-CO₂H, R²⁶⁰-OH, R²⁷⁰-CN, R²⁸⁰-SH, or R²⁹⁰-SO₃H, wherein: R²¹⁰, R²²⁰, R²³⁰, R²⁴⁰, R²⁵⁰, R²⁶⁰, R²⁷⁰, R²⁸⁰, and R²⁹⁰ are each independently a hydrogen atom or an optionally substituted hydrocarbon group; Each of three R²¹⁰s, three R²²⁰s, two R²³⁰s, and two R²⁴⁰s may be the same as or different from each other; two of three R²¹⁰s may be bonded to each other to form a ring; two of three R²²⁰s may be bonded to each other to form a ring; two R²³⁰s may be bonded to each other to form a ring; and two R²⁴⁰s may be bonded to each other to form a ring.

8. The luminescent silver complex according to claim 7, wherein L⁴ is P(R²¹⁰)₃ or an optionally substituted nitrogen-containing heterocyclic compound molecule, R²¹⁰ is an optionally substituted aryl group, each of three R²¹⁰s may be the same as or different from each other, and two of three R²¹⁰s may be bonded to each other to form a ring.

9. The luminescent silver complex according to claim 8, L⁴ is P(R²¹⁰)₃, R²¹⁰ is an optionally substituted phenyl group, each of three R²¹⁰s may be the same as or different from each other, and two of three R²¹⁰s may be bonded to each other to form a ring.

10. The luminescent silver complex according to claim 6, wherein the luminescent silver complex is represented by compositional formula (3), in which L³ is a molecule represented by any one of formulae: 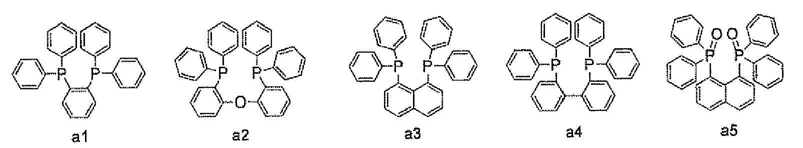 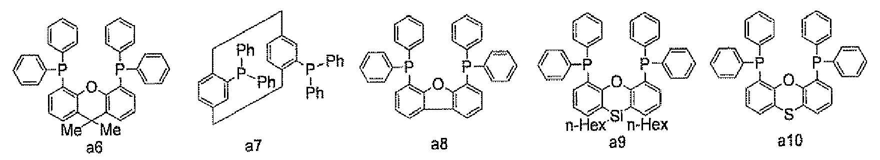 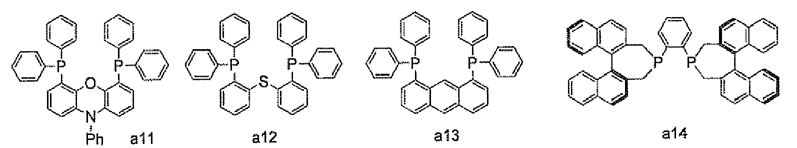 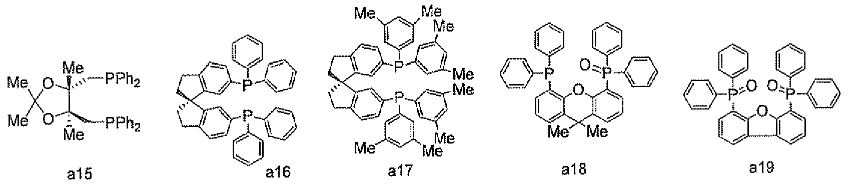 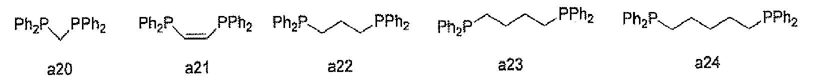 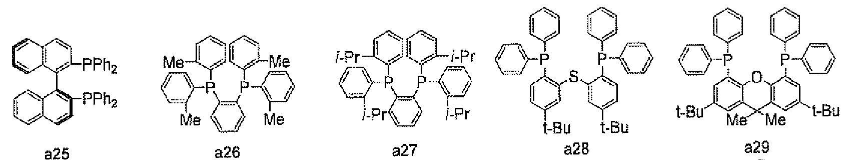 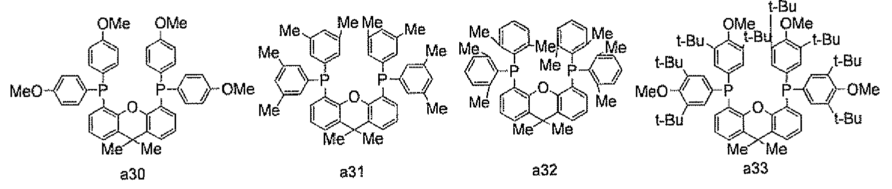 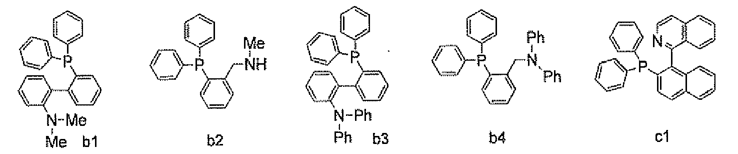 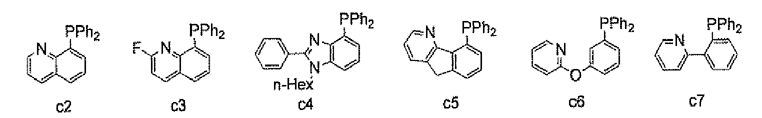 , and L⁴ is a molecule represented by any one of formulae:

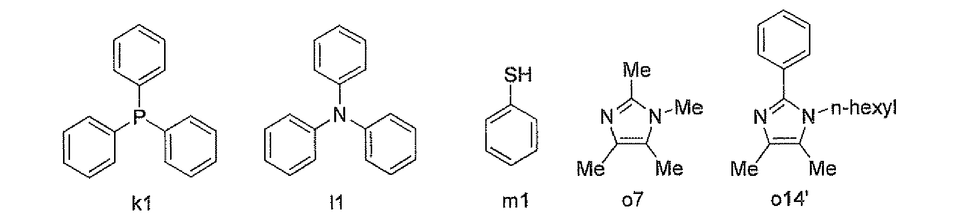

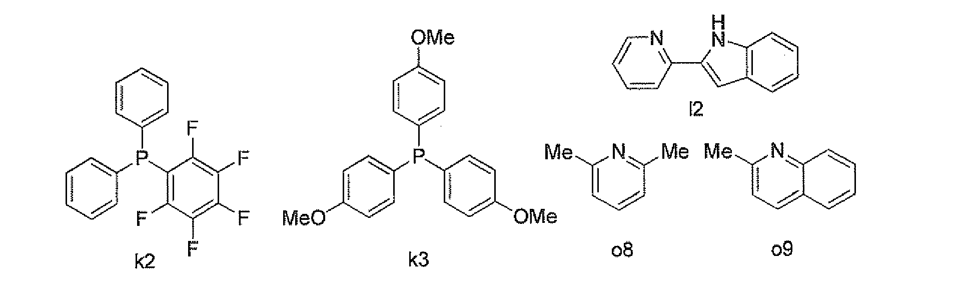

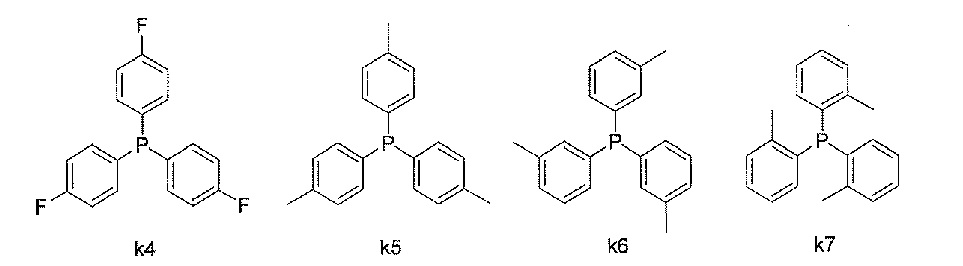

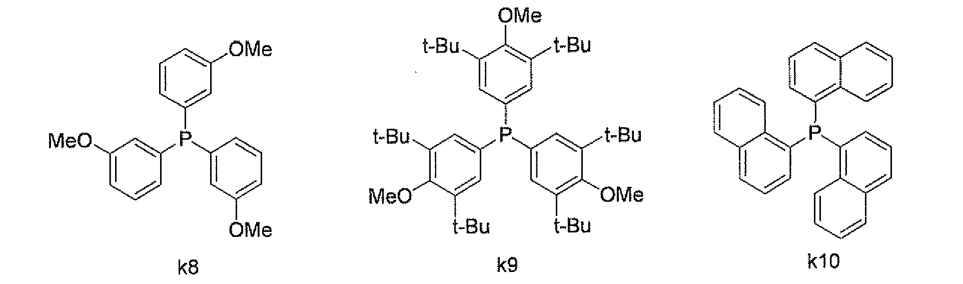

11. The luminescent silver complex according to claim 10, wherein the luminescent silver complex is represented by compositional formula (3), in which L³ is a molecule represented by any one of formulae a1 to a4, a6 to a13, a16 to a17, and a25 to a33, and L⁴ is a molecule represented by any one of formulae k1 to k10.

12. The luminescent silver complex according to claim 9, wherein d'1, e'1, and f'1 are each independently from 0.5 to 1.5.

13. The luminescent silver complex according to claim 11, wherein d'1, e'1, and f'1 are each independently from 0.5 to 1.5.

14. The luminescent silver complex according to claim 6, wherein the luminescent silver complex is represented by compositional formula (4) in which L⁶ is a molecule represented by formula (B):
Q⁵-R⁵-Q⁵¹ (B)
wherein Q⁵ is a group represented by -P(R⁵¹)₂, -As(R⁵²)₂, -P(=O)(R⁵³)₂, -OH, -CO₂H, -SH, -SO₃H, -OR⁵⁴, -CO₂R⁵⁵, -SR⁵⁶, or -SO₃R⁵⁷; Q⁵¹ is -P(R⁵⁸)₂, -As(R⁵⁹)₂, -P(=O) (R⁵¹⁰)₂, -OH, -CO₂H, -SH, -SO₃H, -OR⁵¹¹, -CO₂R⁵¹², -SR⁵¹³, -SO₃R⁵¹⁴, -N(R⁵¹)₂, or an optionally substituted nitrogen-containing heterocyclic group; Q⁵ and Q⁵¹ may be the same as or different from each other, and Q⁵ and Q⁵¹ may be bonded to each other to form a rang; R⁵¹ to R⁵⁹ and R⁵¹⁰ to R⁵¹⁵ are each independently a hydrogen atom or an optionally substituted hydrocarbon group; two R⁵¹s, two R⁵²s, two R⁵³s, two R⁵⁸s, two R⁵⁹s, two R⁵¹⁰s, and two R⁵¹⁵s may be the same as or different from each other; two R⁵¹s may be bonded to each other to form a ring; two R⁵²s may be bonded to each other to form a ring; two R⁵³s may be bonded to each other to form a ring; two R⁵⁸s may be bonded to each other to form a ring; two R⁵⁹s may be bonded to each other to form a ring; two R⁵¹⁰s may be bonded to each other to form a ring; and two R⁵¹⁵s may be bonded to each other to form a ring; R⁵ is a divalent group, but may be a direct bonding when Q⁵¹ is an optionally substituted nitrogen-containing heterocyclic group.

15. The luminescent silver complex according to claim 14, wherein, in formula (B), Q⁵ is a group represented by - P(R⁵¹)₂, -OH, -CO₂H, or -SH; Q⁵¹ is -OH, -CO₂H, -SH, or an optionally substituted nitrogen-containing heterocyclic group; at least one of Q⁵ and Q⁵¹ is -P(R⁵¹)₂ or an optionally substituted nitrogen-containing heterocyclic group; two R⁵¹s are optionally substituted aryl groups; each of two R⁵¹s may be the same as or different from each other; two R⁵¹s may be bonded to each other to form a ring; R⁵ is a divalent group represented by the optionally substituted r1 to r12, but may be a direct bonding when Q⁵¹ is an optionally substituted nitrogen-containing heterocyclic group.

16. The luminescent silver complex according to claim 15, wherein, in formula (B), Q⁵ is a group represented by - P(R⁵¹)₂; Q⁵¹ is -OH, -CO₂H, or an optionally substituted nitrogen-containing heterocyclic group; R⁵¹ is an optionally substituted phenyl group; each of two R⁵¹s may be the same as or different from each other; two R⁵¹s may be bonded to each other to form a ring; R⁵ is a divalent group represented by the optionally substituted r1', r5', r6', r10', or r12', but may be a direct bonding when Q⁵¹ is an optionally substituted nitrogen-containing heterocyclic group.

17. The luminescent silver complex according to claim 6, wherein the luminescent silver complex is represented by compositional formula (4), in which L⁵ is a molecule represented by any one of formulae: 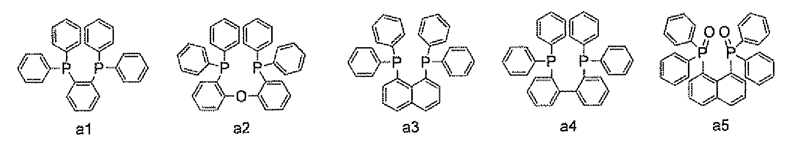 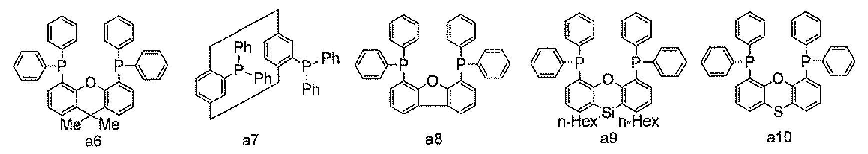 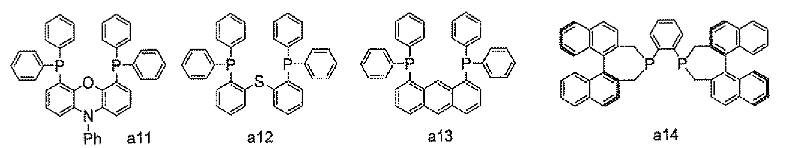 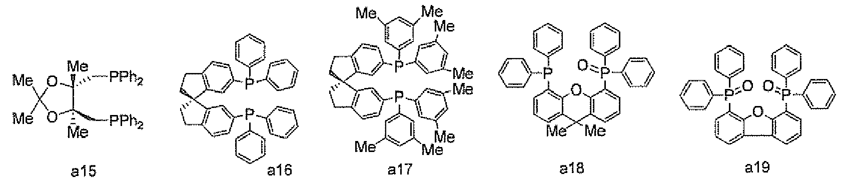 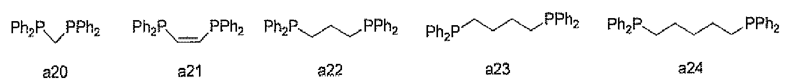 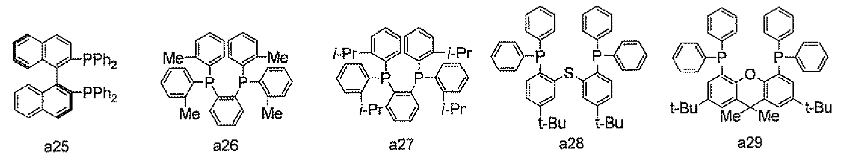 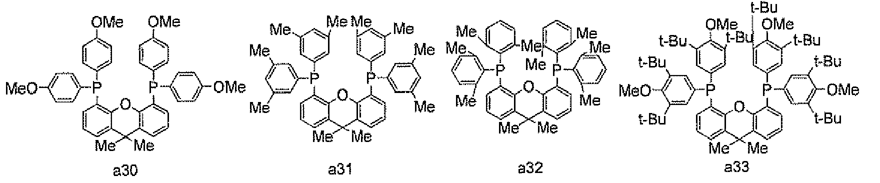 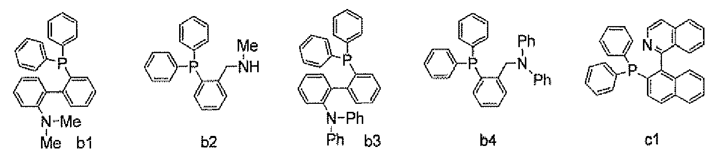 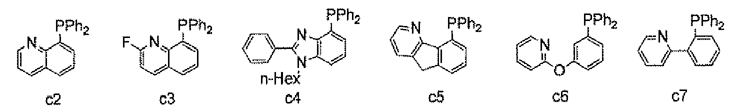 ; L⁶ is a molecule represented by any one of formulae: 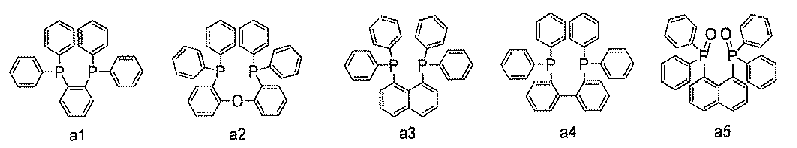 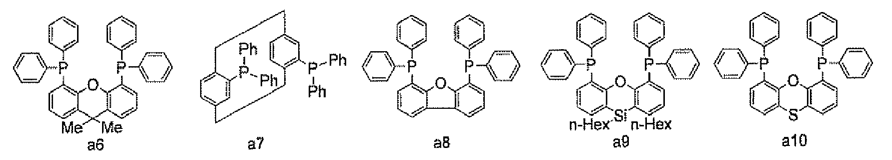 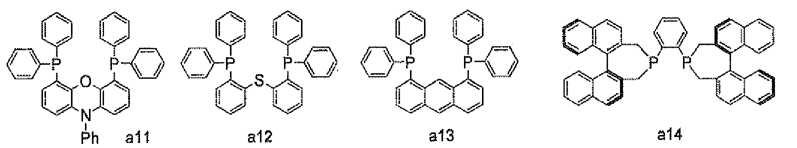 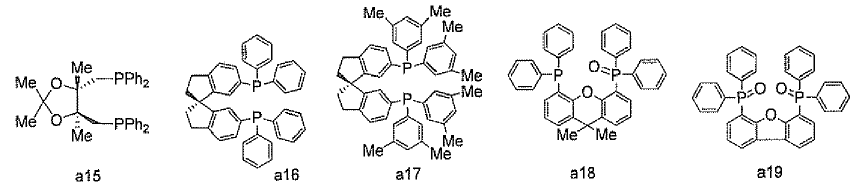 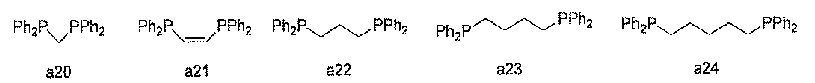 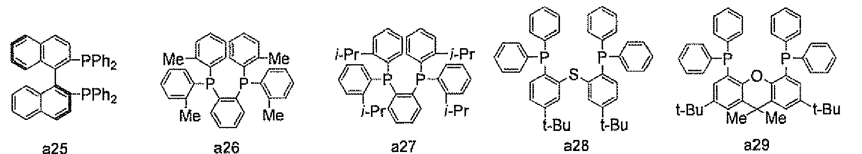 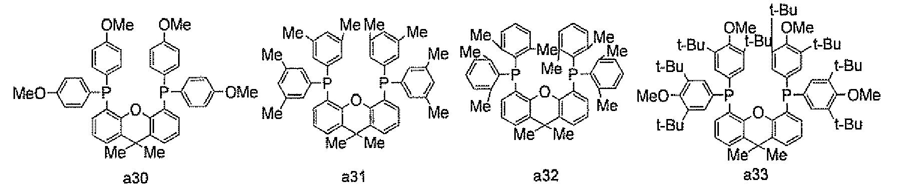 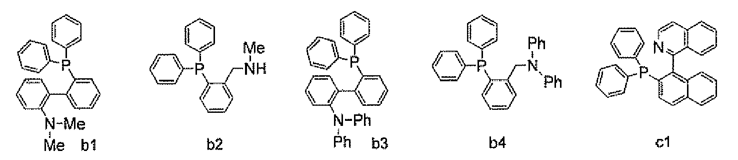 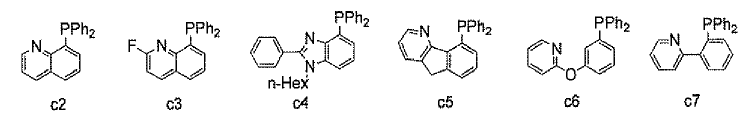 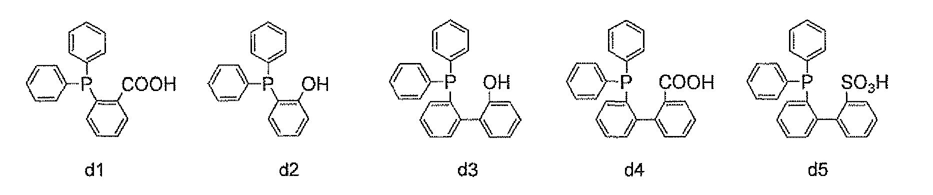 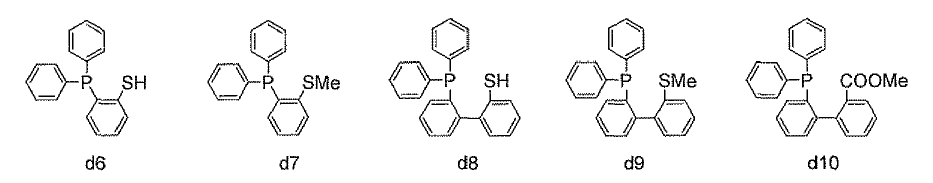 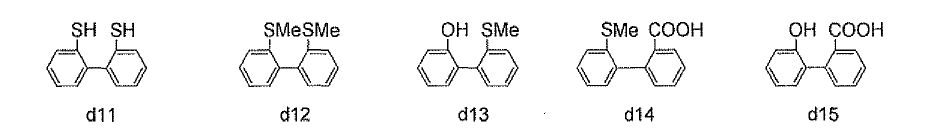 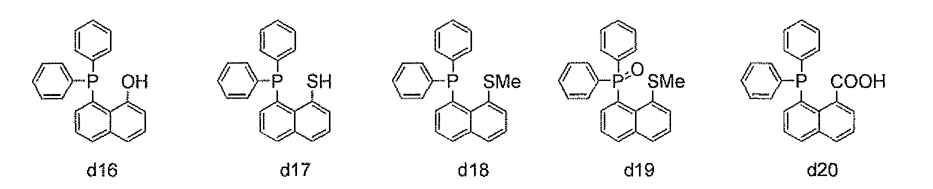 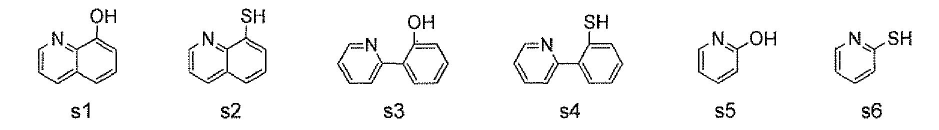 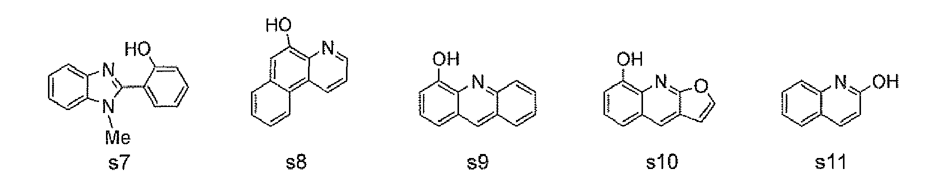 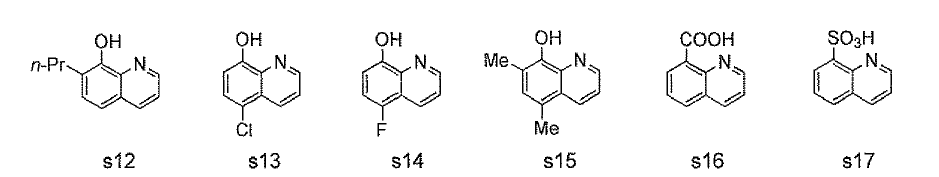 ; and X³ is a fluoride ion, a chloride ion, a bromide ion, an iodide ion, a sulfate ion, a nitrate ion, a carbonate ion, an acetate ion, a perchlorate ion, a tetrafluoroborate ion, a hexafluorophosphate ion, a hexafluoro antimony ion, a hexafluoro arsenic ion, a methanesulfonate ion, a trifluoromethanesulfonate ion, a trifluoroacetate ion, a benzenesulfonate ion, a p-toluenesulfonate ion, a dodecylbenzenesulfonate ion, a tetraphenylborate ion, or a tetrakis(pentafluorophenyl)borate ion.

18. The luminescent silver complex according to claim 17, wherein the luminescent silver complex is represented by compositional formula (4) in which L⁵ is a molecule represented by any one of formulae a1 to a4, a6 to 13, a16 to a17, and a25 to a33; and L⁶ is a molecule represented by any one of formulae c1 to c5, c7, d1 to d4, d6, d8, d16 to d17, d20, s1 to s4, s7 to s10, and s12 to s16.

19. The luminescent silver complex according to claim 16, which is **characterized in that** d'2, e'2, and f'2 are each independently from 0.5 to 1.5.

20. The luminescent silver complex according to claim 18, which is **characterized in that** d'2, e'2, and f'2 are each independently from 0.5 to 1.5.

21. The luminescent silver complex according to claim 6, wherein the luminescent silver complex is represented by compositional formula (5) in which L⁸ is a molecule represented by formula (D):
Q⁷-R⁷-Q⁷ (D)
wherein Q⁷ is -N(R⁷¹)₂ or an optionally substituted nitrogen-containing heterocyclic group; two Q⁷s may be the same as or different from each other; two Q⁷s may be bonded to each other to form a ring; R⁷¹ is a hydrogen atom or an optionally substituted hydrocarbon group; each of two R⁷¹s may be the same as or different from each other; two R⁷¹s may be bonded to each other to form a ring; R⁷ is a divalent group, but may be a direct bonding when any one of two Q⁷s is an optionally substituted nitrogen-containing heterocyclic group.

22. The luminescent silver complex according to claim 21, wherein the luminescent silver complex is represented by compositional formula (5) in which L⁸ is a molecule represented by the following formula (Da): 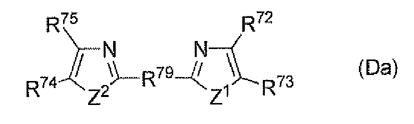 wherein N is a nitrogen atom capable of coordinating to Ag⁺; Z¹ and Z² are each independently -C (R⁷⁶) =C (R⁷⁷) -, - NR⁷⁸-, -O-, or -S-; Z¹ and Z² may be the same as or different from each other; R⁷⁹ is a direct bonding, - C(R⁸⁰)₂ -, -NR⁷⁸-, -O-, or -S-; R⁷², R⁷³, R⁷⁴, R⁷⁵, R⁷⁶, R⁷⁷, R⁷⁸, and R⁸⁰ are each independently a hydrogen atom, a halogen atom, an optionally substituted hydrocarbyloxy group, or an optionally substituted hydrocarbon group; Each of R⁷², R⁷³, R⁷⁴, R⁷⁵, R⁷⁶, R⁷⁷, R⁷⁸, and R⁸⁰ may be the same as or different from each other; R⁷² and R⁷³ may be bonded to each other to form a ring; R⁷⁴ and R⁷⁵ may be bonded to each other to form a ring; R⁷⁶ and R⁷³ may be bonded to each other to form a ring, and R⁷⁶ and R⁷⁷ may be bonded to each other to form a ring when Z¹ is -C(R⁷⁶) =C (R⁷⁷) -;R⁷⁶ and R⁷⁴ may be bonded to each other to form a ring, and R⁷⁶ and R⁷⁷ may be bonded to each other to form a ring when Z² is - C (R⁷⁶) =C (R⁷⁷) -; and two R⁷⁷ s may be bonded to each other to form a ring when both Z¹ and Z² are -C(R⁷⁶)=C(R⁷⁷)-.

23. The luminescent silver complex according to claim 22, wherein the luminescent silver complex is represented by compositional formula (5) in which L⁸ is a molecule represented by the following formula (Db): 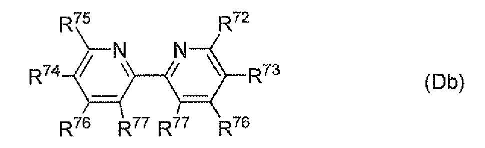 wherein, N is a nitrogen atom capable of coordinating to Ag⁺; R⁷², R⁷³, R⁷⁴, R⁷⁵, R⁷⁶, and R⁷⁷ are each independently a hydrogen atom, a halogen atom, an optionally substituted hydrocarbyloxy group, or an optionally substituted hydrocarbon group; Each of R⁷², R⁷³, R⁷⁴, R⁷⁵, R⁷⁶, R⁷⁷, and R⁷⁸ may be the same as or different from each other; R⁷² and R⁷³ may be bonded to each other to form a ring; R⁷³ and R⁷⁶ may be bonded to each other to form a ring; two R⁷⁶s and R⁷⁷ may be bonded to each other to form a ring; two R⁷⁷s may be bonded to each other to form a ring; R⁷⁶ and R⁷⁴ may be bonded to each other to form a ring; and R⁷⁴ and R⁷⁵ may be bonded to each other to form a ring.

24. The luminescent silver complex according to claim 23, wherein R⁷² and/or R⁷⁵ are each independently a fluorine atom, a chlorine atom, a bromine atom, or a trifluoromethyl group in the above formula (Db) which is L⁸.

25. The luminescent silver complex according to claim 6, wherein the luminescent silver complex is represented by compositional formula (5) in which L⁷ is a molecule represented by any one of formulae: 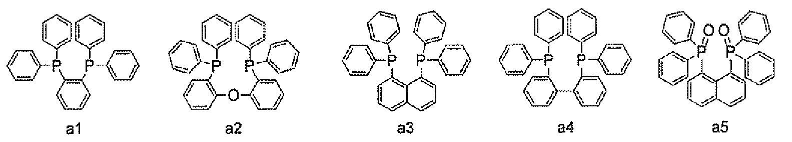 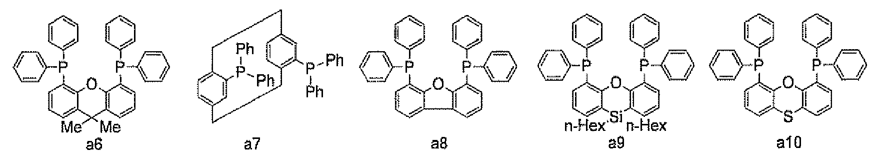 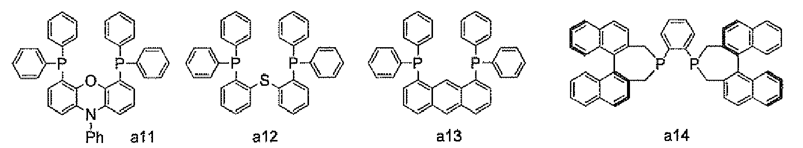 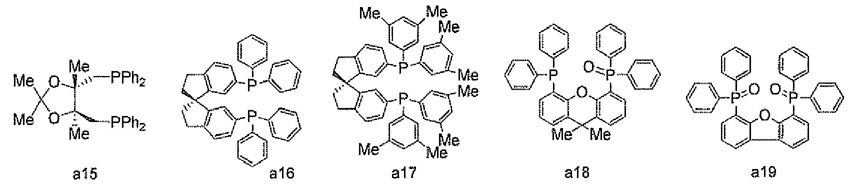 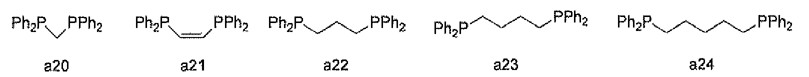 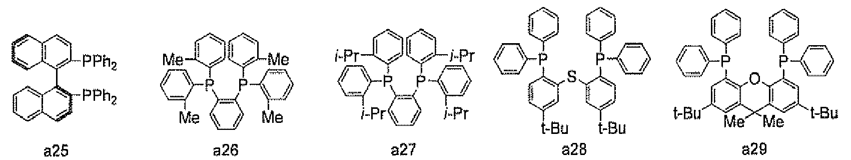 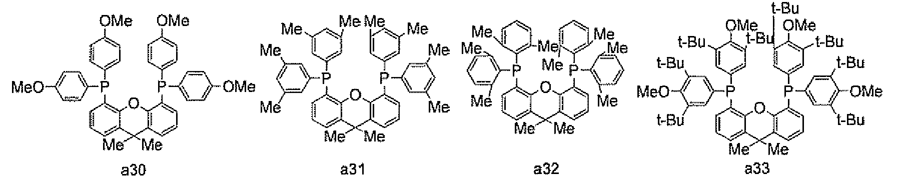 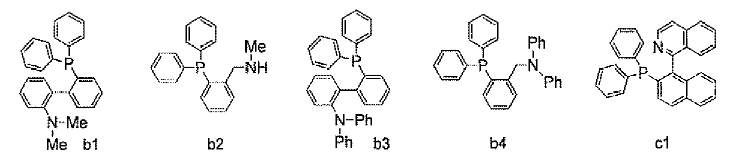 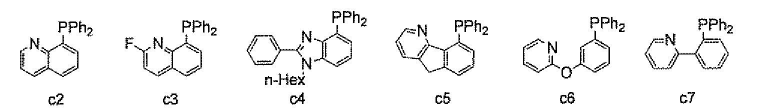 ; L⁸ is a molecule represented by any one of formulae: 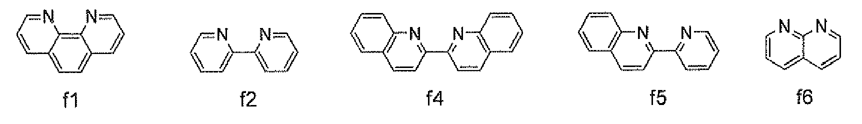 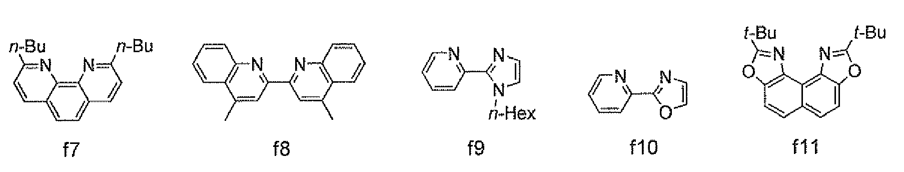 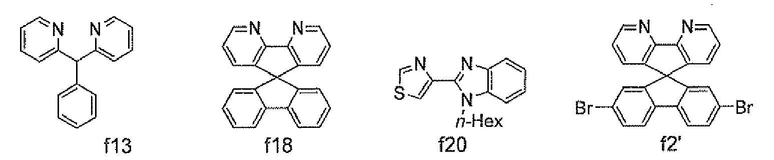 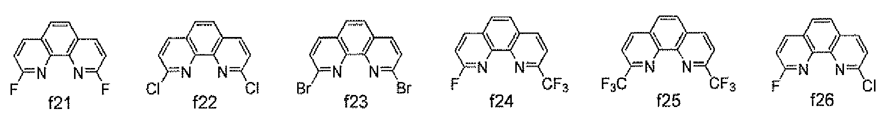 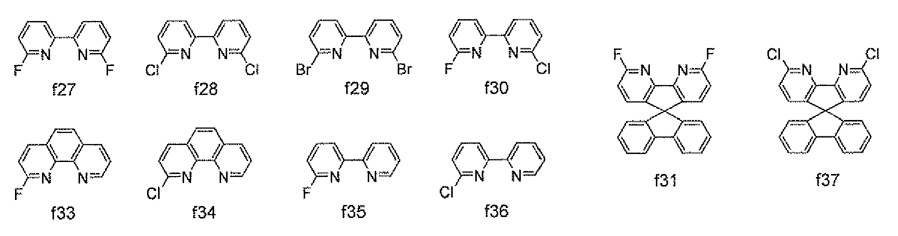 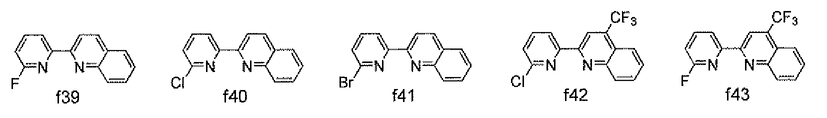 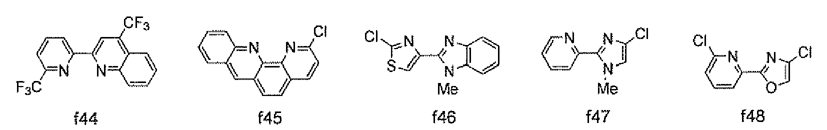 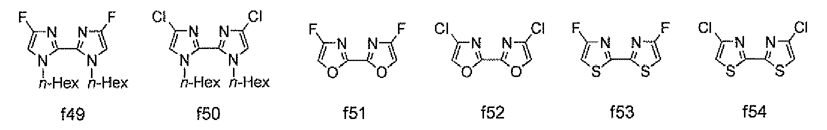 ; and X⁴ is a fluoride ion, a chloride ion, a bromide ion, an iodide ion, a sulfate ion, a nitrate ion, a carbonate ion, an acetate ion, a perchlorate ion, a tetrafluoroborate ion, a hexafluorophosphate ion, a hexafluoro antimony ion, a hexafluoro arsenic ion, a methanesulfonate ion, a trifluoromethanesulfonate ion, a trifluoroacetate ion, a benzenesulfonate ion, a p-toluenesulfonate ion, a dodecylbenzenesulfonate ion, a tetraphenylborate ion, or a tetrakis(pentafluorophenyl)borate ion.

26. The luminescent silver complex according to claim 25, wherein the luminescent silver complex is represented by compositional formula (5) in which L⁷ is a molecule represented by any one of formulae a1 to a4, a6 to 13, a16 to a17, and a25 to a33; and L⁸ is a molecule represented by any one of formulae f1 to f2, f4 to f11, f13, f18, f20, f2', f21 to f31, f33 to f37, and f39 to f54.

27. The luminescent silver complex according to claim 24, wherein d'3, e'3, and f'3 are each independently from 0.5 to 1.5.

28. The luminescent silver complex according to claim 26, wherein d'3, e'3, and f'3 are each independently from 0.5 to 1.5.

29. The luminescent silver complex according to claim 6, wherein the luminescent silver complex is represented by compositional formula (6) in which L¹⁰ is a molecule represented by formula (G):
Q¹⁰-R¹⁰-Q¹⁰⁰ (G)
wherein Q¹⁰ is -P(R¹⁰⁰)₂, -As (R¹⁰¹)₂, -P (=O) (R¹⁰²)₂, -OH, -CO₂H, -SH, -SO₃H, -OR¹⁰³, -CO₂R¹⁰⁴, -SR¹⁰⁵, -SO₃R¹⁰⁶, -SO₃R¹⁰⁷, -N(R¹⁰⁸)₂, or an optionally substituted nitrogen-containing heterocyclic group; Q¹⁰⁰ is -O⁻, -S⁻, -CO₂⁻, or -SO₃⁻; Q¹⁰ and Q¹⁰⁰ may be bonded to each other to form a ring; R¹⁰⁰ to R¹⁰⁸ are each independently a hydrogen atom or an optionally substituted hydrocarbon group; two R¹⁰⁰s, two R¹⁰¹s, two R¹⁰²s, and two R¹⁰⁸s may be the same as or different from each other; two R¹⁰⁰s may be bonded to each other to form a ring; two R¹⁰¹s may be bonded to each other to form a ring; two R¹⁰²s may be bonded to each other to form a ring; two R¹⁰⁸s may be bonded to each other to form a ring; R¹⁰ is a divalent group, but may be a direct bonding when Q¹⁰ is an optionally substituted nitrogen-containing heterocyclic group.

30. The luminescent silver complex according to claim 29, wherein, in formula (G), Q¹⁰ is -P(R¹⁰⁰)₂ or an optionally substituted nitrogen-containing heterocyclic group; Q¹⁰⁰ is -O⁻ or -S⁻; two R¹⁰⁰s are optionally substituted aryl groups; each of two R¹⁰⁰s may be the same as or different from each other; two R¹⁰⁰s may be bonded to each other to form a ring; and R¹⁰ is a divalent group represented by the optionally substituted r1', r5', r6', r10', or r12'.

31. The luminescent silver complex according to claim 30, wherein Q¹⁰ is -P(R¹⁰⁰)₂; Q¹⁰⁰ is -O⁻; two R¹⁰⁰s are optionally substituted phenyl groups; each of two R¹⁰⁰s may be the same as or different from each other; and two R¹⁰⁰s may be bonded to each other to form a ring in the above formula (G) which is L¹⁰.

32. The luminescent silver complex according to claim 6, wherein the luminescent silver complex is represented by compositional formula (6) in which L⁹ is a molecule represented by any one of formulae: 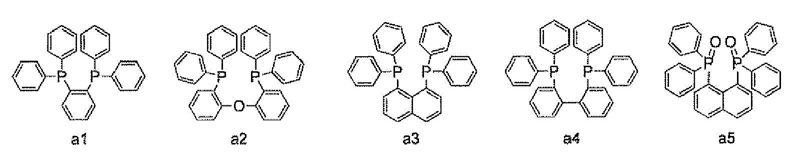 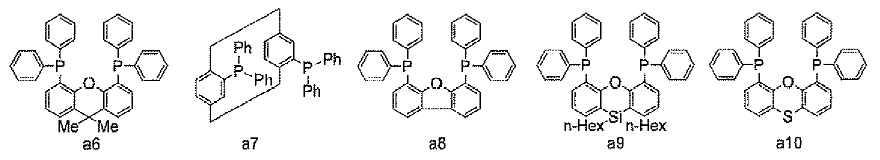 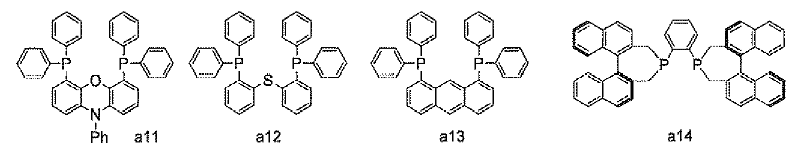 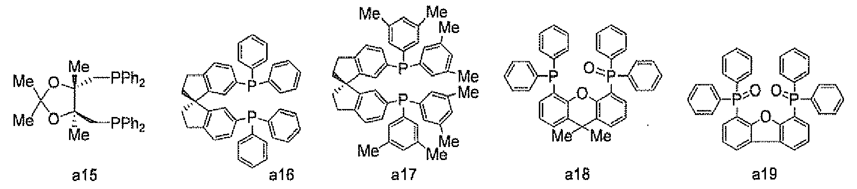 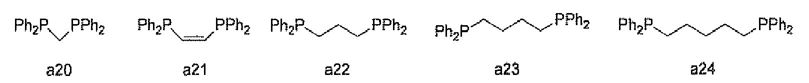 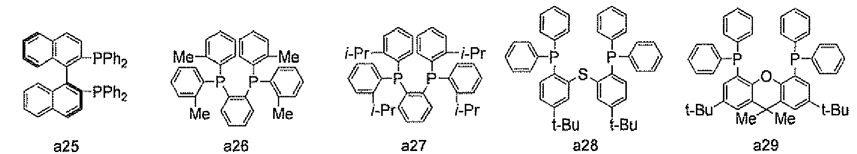 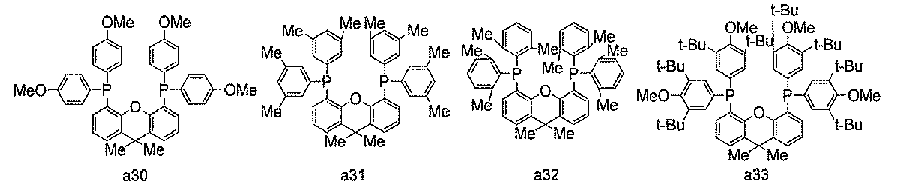 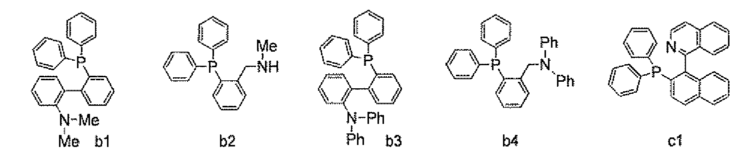 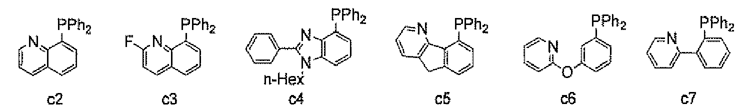 , and L¹⁰ is a molecule represented by any one of formulae:

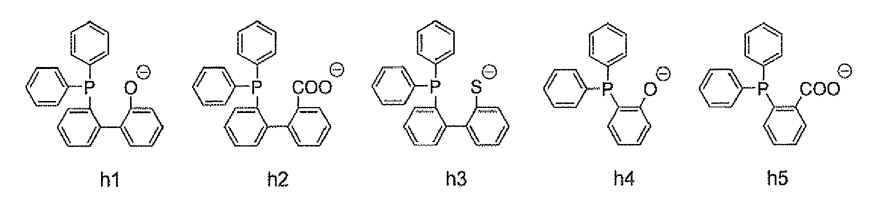

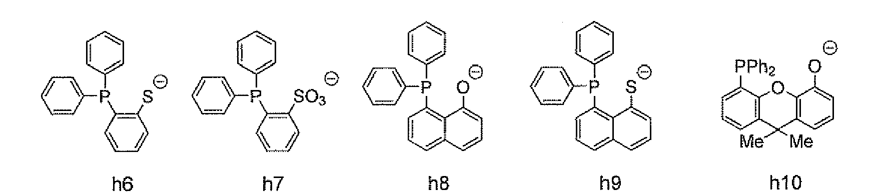

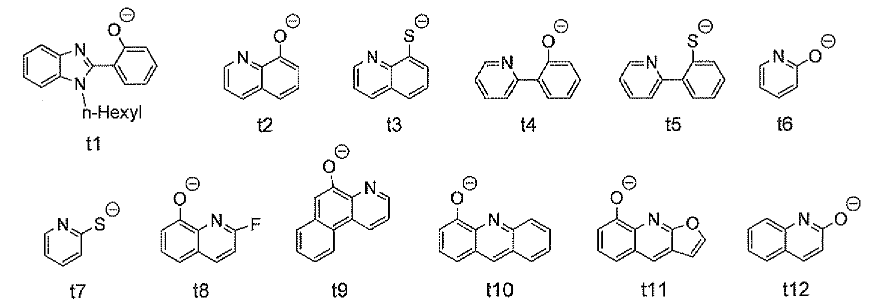

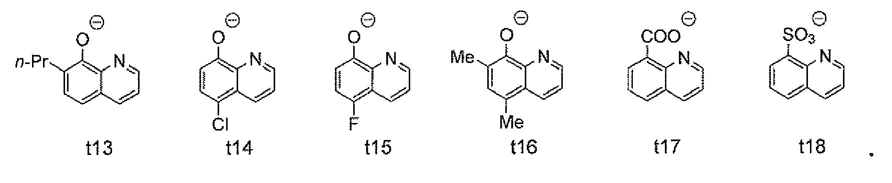

33. The luminescent silver complex according to claim 29, wherein the luminescent silver complex is represented by compositional formula (6) in which L⁹ is a molecule represented by any one of formulae a1 to a4, a6 to 13, a16 to a17, and a25 to a33, and L¹⁰ is a molecule represented by any one of formulae h1 to h6, h8 to h10, t1 to t5, t8 to t11, and t13 to t17.

34. The luminescent silver complex according to claim 33, wherein d'4 and e'4 are each independently from 0.5 to 1.5.

35. The luminescent silver complex according to any one of claims 1 to 34, wherein a difference between S1 energy and T1 energy is 0.3 eV or smaller.

36. A polymer having a residue of the luminescent silver complex according to any one of claims 1 to 34.

37. A composition comprising the luminescent silver complex according to any one of claims 1 to 34 and a high-molecular compound.

38. A composition comprising the polymer according to claim 36 and a high-molecular compound.

39. A thin-film comprising the luminescent silver complex according to any one of claims 1 to 34.

40. A thin-film comprising the polymer according to claim 36.

41. A luminescent device comprising the thin-film according to claim 39.

42. A luminescent device comprising the thin-film according to claim 39.
